(19) Europäisches Patentamt
European Patent Office
Office européen des brevets

(11) **EP 4 579 342 A1**

(12) **EUROPEAN PATENT APPLICATION**
published in accordance with Art. 153(4) EPC

(43) Date of publication:
**02.07.2025 Bulletin 2025/27**

(21) Application number: **23857223.4**

(22) Date of filing: **10.08.2023**

(51) International Patent Classification (IPC):
***G03F 7/004*** (2006.01) ***G01J 1/04*** (2006.01)
***G02B 5/02*** (2006.01) ***G03F 7/033*** (2006.01)

(52) Cooperative Patent Classification (CPC):
**G01J 1/04; G02B 5/02; G03F 7/004; G03F 7/033**

(86) International application number:
**PCT/JP2023/029206**

(87) International publication number:
**WO 2024/043110 (29.02.2024 Gazette 2024/09)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **22.08.2022 JP 2022131593**

(71) Applicant: **FUJIFILM Corporation**
**Tokyo 106-8620 (JP)**

(72) Inventors:
- **KATO, Ryosuke**
**Haibara-gun, Shizuoka 421-0396 (JP)**
- **IDEI, Hiroaki**
**Haibara-gun, Shizuoka 421-0396 (JP)**

(74) Representative: **HGF**
**HGF Limited**
**1 City Walk**
**Leeds LS11 9DX (GB)**

(54) **PHOTOSENSITIVE COMPOSITION, FILM, AND OPTICAL SENSOR**

(57) There are provided a photosensitive composition including particles A containing a rare earth element, a photopolymerization initiator B, and a resin C, in which the resin C includes a resin having at least one selected from an acid value or a base number, a film, and an optical sensor.

EP 4 579 342 A1

## Description

## BACKGROUND OF THE INVENTION

1. Field of the Invention

The present invention relates to a photosensitive composition containing particles containing a rare earth element, and a film and an optical sensor formed of the photosensitive composition.

2. Description of the Related Art

Titanium oxide is a particle having a high refractive index. Attempts to use such particles having a high refractive index for a light scattering film or the like have been studied.
In addition, in recent years, the use of particles of rare earth phosphates in a light scattering film or the like has been studied.
JP2020-076993A describes an invention relating to a coating material for forming a light diffusion layer of a projection screen, which contains 100 parts by mass of a base material resin and 0.1 to 50 parts by mass of rare earth phosphate fine particles.

## SUMMARY OF THE INVENTION

In recent years, in the production of a light scattering film including particles having a high refractive index, it has also been considered to produce the light scattering film by forming a pattern by a photolithography method. Titanium oxide has been used as particles having a high refractive index in the related art, but in a case where a composition containing titanium oxide is used to form a pattern by a photolithography method to produce a light scattering film formed in a pattern shape or the like, development residues are likely to occur between the patterns, and there is room for improvement in developability.
In addition, in recent years, the use of particles of rare earth phosphates in a light scattering film or the like has also been studied. However, as a result of intensive studies on particles containing a rare earth element such as a rare earth phosphate, the present inventors have found that the particles containing a rare earth element tend to have low dispersibility in a composition. In addition, as a result of studying the composition described in Examples of JP2020-076993A, the present inventors found that there is room for improvement in the storage stability of the composition.
Therefore, an object of the present invention is to provide a photosensitive composition having excellent storage stability and developability, and a film and an optical sensor formed of the photosensitive composition.
As a result of a thorough investigation under the above-described circumstances, the present inventors have found that the object of the present invention can be achieved by using a photosensitive composition described below, thereby completing the present invention. The present invention provides the following.

<1> A photosensitive composition comprising: particles A containing a rare earth element; a photopolymerization initiator B; and a resin C,
in which the resin C includes a resin having at least one selected from an acid value or a base number.
<2> The photosensitive composition according to <1>,
in which the particles A are particles of a rare earth phosphate.
<3> The photosensitive composition according to <1> or <2>,
in which the particles A are particles containing a yttrium element.
<4> The photosensitive composition according to any one of <1> to <3>,
in which an average primary particle diameter of the particles A is 30 to 200 nm.
<5> The photosensitive composition according to any one of <1> to <4>,
in which the resin C includes a resin having an acid value and a base number.
<6> The photosensitive composition according to any one of <1> to <5>,

in which the resin C includes a resin having a repeating unit of a poly(meth)acrylic structure and a resin having a repeating unit of a polyester structure, and
at least one of the resin having a repeating unit of a poly(meth)acrylic structure or the resin having a repeating unit of a polyester structure has at least one selected from an acid value or a base number.

<7> The photosensitive composition according to any one of <1> to <6>, further comprising:

polyalkyleneimine.

<8> The photosensitive composition according to any one of <1> to <4>,

in which the resin C includes a resin having an acid value, and
the photosensitive composition further contains polyalkyleneimine.

<9> The photosensitive composition according to any one of <1> to <8>, further comprising:
a polymerizable monomer.
<10> The photosensitive composition according to any one of <1> to <9>,
in which a content of the particles A in a total solid content of the photosensitive composition is 35% by mass or more.
<11> The photosensitive composition according to any one of <1> to <10>,
in which, in a case where a film having a thickness of 4 μm is formed by heating the photosensitive composition at 200°C for 5 minutes, a phase-separated structure of a first phase containing the particles A and a second phase having a lower content of the particles A than the content of the particles A of the first phase is formed in the film.
<12> The photosensitive composition according to <11>,
in which the phase-separated structure is a sea-island structure or a co-continuous phase structure.
<13> A film formed of the photosensitive composition according to any one of <1> to <12>.
<14> An optical sensor comprising:
the film according to <13>.

According to the present invention, it is possible to provide a photosensitive composition having excellent storage stability and developability, and a film and an optical sensor formed of the photosensitive composition.

## BRIEF DESCRIPTION OF THE DRAWINGS

Fig. 1 is a schematic diagram showing an embodiment of an optical sensor according to the present invention.
Fig. 2 is a schematic diagram showing another embodiment of the optical sensor according to the present invention.

## DESCRIPTION OF THE PREFERRED EMBODIMENTS

Hereinafter, the details of the present invention will be described.

The following description regarding configuration requirements has been made based on a representative embodiment of the present invention. However, the present invention is not limited to the embodiment.

In the present specification, numerical ranges represented by "to" include numerical values before and after "to" as lower limit values and upper limit values.

In the present specification, unless specified as a substituted group or as an unsubstituted group, a group (atomic group) denotes not only a group (atomic group) having no substituent but also a group (atomic group) having a substituent. For example, "alkyl group" denotes not only an alkyl group having no substituent (unsubstituted alkyl group) but also an alkyl group having a substituent (substituted alkyl group).

In the present specification, "(meth)acrylate" represents acrylate or methacrylate, "(meth)acryl" represents acryl and methacryl, "(meth)allyl" represents allyl and methallyl, and "(meth)acryloyl" represents acryloyl and methacryloyl.

In the present specification, in a chemical formula, Me represents a methyl group, Et represents an ethyl group, Pr represents a propyl group, Bu represents a butyl group, and Ph represents a phenyl group.

In the present specification, unless specified otherwise, "exposure" denotes not only exposure using light but also drawing using a corpuscular beam such as an electron beam or an ion beam. Examples of the light used for exposure include an actinic ray or radiation, for example, a bright light spectrum of a mercury lamp, a far ultraviolet ray represented by an excimer laser, an extreme ultraviolet ray (EUV light), an X-ray, or an electron beam.

In the present specification, a weight-average molecular weight and a number-average molecular weight are defined as values in terms of polystyrene measured by gel permeation chromatography (GPC). In the present specification, the weight-average molecular weight (Mw) and the number-average molecular weight (Mn) can be obtained, for example, by using HLC-8220GPC (manufactured by Tosoh Corporation), using a column in which TOSOH TSK gel Super HZM-H, TOSOH TSK gel Super HZ4000, and TOSOH TSK gel Super HZ2000 are linked to each other, and using tetrahydrofuran as a developing solvent.

In the present specification, a value of refractive index is a value of refractive index with refractive index to light at a wavelength of 589 nm at 23°C, unless otherwise specified.

<Photosensitive composition>

The photosensitive composition according to the embodiment of the present invention includes

particles A containing a rare earth element, a photopolymerization initiator B, and a resin C,
in which the resin C includes a resin having at least one selected from an acid value or a base number.

The photosensitive composition according to the embodiment of the present invention has excellent storage stability and developability. The reason for obtaining such an effect is presumed as follows. That is, it is presumed that, since the photosensitive composition according to the embodiment of the present invention includes the particles A containing a rare earth element and a resin having at least one selected from an acid value or a base number, the particles A and the resin interact with each other, and the resin can suppress aggregation or the like of the particles A in the photosensitive composition or suppress sedimentation of the particles A, and as a result, the storage stability of the photosensitive composition can be improved.

In addition, it is presumed that the particles A and the resin interact with each other during film formation, and thus the resin is likely to be present in the vicinity of the particles A even in the film. Therefore, it is presumed that, during development, the particles A present in the non-exposed portion are easily removed by development together with the resin, and development residues derived from the particles A and the like are less likely to remain between the patterns, and as a result, the developability of the photosensitive composition can be improved.

it is preferable that in a case where a film having a thickness of 4 μm is formed by heating the photosensitive composition according to the embodiment of the present invention at 200°C for 5 minutes, a phase-separated structure of a first phase including the particles A and a second phase having a lower content of the particles A than that of the first phase is formed in the film. By forming such a phase-separated structure in the film, the light scattering properties can be improved, and angle dependence of the scattered light can be reduced.

A base material of the first phase and the second phase is the film-forming component such as a resin or a cured substance derived from the film-forming component. In addition, mere aggregates of the above-described particles A are one form of the particles, and the mere aggregates of the above-described particles A themselves are not the first phase. The above-described first phase is a phase in which the above-described particles A are present in the film-forming component or the cured substance derived from the film-forming component. In addition, it is sufficient that the second phase has a lower content of the above-described particles A than the first phase, and the second phase may not substantially contain the above-described particles A. From the reason of easily obtaining more excellent light scattering properties, the content of the particles A in the second phase is preferably 30% by mass or less, more preferably 20% by mass or less, still more preferably 10% by mass or less, and even more preferably 5% by mass or less with respect to the total amount of the particles included in the photosensitive composition, and it is particularly preferable that the second phase does not substantially include the particles A. Here, the second phase not substantially including the particles A means that the content of the particles A is 1% by mass or less, preferably 0.5% by mass or less, with respect to the total amount of the particles A included in the photosensitive composition, and it is particularly preferable that the second phase does not include the particles A.

The formation of the phase-separated structure between the first phase and the second phase in the film can be observed using a scanning electron microscope (SEM), a transmission electron microscope (TEM), or an optical microscope. For example, the photosensitive composition is applied to a support such as a glass substrate and heated at 200°C for 5 minutes to form a film having a thickness of 4 μm, and then a cross section of the obtained film in a thickness direction is observed using a scanning electron microscope (SEM), a transmission electron microscope (TEM), or an optical microscope. As a result, it is possible to investigate whether or not the phase-separated structure between the first phase and the second phase is formed in the film.

The above-described phase-separated structure can be formed by appropriately changing the kind or the like of the resin.

Examples of one aspect thereof include a method of using a first resin and a second resin having low compatibility with the first resin. In a case where such a resin is used, a phase-separated structure between a phase containing the first resin as a main component and a phase containing the second resin as a main component can be formed during film formation. For example, in a case where one of the first resin or the second resin is a resin as a dispersant of the particles A and the other is a binder resin A, many particles A can be unevenly distributed in the phase including the resin as a dispersant as a main component. In this aspect, it is preferable that at least one of the first resin or the second resin is a resin having at least one selected from an acid value or a base number.

The phase-separated structure in the above-described film preferably has a phase interface isotropically present in the film, and for example, more preferably a sea-island structure or a co-continuous phase structure. By forming these phase-separated structures, light can be effectively scattered between the first phase and the second phase, and particularly excellent light scattering properties can be easily obtained. The sea-island structure is a structure formed by a

sea region which is a continuous region and an island region which is a discontinuous region. In the sea-island structure, the second phase may form the sea and the first phase may form the island, or the first phase may form the sea and the second phase may form the island. The case where the first phase forms the sea and the second phase forms the island is preferable from the viewpoint of transmittance. The case where the first phase forms the island and the second phase forms the sea is preferable from the viewpoint of angle dependence. In addition, the co-continuous phase structure is a network structure in which the first phase and the second phase each form a continuous phase structure intrusive to each other.

In a case where a film having a thickness of 4 μm is formed by heating the photosensitive composition according to the embodiment of the present invention at 200°C for 5 minutes, the transmittance of the film to light having a wavelength of 365 nm is preferably 15% or more, more preferably 25% or more, and still more preferably 35% or more.

In a case where a film having a thickness of 4 μm is formed by heating the photosensitive composition according to the embodiment of the present invention at 200°C for 5 minutes, the maximum value of the transmittance of the film to light in a wavelength range of 400 to 700 nm is preferably 90% or less, more preferably 85% or less, still more preferably 80% or less, even still more preferably 75% or less, and particularly preferably 70% or less, from the viewpoint of reducing the wavelength dependence of light scattering. The lower limit of the maximum value of the above-described transmittance is preferably 15% or more, more preferably 20% or more, still more preferably 30% or more, even more preferably 40% or more, and particularly preferably 45% or more.

In addition, the maximum value of transmittance of the above-described film with respect to light in 400 to 1000 nm is preferably 90% or less, more preferably 85% or less, still more preferably 80% or less, even more preferably 75% or less, and particularly preferably 70% or less. The lower limit of the maximum value of the above-described transmittance is preferably 20% or more, more preferably 25% or more, still more preferably 35% or more, even more preferably 45% or more, and particularly preferably 50% or more.

The average value of a difference in refractive index between the phases in the above-described film is preferably 0.1 or more, more preferably 0.2 or more, still more preferably 0.3 or more, and particularly preferably 0.4 or more.

The haze of the above-described film based on JIS K 7136 is preferably 30% to 100%. The upper limit is preferably 99% or less, more preferably 95% or less, and still more preferably 90% or less. The lower limit is preferably 35% or more, more preferably 40% or more, and still more preferably 50% or more.

The formation of the film having such spectral characteristics can be achieved by appropriately adjusting a shape of the phase-separated structure, a refractive index of the particles, an abundance of the particles in the film, a degree of uneven distribution of the particles in the film, and the like. In this case, it is better to provide a higher refractive index of the particles, abundance of the particles, and degree of uneven distribution of the particles.

A concentration of solid contents of the photosensitive composition according to the embodiment of the present invention is preferably 5% to 90% by mass. The upper limit is preferably 85% by mass or more, more preferably 80% by mass or more, still more preferably 75% by mass or less, even more preferably 70% by mass or less, and even still more preferably 60% by mass or less. The lower limit is preferably 10% by mass or more, more preferably 15% by mass or more, and still more preferably 20% by mass or more.

Hereinafter, each of the components used in the photosensitive composition according to the embodiment of the present invention will be described.

<<Specific particles>>

The photosensitive composition according to the embodiment of the present invention includes particles A (hereinafter, also referred to as specific particles) containing a rare earth element.

The specific particles are materials having a high refractive index and a high Abbe number (vd) in a wavelength range from ultraviolet light to infrared light including a wavelength range of visible light. Therefore, by using the specific particles, the light scattering properties of the obtained film can be further enhanced. Furthermore, angle dependence of scattered light can be reduced.

Examples of the rare earth element contained in the specific particles include a scandium element, a yttrium element, a lanthanum element, a cerium element, a praseodymium element, a neodymium element, a promethium element, a samarium element, a europium element, a gadolinium element, a terbium element, a dysprosium element, a holmium element, an erbium element, a thulium element, an ytterbium element, and a lutetium element.

From the reason that the storage stability and the developability can be further improved, and further, the light scattering properties of the obtained film can be further improved and the angle dependence of scattered light can be reduced, the specific particles are preferably particles containing at least one selected from a yttrium element, a gadolinium element, a dysprosium element, an ytterbium element, or a lutetium element, and more preferably particles containing a yttrium element.

Examples of the specific particles include particles of a rare earth phosphate, particles of a rare earth oxide, and particles of a rare earth titanate. Among these, particles of a rare earth phosphate are preferable as the specific particles

from the reason that the storage stability and the developability can be further improved, and the light scattering properties of the obtained film can be further enhanced and the angle dependence of scattered light can be reduced.

Specific examples of the specific particles include $YPO_4$, $GdPO_4$, $LuPO_4$, $YbPO_4$, and $DyPO_4$.

The specific particles may be crystalline or amorphous (noncrystalline). In a case where the specific particles are crystalline, examples of the crystal system thereof include a monoclinic system, a tetragonal system, and a cubic system.

The average primary particle diameter of the specific particles is preferably 300 nm or less, more preferably 250 nm or less, still more preferably 200 nm or less, and even more preferably 150 nm or less. From the viewpoint of light scattering properties of the obtained film, the lower limit is preferably 5 nm or more, more preferably 10 nm or more, still more preferably 20 nm or more, and even still more preferably 30 nm or more.

The average primary particle diameter of the specific particles is preferably 30 to 200 nm and more preferably 30 to 150 nm.

In the present specification, the average primary particle diameter of particles is a value measured by the following method. That is, the primary particle diameter of the particles can be obtained by observing the particles with a transmission electron microscope (TEM) and observing a portion (primary particle) where the particles do not aggregate. A particle size distribution of the particles can be obtained by photographing a transmission electron micrograph of the primary particles using a transmission electron microscope and measuring a particle size distribution with an image processing device using the micrograph. In the present specification, the average primary particle diameter of the particles refers to the number average particle size calculated from the particle size distribution. In the present specification, an electron microscope (H-7000, manufactured by Hitachi, Ltd.) is used as the transmission electron microscope, and a LUZEX AP (manufactured by Nireco Corporation) is used as the image processing device.

The refractive index of the specific particles is preferably 1.70 or more and more preferably 1.75 or more. The upper limit of the refractive index of the specific particles is not particularly limited, but can be set to 5.0 or less or 4.0 or less.

The refractive index of particles is a value measured by the following method. First, a dispersion liquid is prepared using the particles, a resin (dispersant) having a known refractive index, and propylene glycol monomethyl ether acetate. Next, the prepared dispersion liquid and a resin having a known refractive index are mixed with each other to prepare coating liquids in which the concentrations of the particles are 10% by mass, 20% by mass, 30% by mass, and 40% by mass with respect to the total solid content of the coating liquids. Using each of the coating liquids, a film having a thickness of 300 nm is formed on a silicon wafer, and the refractive index of the obtained film is measured by ellipsometry (LAMBDA ACE RE-3300, manufactured by SCREEN Holdings Co., Ltd.). Next, the refractive index corresponding to the concentration of the particles is plotted on a graph to derive the refractive index of the particles.

The specific gravity of the specific particles is preferably 3.0 to 8.0 $g/cm^3$. The upper limit is preferably 7.5 $g/cm^3$ or less and more preferably 7.0 $g/cm^3$ or less. The lower limit of the specific gravity is not particularly limited, but can be 3.2 $g/cm^3$ or more or 3.5 $g/cm^3$ or more.

In the present specification, the specific gravity of particles is a value measured by the following method. First, 50 g of particles are put into a 100 mL volumetric flask. Subsequently, 100 mL of water is weighed using another 100 mL graduated cylinder. Thereafter, first, the weighed water is put into the volumetric flask to the extent that the particles are immersed, and then ultrasonic waves are applied to the volumetric flask to allow the particles and water to blend in. Next, additional water is added thereto until the marked line of the volumetric flask is reached, and the specific gravity is calculated as 50 g/(volume of water remaining in volumetric flask).

In the specific surface area of the specific particles, it is preferable that a value measured by Brunauer, Emmett, Teller (BET) method is preferably 1 to 100 $m^2/g$. The upper limit is preferably 95 $m^2/g$ or less and more preferably 90 $m^2/g$ or less. The lower limit is preferably 2 $m^2/g$ or more and more preferably 3 $m^2/g$ or more.

The content of the specific particles in the total solid content of the photosensitive composition is preferably 10% by mass or more, more preferably 20% by mass or more, still more preferably 30% by mass or more, and even still more preferably 35% by mass or more. The upper limit is preferably 90% by mass or less, more preferably 80% by mass or less, and still more preferably 70% by mass or less.

The photosensitive composition according to the embodiment of the present invention may contain only one kind of specific particle, or may contain two or more kinds thereof.

<<Photopolymerization initiator>>

The photosensitive composition according to the embodiment of the present invention contains a photopolymerization initiator B (hereinafter, also referred to as a photopolymerization initiator). The photopolymerization initiator is not particularly limited, and can be appropriately selected from known photopolymerization initiators. For example, a compound having photosensitivity to light in a range from an ultraviolet range to a visible range is preferable. The photopolymerization initiator is preferably a photoradical polymerization initiator.

Examples of the photopolymerization initiator include a halogenated hydrocarbon derivative (for example, a compound having a triazine skeleton or a compound having an oxadiazole skeleton), an acylphosphine compound, a

hexaarylbiimidazole compound, an oxime compound, an organic peroxide, a thio compound, a ketone compound, an aromatic onium salt, an α-hydroxyketone compound, and an α-aminoketone compound. From the viewpoint of exposure sensitivity, as the photopolymerization initiator, a trihalomethyltriazine compound, a benzyldimethylketal compound, an α-hydroxyketone compound, an α-aminoketone compound, an acylphosphine compound, a phosphine oxide compound, a metallocene compound, an oxime compound, a hexaarylbiimidazole compound, an onium compound, a benzothiazole compound, a benzophenone compound, an acetophenone compound, a cyclopentadiene-benzene-iron complex, a halomethyl oxadiazole compound, or a 3-aryl-substituted coumarin compound is preferable, a compound selected from an oxime compound, an α-hydroxyketone compound, an α-aminoketone compound, and an acylphosphine compound is more preferable, and an oxime compound is still more preferable. As the photopolymerization initiator, compounds described in paragraphs 0065 to 0111 of JP2014-130173A, compounds described in JP6301489B, peroxide-based photopolymerization initiators described in MATERIAL STAGE, p. 37 to 60, vol. 19, No. 3, 2019, photopolymerization initiators described in WO2018/221177A, photopolymerization initiators described in WO2018/110179A, photopolymerization initiators described in JP2019-043864A, photopolymerization initiators described in JP2019-044030A, peroxide initiators described in JP2019-167313A, aminoacetophenone-based initiators having an oxazolidine group described in JP2020-055992A, oxime-based photopolymerization initiators described in JP2013-190459A, polymers described in JP2020-172619A, compounds represented by Formula 1 described in WO2020/152120A, compounds described in JP2021-181406A, photopolymerization initiators described in JP2022-013379A, compounds represented by Formula (1) described in JP2022-015747A, fluorine-containing fluorene oxime ester-based photoinitiators described in JP2021-507058A, and the like can also be used.

Examples of a commercially available product of the α-hydroxyketone compound include Omnirad 184, Omnirad 1173, Omnirad 2959, and Omnirad 127 (all of which are manufactured by IGM Resins B.V.), Irgacure 184, Irgacure 1173, Irgacure 2959, and Irgacure 127 (all of which are manufactured by BASF SE). Examples of a commercially available product of the α-aminoketone compound include Omnirad 907, Omnirad 369, Omnirad 369E, and Omnirad 379EG (all of which are manufactured by IGM Resins B.V.), Irgacure 907, Irgacure 369, Irgacure 369E, and Irgacure 379EG (all of which are manufactured by BASF SE). Examples of a commercially available product of the acylphosphine compound include Omnirad 819 and Omnirad TPO H (both of which are manufactured by IGM Resins B.V.), Irgacure 819 and Irgacure TPO (both of which are manufactured by BASF SE).

Examples of the oxime compound include compounds described in paragraph 0142 of WO2022/085485A, compounds described in JP5430746B, compounds described in JP5647738B, compounds represented by General Formula (1) and compounds described in paragraphs 0022 to 0024 of JP2021-173858A, and compounds represented by General Formula (1) and compounds described in paragraphs 0117 to 0120 of JP2021-170089A. Specific examples of the oxime compound include 3-benzoyloxyiminobutane-2-one, 3-acetoxyiminobutane-2-one, 3-propionyloxyiminobutane-2-one, 2-acetoxyiminopentane-3-one, 2-acetoxyimino-1-phenylpropane-1-one, 2-benzoyloxyimino-1-phenylpropane-1-one, 3-(4-toluene sulfonyloxy)iminobutane-2-one, 2-ethoxycarbonyloxyimino-1-phenylpropane-1-one, and 1-[4-(phenylthio)phenyl]-3-cyclohexyl-propane-1,2-dione-2-(O-acetyloxime). Examples of a commercially available product thereof include Irgacure OXE01, Irgacure OXE02, Irgacure OXE03, and Irgacure OXE04 (all of which are manufactured by BASF SE), TR-PBG-304 and TR-PBG-327 (manufactured by TRONLY), and ADEKA OPTOMER N-1919 (manufactured by ADEKA Corporation; photopolymerization initiator 2 described in JP2012-014052A). In addition, as the oxime compound, it is also preferable to use a compound having no colorability or a compound having high transparency and being resistant to discoloration. Examples of a commercially available product thereof include ADEKA ARKLS NCI-730, NCI-831, and NCI-930 (all of which are manufactured by ADEKA Corporation).

As the photopolymerization initiator, an oxime compound having a fluorene ring, an oxime compound having a skeleton in which at least one benzene ring of a carbazole ring is a naphthalene ring, an oxime compound having a fluorine atom, an oxime compound having a nitro group, an oxime compound having a benzofuran skeleton, an oxime compound in which a substituent having a hydroxy group is bonded to a carbazole skeleton, or the compounds described in paragraphs 0143 to 0149 of WO2022/085485A can also be used.

Specific examples of the oxime compound include compounds having the following structures.

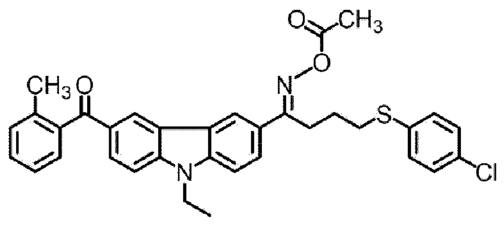

(C-1)

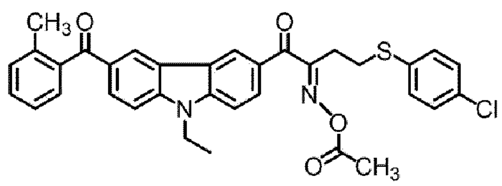

(C-2)

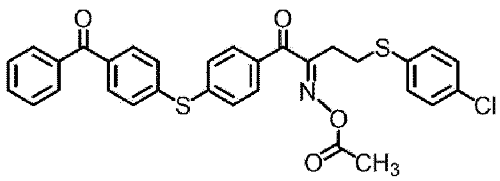

(C-3)

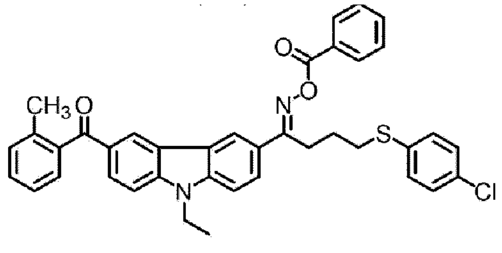

(C-4)

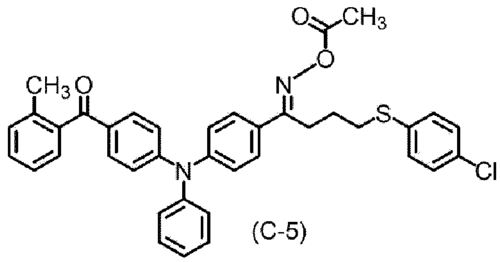

(C-5)

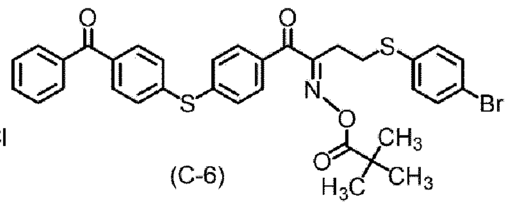

(C-6)

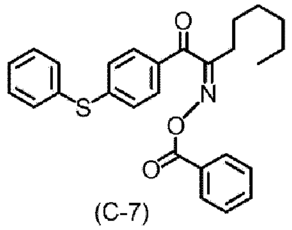

(C-7)

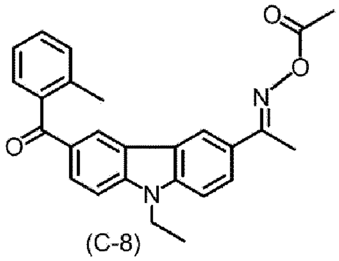

(C-8)

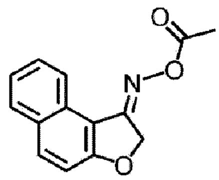

(C-9)

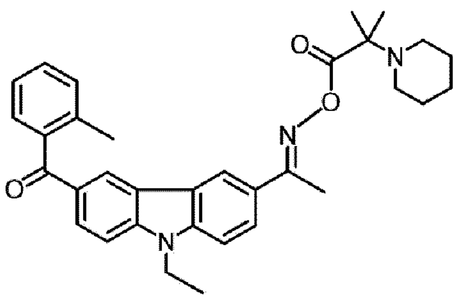

(C-10)

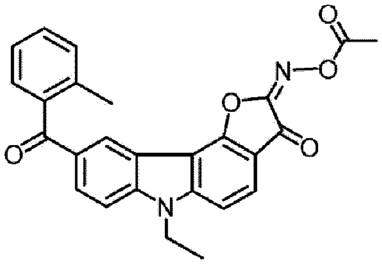

(C-11)

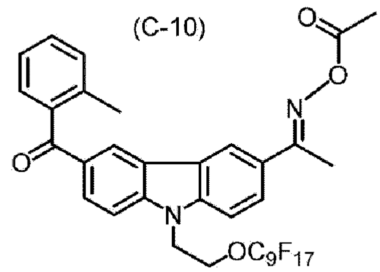

(C-12)

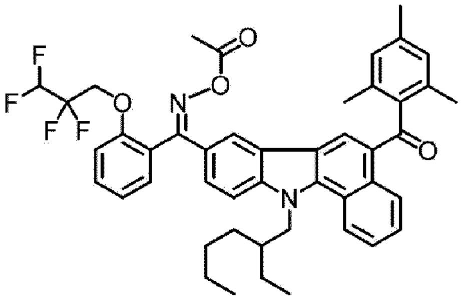

(C-13)

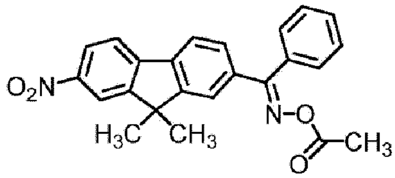

(C-14)

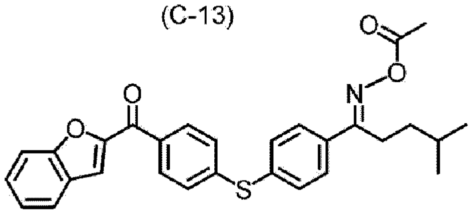

(C-15)

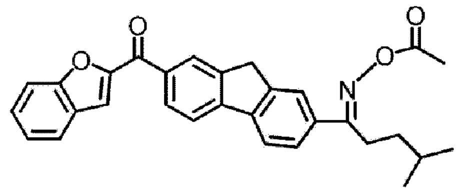

(C-16)

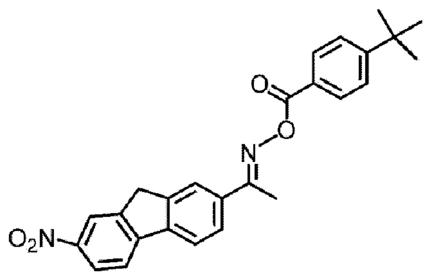

(C-17)

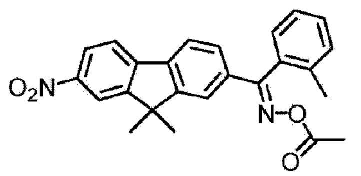

(C-18)

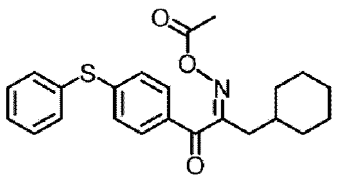

(C-19)

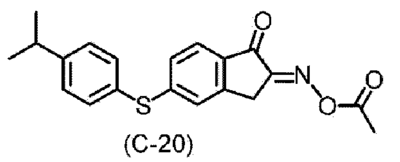

(C-20)

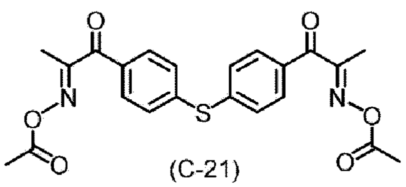

(C-21)

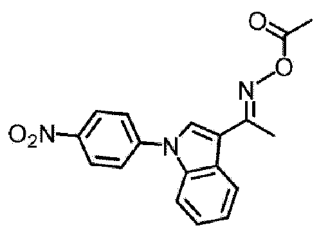

(C-22)

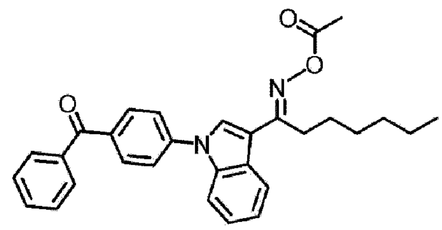

(C-23)

The oxime compound is preferably a compound having a maximal absorption wavelength in a wavelength range of 350 to 500 nm and more preferably a compound having a maximal absorption wavelength in a wavelength range of 360 to 480 nm. In addition, from the viewpoint of sensitivity, a molar absorption coefficient of the oxime compound at a wavelength of 365 nm or 405 nm is preferably high, more preferably 1000 to 300000, still more preferably 2,000 to 300,000, and particularly preferably 5,000 to 200,000. The molar absorption coefficient of a compound can be measured using a known method. For example, it is preferable that the molar absorption coefficient can be measured using a spectrophotometer (Cary-5 spectrophotometer, manufactured by Varian Medical Systems, Inc.) and ethyl acetate at a concentration of 0.01 g/L.

As the photopolymerization initiator, a bifunctional or tri- or higher functional photoradical polymerization initiator may be used. By using such a photoradical polymerization initiator, two or more radicals are generated from one molecule of the photoradical polymerization initiator, and as a result, good sensitivity is obtained. In addition, in a case of using a compound having an asymmetric structure, crystallinity is reduced so that solubility in a solvent or the like is improved, precipitation is to be difficult over time, and temporal stability of the photosensitive composition can be improved. Specific examples of the bifunctional or tri- or higher functional photoradical polymerization initiator include dimers of the oxime compounds described in JP2010-527339A, JP2011-524436A, WO2015/004565A, paragraphs 0407 to 0412 of JP2016-532675A, and paragraphs 0039 to 0055 of WO2017/033680A; the compound (E) and compound (G) described in JP2013-522445A; Cmpd 1 to 7 described in WO2016/034963A; the oxime ester-based photoinitiators described in paragraph 0007 of JP2017-523465A; the photoinitiators described in paragraphs 0020 to 0033 of JP2017-167399A; the photopolymerization initiator (A) described in paragraphs 0017 to 0026 of JP2017-151342A; and the oxime ester-based photoinitiators described in JP6469669B.

The content of the photopolymerization initiator in the total solid content of the photosensitive composition is preferably in a range of 0.1% to 30% by mass. The lower limit is preferably 0.5% by mass or more, more preferably 1% by mass or more, still more preferably 2% by mass or more, and even still more preferably 3% by mass or more. The upper limit is preferably 20% by mass or less, more preferably 15% by mass or less, and still more preferably 10% by mass or less. The photosensitive composition according to the embodiment of the present invention may contain only one kind of photopolymerization initiator, or may contain two or more kinds of photopolymerization initiators. In a case of containing two or more kinds of photopolymerization initiators, it is preferable that the total content of the photopolymerization initiators is within the above-described range.

<<Resin>>

The photosensitive composition according to the embodiment of the present invention contains a resin C (hereinafter, also referred to as a resin). The resin is blended in, for example, an application for dispersing the particles or the like in the photosensitive composition or an application as a binder. Mainly, a resin which is used for dispersing the particles or the like in the photosensitive composition is also referred to as a dispersant. However, such applications of the resin are merely exemplary, and the resin can also be used for other purposes in addition to such applications.

As the resin, any known resin can be used. Examples of the resin include a (meth)acrylic resin, a (meth) acrylamide resin, an epoxy resin, an ene-thiol resin, a polycarbonate resin, a polyether resin, a polyarylate resin, a polysulfone resin, a polyethersulfone resin, a polyphenylene resin, a polyarylene ether phosphine oxide resin, a polyimide resin, a polyamide resin, a polyolefin resin, a cyclic olefin resin, a polyester resin, a styrene resin, a silicone resin, and a urethane resin.

A weight-average molecular weight of the resin is preferably 3,000 to 2,000,000. The upper limit is preferably 1,000,000 or less and more preferably 500,000 or less. The lower limit is preferably 3,000 or more, more preferably 4,000 or more, and still more preferably 5,000 or more.

The photosensitive composition according to the embodiment of the present invention preferably contains each of the resin as a dispersant for the specific particles and the resin as a binder. In addition, the resin as a binder preferably has low compatibility with the resin as a dispersant. By using such resins in combination, the above-described phase-separated structure is easily formed in the film during film formation, and the light scattering properties of the obtained film can be further improved. Examples of the combination of resins having low compatibility include a combination of a resin having a repeating unit of a poly(meth)acrylic structure and a resin having a repeating unit of a polyester structure.

The photosensitive composition according to the embodiment of the present invention preferably includes at least one selected from a resin having a structure in which a plurality of polymer chains are bonded to a tri- or higher valent linking group or a resin having a repeating unit having a graft chain. According to this aspect, aggregation and the like of particles in the photosensitive composition can be suppressed more effectively, and more excellent storage stability can be obtained. Furthermore, the above-described phase-separated structure is easily formed in the film during film formation, and the light scattering properties of the obtained film can be further improved.

It is more preferable that each of a resin having a structure in which a plurality of polymer chains are bonded to a tri- or higher valent linking group and a resin having a repeating unit having a graft chain is contained.

The photosensitive composition according to the embodiment of the present invention may include each of a resin having a structure in which a plurality of polymer chains are bonded to a tri- or higher valent linking group and a resin having a repeating unit having a graft chain.

The resin having a structure in which a plurality of polymer chains are bonded to a tri- or higher valent linking group and the resin having a repeating unit having a graft chain will be described later in detail.

In a case where the photosensitive composition according to the embodiment of the present invention contains the resin having a structure in which a plurality of polymer chains are bonded to a tri- or higher valent linking group and the resin including a repeating unit having a graft chain, it is preferable that any one of the resins is a dispersant and the other resin is a binder. In addition, it is preferable that the polymer chain in the resin having a structure in which a plurality of polymer chains are bonded to a tri- or higher valent linking group is a polymer chain including a repeating unit having a structure different from that of the graft chain in the resin including a repeating unit having a graft chain. Examples thereof preferably include a combination of a polymer chain in a resin having a structure in which a plurality of polymer chains are bonded to a tri- or higher valent linking group, the polymer chain being a polymer chain composed of a repeating unit of a polyether structure, a polyester structure, a poly(meth)acrylic structure, or a polystyrene structure, and a graft chain in a resin having a repeating unit having a graft chain, the graft chain being a repeating unit having a structure different from the polymer chain and being a graft chain composed of a repeating unit of a polyether structure, a polyester structure, a poly(meth)acrylic structure, or a polystyrene structure, and a combination of a polymer chain in a resin having a structure in which a plurality of polymer chains are bonded to a tri- or higher valent linking group, the polymer chain being a polymer chain composed of a repeating unit of a polyester structure or a poly(meth)acrylic structure, and a graft chain in a resin having a repeating unit having a graft chain, the graft chain being a repeating unit having a structure different from the polymer chain and being a graft chain composed of a repeating unit of a polyester structure or a poly(meth)acrylic structure.

The photosensitive composition according to the embodiment of the present invention preferably contains 40 to 300 parts by mass of the resin as a binder with respect to 100 parts by mass of the resin as a dispersant. The upper limit is preferably 250 parts by mass or less and more preferably 200 parts by mass or less. The lower limit is preferably 50 parts by mass or more and more preferably 100 parts by mass or more.

The photosensitive composition according to the embodiment of the present invention preferably contains 5 to 150 parts by mass of the resin as a dispersant with respect to 100 parts by mass of the specific particles. The upper limit is preferably 140 parts by mass or less, more preferably 125 parts by mass or less, and still more preferably 100 parts by mass or less. The lower limit is preferably 10 parts by mass or more, more preferably 15 parts by mass or more, and still more preferably 25 parts by mass or more.

As the resin as a dispersant and the resin as a binder, resins to be described later can be appropriately selected and used. In addition, a commercially available product is also available as the dispersant, and specific examples thereof include DISPERBYK series (for example, DISPERBYK-111, 2001, and the like) manufactured by BYK-Chemie Japan K.K., Solsperse series (for example, Solsperse 20000, 76500, and the like) manufactured by Lubrizol Corporation, and AJISPER series manufactured by Ajinomoto Fine-Techno Co., Inc. In addition, products described in paragraph 0129 of JP2012-137564A and products described in paragraph 0235 of JP2017-194662A can also be used as the dispersant.

As the resin, a resin having an acid group can be used. Examples of the resin having an acid group include a resin having a repeating unit having an acid group. Examples of the acid group include a carboxy group, a phosphoric acid group, a sulfo group, and a phenolic hydroxy group.

As the resin, a resin having a basic group can be used. Examples of the resin having a basic group include a resin having a repeating unit having a basic group. Examples of the basic group include an amino group and a pyridyl group. The basic group is preferably an amino group. Examples of the amino group include a group represented by $-NR^{am1}R^{am2}$ and a cyclic amino group, and a group represented by $-NR^{am1}R^{am2}$ is preferable. In the group represented by $-NR^{am1}R^{am2}$, $R^{am1}$ and $R^{am2}$ each independently represent a hydrogen atom, an alkyl group, or an aryl group, and an alkyl group is preferable. The alkyl group preferably has 1 to 10 carbon atoms, more preferably has 1 to 5 carbon atoms, still more preferably has 1 to 3 carbon atoms, and particularly preferably has 1 or 2 carbon atoms. The alkyl group may be any of linear, branched, and cyclic forms, but is preferably linear or branched and more preferably linear. The aryl group preferably has 6 to 30 carbon atoms, more preferably has 6 to 20 carbon atoms, and still more preferably has 6 to 12 carbon atoms. Examples of the cyclic amino group include a pyrrolidine group, a piperidine group, a piperazine group, and a morpholine group. These groups may further have a substituent. Examples of the substituent include an alkyl group and an aryl group.

As the resin, a resin having an acid group and a basic group can be used. Examples of the resin having an acid group and a basic group include a resin having a repeating unit having an acid group and a repeating unit having a basic group.

As the resin, a resin including a repeating unit derived from a compound represented by Formula (ED1) and/or a compound represented by Formula (ED2) (hereinafter, these compounds will also be referred to as an "ether dimer") can be used.

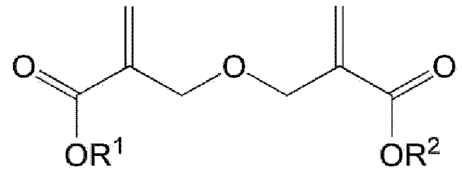

(ED1)

In Formula (ED1), $R^1$ and $R^2$ each independently represent a hydrogen atom or a hydrocarbon group having 1 to 25 carbon atoms, which may have a substituent.

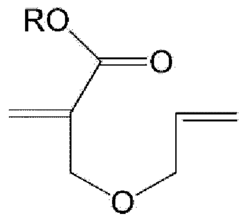

(ED2)

In Formula (ED2), R represents a hydrogen atom or an organic group having 1 to 30 carbon atoms. Specific examples of Formula (ED2) can be found in the description of JP2010-168539A.

Specific examples of the ether dimer can be found in paragraph 0317 of JP2013-029760A, the contents of which are incorporated herein by reference.

As the resin, a resin including a repeating unit derived from a compound represented by Formula (X) can be used.

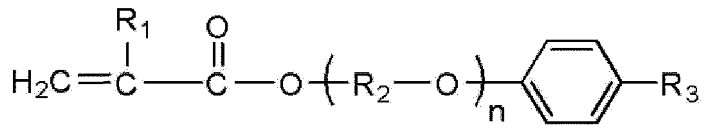

(X)

In Formula (X), $R_1$ represents a hydrogen atom or a methyl group, $R_2$ represents an alkylene group having 2 to 10 carbon atoms, and $R_3$ represents a hydrogen atom or an alkyl group having 1 to 20 carbon atoms, which may have a benzene ring. n represents an integer of 1 to 15.

As the resin, a resin including a repeating unit having a graft chain can also be used. In a case where the resin includes a repeating unit having a graft chain, due to steric hindrance caused by the graft chain, aggregation and the like of particles in the photosensitive composition can be suppressed more effectively, and excellent storage stability can be obtained. In addition, the above-described phase-separated structure is easily formed in the film during film formation, and the light scattering properties of the obtained film are easily improved. The resin including a repeating unit having a graft chain may be used as a dispersant or a binder.

The graft chain preferably includes a repeating unit having at least one structure selected from a polyether structure, a polyester structure, a poly(meth)acrylic structure, a polystyrene structure, a polyurethane structure, a polyurea structure, or a polyamide structure, more preferably includes a repeating unit having at least one structure selected from a polyether structure, a polyester structure, a poly(meth)acrylic structure, or a polystyrene structure, still more preferably includes a repeating unit having a polyether structure or a repeating unit having a polyester structure, and particularly preferably includes a repeating unit having a polyester structure.

Examples of the repeating unit having a polyester structure include a repeating unit having a structure represented by Formula (G-1), Formula (G-4), or Formula (G-5). Examples of the repeating unit having a polyether structure include a repeating unit having a structure represented by Formula (G-2). Examples of the repeating unit having a poly(meth)acrylic structure include a repeating unit having a structure represented by Formula (G-3). Examples of the repeating unit having a polystyrene structure include a repeating unit having a structure represented by Formula (G-6).

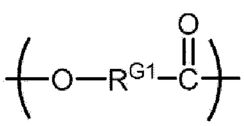

(G-1)

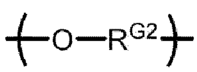

(G-2)

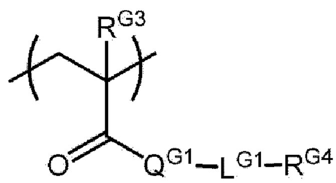

(G-3)

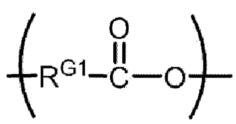

(G-4)

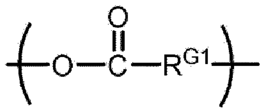

(G-5)

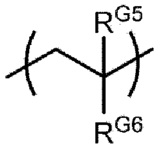

(G-6)

In the formulae, $R^{G1}$ and $R^{G2}$ each independently represent an alkylene group. The alkylene group represented by $R^{G1}$ and $R^{G2}$ is not particularly limited, but is preferably a linear or branched alkylene group having 1 to 20 carbon atoms, more preferably a linear or branched alkylene group having 2 to 16 carbon atoms, and still more preferably a linear or branched alkylene group having 3 to 12 carbon atoms.

In the formulae, $R^{G3}$ represents a hydrogen atom or a methyl group, $Q^{G1}$ represents -O- or -NH-, $L^{G1}$ represents a single bond or a divalent linking group, and $R^{G4}$ represents a hydrogen atom or a substituent.

Examples of the divalent linking group represented by $L^{G1}$ include an alkylene group (preferably an alkylene group having 1 to 12 carbon atoms), an alkyleneoxy group (preferably an alkyleneoxy group having 1 to 12 carbon atoms), an oxyalkylenecarbonyl group (preferably an oxyalkylenecarbonyl group having 1 to 12 carbon atoms), an arylene group (preferably an arylene group having 6 to 20 carbon atoms), -NH-, -SO-, $-SO_2-$, -CO-, -O-, -COO-, OCO-, -S-, and a group formed by a combination of two or more of these groups.

Examples of the substituent represented by $R^{G4}$ include a hydroxy group, a carboxy group, an alkyl group, an aryl group, a heterocyclic group, an alkoxy group, an aryloxy group, a heterocyclic oxy group, an alkylthioether group, an arylthioether group, a heterothioether group, an ethylenically unsaturated bond-containing group, an epoxy group, an oxetanyl group, and a blocked isocyanate group.

$R^{G5}$ represents a hydrogen atom or a methyl group and $R^{G6}$ represents an aryl group. The number of carbon atoms in the aryl group represented by $R^{G6}$ is preferably 6 to 30, more preferably 6 to 20, and still more preferably 6 to 12. The aryl group represented by $R^{G6}$ may have a substituent. Examples of the substituent include a hydroxy group, a carboxy group, an alkyl group, an aryl group, a heterocyclic group, an alkoxy group, an aryloxy group, a heterocyclic oxy group, an alkylthioether group, an arylthioether group, a heterothioether group, an ethylenically unsaturated bond-containing group, an epoxy group, an oxetanyl group, and a blocked isocyanate group.

A terminal structure of the graft chain is not particularly limited. The terminal structure may be a hydrogen atom or a substituent. Examples of the substituent include an alkyl group, an aryl group, a heteroaryl group, an alkoxy group, an aryloxy group, a heteroaryloxy group, an alkylthioether group, an arylthioether group, and a heteroarylthioether group. Among these, from the viewpoint of improvement of the dispersibility of the particles, a group having a steric repulsion effect is preferable, and an alkyl group or alkoxy group having 5 to 24 carbon atoms is preferable. The alkyl group and the alkoxy group may be linear, branched, or cyclic, and are preferably linear or branched.

The graft chain preferably has a structure represented by Formula (G-1a), Formula (G-2a), Formula (G-3a), Formula (G-4a), Formula (G-5a), or Formula (G-6a), and more preferably has a structure represented by Formula (G-1a), Formula (G-4a), or Formula (G-5a).

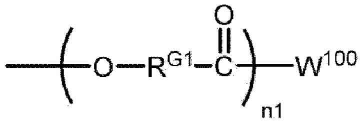

(G-1a)

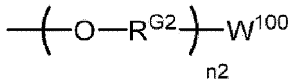

(G-2a)

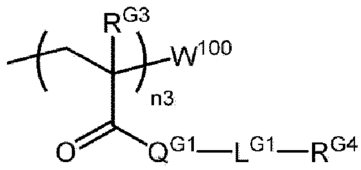

(G-3a)

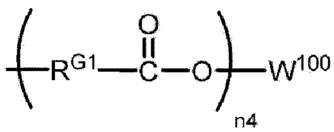

(G-4a)

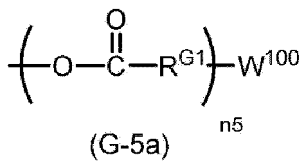

(G-5a)

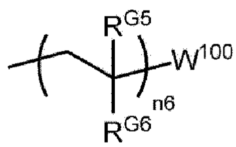

(G-6a)

In the formulae, $R^{G1}$ and $R^{G2}$ each represent an alkylene group, $R^{G3}$ represents a hydrogen atom or a methyl

group, $Q^{G1}$ represents -O- or -NH-, $L^{G1}$ represents a single bond or a divalent linking group, $R^{G4}$ represents a hydrogen atom or a substituent, $R^{G5}$ represents a hydrogen atom or a methyl group, $R^{G6}$ represents an aryl group, $W^{100}$ represents a hydrogen atom or a substituent, and n1 to n6 each independently represent an integer of 2 or more. $R^{G1}$ to $R^{G6}$, $Q^{G1}$, and $L^{G1}$ have the same meanings as $R^{G1}$ to $R^{G6}$, $Q^{G1}$, and $L^{G1}$ described in Formulae (G-1) to (G-6), and preferred ranges thereof are also the same.

In Formulae (G-1a) to (G-6a), it is preferable that $W^{100}$ represents a substituent. Examples of the substituent include an alkyl group, an aryl group, a heteroaryl group, an alkoxy group, an aryloxy group, a heteroaryloxy group, an alkylthioether group, an arylthioether group, and a heteroarylthioether group. Among these, from the viewpoint of improvement of the dispersibility of the particles, a group having a steric repulsion effect is preferable, and an alkyl group or alkoxy group having 5 to 24 carbon atoms is preferable. The alkyl group and the alkoxy group may be linear, branched, or cyclic, and are preferably linear or branched.

In Formulae (G-1a) to (G-6a), n1 to n6 each are preferably an integer of 2 to 100, more preferably an integer of 2 to 80, and still more preferably an integer of 8 to 60.

In Formula (G-1a), in a case where n1 is 2 or more, a plurality of $R^{G1}$'s in each repeating unit may be the same or different from each other. In a case where $R^{G1}$ includes two or more kinds of repeating units different from each other, the arrangement of the repeating units is not particularly limited, and may be performed in any of a random manner, an alternative manner, and a blocked manner. The same applies to Formulae (G-2a) to (G-6a). In addition, the graft chain also preferably has a structure which is represented by Formula (G-1a), Formula (G-4a), or Formula (G-5a) and includes two or more repeating units having different $R^{G1}$'s.

Examples of the repeating unit having a graft chain include a repeating unit represented by Formula (A-1-2).

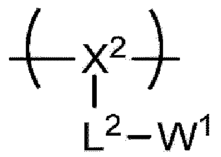

(A-1-2)

In Formula (A-1-2), $X^2$ represents a trivalent linking group, $L^2$ represents a single bond or a divalent linking group, and $W^1$ represents a graft chain.

Examples of the trivalent linking group represented by $X^2$ include a poly(meth)acrylic linking group, a polyalkyleneimine-based linking group, a polyester-based linking group, a polyurethane-based linking group, a polyurea-based linking group, a polyamide-based linking group, a polyether-based linking group, and a polystyrene-based linking group; a poly(meth)acrylic linking group or a polyalkyleneimine-based linking group is preferable, and a poly(meth)acrylic linking group is more preferable.

Examples of the divalent linking group represented by $L^2$ include an alkylene group (preferably an alkylene group having 1 to 12 carbon atoms), an arylene group (preferably an arylene group having 6 to 20 carbon atoms), -NH-, -SO-, $-SO_2-$, -CO-, -O-, -COO-, -OCO-, -S-, and a group formed by a combination of two or more of these groups.

Examples of the graft chain represented by $W^1$ include the graft chains described above.

Specific examples of the repeating unit represented by Formula (A-1-2) include a repeating unit represented by Formula (A-1-2a) and a repeating unit represented by Formula (A-1-2b).

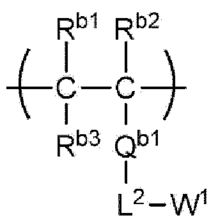

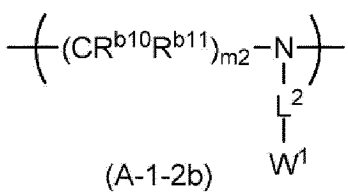

(A-1-2b)

(A-1-2a)

In Formula (A-1-2a), $R^{b1}$ to $R^{b3}$ each independently represent a hydrogen atom or an alkyl group, $Q^{b1}$ represents -CO-, -COO-, -OCO-, -CONH-, or a phenylene group, $L^2$ represents a single bond or a divalent linking group, and $W^1$ represents a graft chain. The number of carbon atoms in the alkyl group represented by $R^{b1}$ to $R^{b3}$ is preferably 1 to 10, more preferably 1 to 3, and still more preferably 1. $Q^{b1}$ is preferably -COO- or -CONH- and more preferably -COO-.

In Formula (A-1-2b), $R^{b10}$ and $R^{b11}$ each independently represent a hydrogen atom or an alkyl group, m2 represents an integer of 1 to 5, $L^2$ represents a single bond or a divalent linking group, and $W^1$ represents a graft chain. The number of carbon atoms in the alkyl group represented by $R^{b10}$ and $R^{b11}$ is preferably 1 to 10 and more preferably 1 to 3.

A weight-average molecular weight (Mw) of the repeating unit having a graft chain is preferably 1,000 or more, more preferably 1,000 to 10,000, and still more preferably 1,000 to 7,500. In the present specification, the weight-average molecular weight of the repeating unit having a graft chain is a value calculated from the weight-average molecular weight of the raw material monomer used for the polymerization of the repeating unit. For example, the repeating unit having a graft chain can be formed by polymerizing a macromonomer. Here, the macromonomer means a polymer compound in which a polymerizable group is introduced at a polymer terminal. In a case where the repeating unit having a graft chain is formed using a macromonomer, the weight-average molecular weight of the macromonomer corresponds to the repeating unit having a graft chain.

A content of the repeating unit having a graft chain in the resin including the repeating unit having a graft chain is preferably 3 to 70 mol%. The lower limit is preferably 4 mol% or higher and more preferably 5 mol% or higher. The upper limit is preferably 60 mol% or lower and more preferably 50 mol% or lower.

The resin including a repeating unit having a graft chain may further include a repeating unit having an acid group. Examples of the acid group include the above-described acid group, and a carboxy group is preferable. A content of the repeating unit having an acid group in the resin including the repeating unit having a graft chain is preferably 10 to 90% mol%. The lower limit is preferably 15 mol% or higher and more preferably 20 mol% or higher. The upper limit is preferably 85 mol% or lower and more preferably 80 mol% or lower.

The resin including a repeating unit having a graft chain may further include a repeating unit having a basic group. Examples of the basic group include the above-described basic group, and an amino group is preferable. The content of the repeating unit having a basic group in the resin including the repeating unit having a graft chain is preferably 20 to 80 mol%. The lower limit is preferably 25 mol% or higher and more preferably 30 mol% or higher. The upper limit is preferably 75 mol% or lower and more preferably 70 mol% or lower.

The resin including a repeating unit having a graft chain may further include a repeating unit having an ethylenically unsaturated bond-containing group. Examples of the ethylenically unsaturated bond-containing group include a vinyl group, a styrene group, a maleimide group, a (meth)allyl group, a (meth)acryloyl group, a (meth)acryloyloxy group, and a (meth)acryloylamide group; and a (meth)acryloyl group, a (meth)acryloyloxy group, or a (meth)acryloylamide group is preferable, a (meth)acryloyloxy group is more preferable, and an acryloyloxy group is still more preferable. The content of the repeating unit having an ethylenically unsaturated bond-containing group in the resin including the repeating unit having a graft chain is preferably 1 to 50 mol%. The lower limit is preferably 3 mol% or higher and more preferably 5 mol% or higher. The upper limit is preferably 40 mol% or lower and more preferably 30 mol% or lower.

The weight-average molecular weight of the resin including the repeating unit having a graft chain is preferably 10,000 to 50,000. The lower limit is preferably 12,000 or more and more preferably 13,000 or more. The upper limit is preferably 45,000 or less and more preferably 40,000 or less.

As the resin, it is also preferable to use a resin having a structure in which a plurality of polymer chains are bonded to a tri- or higher valent linking group. By using such a resin, due to steric hindrance caused by the polymer chain, aggregation and the like of particles in the photosensitive composition can be suppressed more effectively, and excellent storage stability can be obtained. In addition, the above-described phase-separated structure is easily formed in the film during film formation, and the light scattering properties of the obtained film are easily improved.

The weight-average molecular weight of the resin having a structure in which a plurality of polymer chains are bonded to a tri- or higher valent linking group is preferably 5,000 to 20,000. The lower limit is preferably 6,000 or more and more preferably 7,000 or more. The upper limit is preferably 18,000 or less and more preferably 15,000 or less.

Examples of the resin having a structure in which a plurality of polymer chains are bonded to a tri- or higher valent linking group include a resin (hereinafter, also referred to as a resin (SP-1)) having a structure represented by Formula (SP-1).

$$\left[ A^1 - Y^1 \right]_n Z^1 \left[ Y^2 - P^1 \right]_m \qquad \text{(SP-1)}$$

In the formula, $Z^1$ represents an (m+n)-valent linking group,

$Y^1$ and $Y^2$ each independently represent a single bond or a linking group,
$A^1$ represents a group including a functional group selected from a heterocyclic group, an acid group, a group having a basic nitrogen atom, a urea group, a urethane group, a group having a coordinating oxygen atom, a hydrocarbon group having 4 or more carbon atoms, an alkoxysilyl group, an epoxy group, an isocyanate group, and a hydroxy

group,
$P^1$ represents a polymer chain,
n represents 1 to 20, m represents 2 to 20, and m + n is 3 to 21,

An n number of $Y^1$'s and an n number of $A^1$'s may be the same as or different from each other.

m pieces of $Y^2$'s and $P^1$'s may be the same or different from each other.

$A^1$ of Formula (SP-1) represents a group including the above-described functional group. As the functional group included in $A^1$, a heterocyclic group, an acid group, a group having a basic nitrogen atom, a hydrocarbon group having 4 or more carbon atoms, or a hydroxy group is preferable, and an acid group is more preferable. Examples of the acid group include the above-described acid group, and a carboxy group is preferable.

It is sufficient that at least one of the above-described functional groups is included in one $A^1$, and two or more functional groups may be included in one $A^1$. $A^1$ preferably includes 1 to 10 of the above-described substituents, and more preferably includes 1 to 6 of the above-described substituents. In addition, as the group including the above-described functional group, which is represented by $A^1$, a group which is formed by the above-described functional group and a linking group including 1 to 200 carbon atoms, 0 to 20 nitrogen atoms, 0 to 100 oxygen atoms, 1 to 400 hydrogen atoms, and 0 to 40 sulfur atoms being bonded to each other can be used. Examples thereof include a group which is formed by one or more acid groups being bonded through a chain-like saturated hydrocarbon group having 1 to 10 carbon atoms, a cyclic saturated hydrocarbon group having 3 to 10 carbon atoms, or an aromatic hydrocarbon group having 5 to 10 carbon atoms. The chain-like saturated hydrocarbon group, the cyclic saturated hydrocarbon group, and the aromatic hydrocarbon group may further have a substituent. Examples of the substituent include an alkyl group having 1 to 20 carbon atoms, an aryl group having 6 to 16 carbon atoms, a hydroxy group, a carboxy group, an amino group, a sulfonamide group, an N-sulfonylamide group, an acyloxy group having 1 to 6 carbon atoms, an alkoxy group having 1 to 20 carbon atoms, a halogen atom, an alkoxycarbonyl group having 2 to 7 carbon atoms, a cyano group, a carbonic acid ester group, and an ethylenically unsaturated bond-containing group. In addition, the above-described functional group itself may be $A^1$.

A chemical formula weight of $A^1$ is preferably 30 to 2,000. The upper limit is preferably 1,000 or less and more preferably 800 or less. The lower limit is preferably 50 or more and more preferably 100 or more.

Examples of the (m+n)-valent linking group represented by $Z^1$ in Formula (SP-1) include a group composed of 1 to 100 carbon atoms, 0 to 10 nitrogen atoms, 0 to 50 oxygen atoms, 1 to 200 hydrogen atoms, and 0 to 20 sulfur atoms. Examples of the (m+n)-valent linking group also include a group (which may form a ring structure) composed of the following structural unit or a combination of two or more of the following structural units. In the formulae, * represents a bonding site.

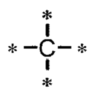 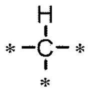 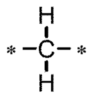 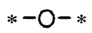 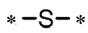 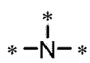 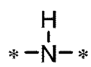 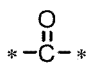 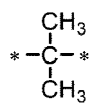

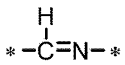 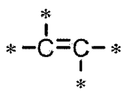 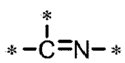 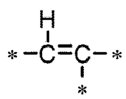 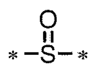 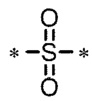 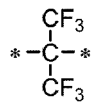

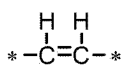 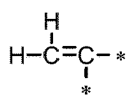 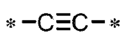 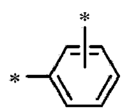 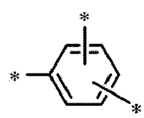

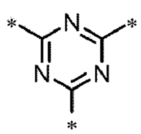 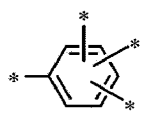 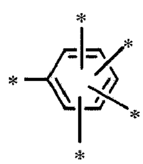 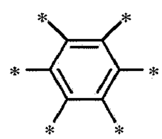

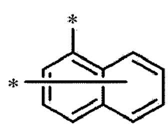 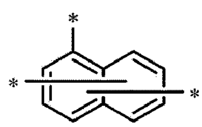 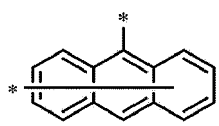

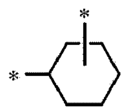
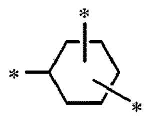
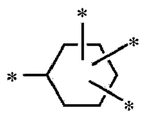
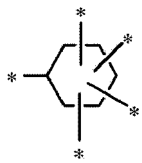
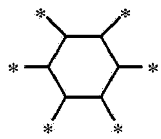
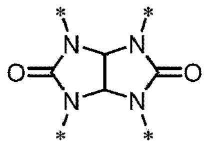
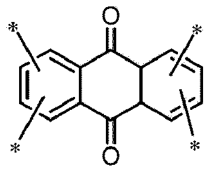
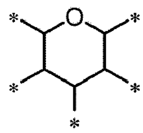

The (m+n)-valent linking group may have a substituent. Examples of the substituent include an alkyl group having 1 to 20 carbon atoms, an aryl group having 6 to 16 carbon atoms, a hydroxy group, an amino group, a carboxy group, a sulfonamide group, an N-sulfonylamide group, an acyloxy group having 1 to 6 carbon atoms, an alkoxy group having 1 to 20 carbon atoms, a halogen atom, an alkoxycarbonyl group having 2 to 7 carbon atoms, a cyano group, a carbonic acid ester group, and an ethylenically unsaturated bond-containing group.

It is preferable that the (m+n)-valent linking group represented by $Z^1$ is a group represented by any one of Formulae (Z-1) to (Z-4).

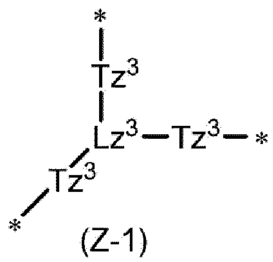

(Z-1)

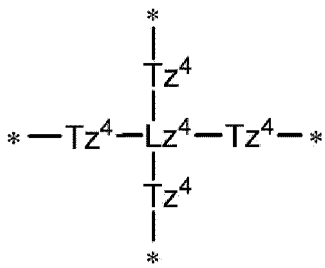

(Z-2)

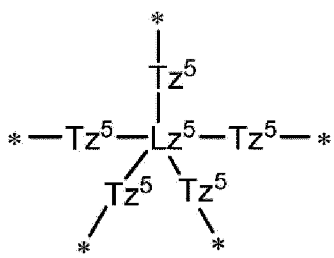

(Z-3)

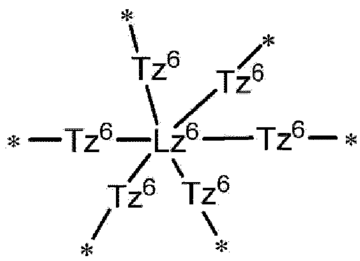

(Z-4)

Formula (Z-1), $Lz^3$ represents a trivalent group, $Tz^3$ represents a single bond or a divalent linking group, and three $Tz^3$'s may be the same or different from each other.

Formula (Z-2), $Lz^4$ represents a tetravalent group, $Tz^4$ represents a single bond or a divalent linking group, and four $Tz^4$'s may be the same or different from each other.

Formula (Z-3), $Lz^5$ represents a pentavalent group, $Tz^5$ represents a single bond or a divalent linking group, and five $Tz^5$'s may be the same or different from each other.

Formula (Z-4), $Lz^6$ represents a hexavalent group, $Tz^6$ represents a single bond or a divalent linking group, and six $Tz^6$'s may be the same or different from each other.

In the above formulae, * represents a bonding site.

Examples of the divalent linking group represented by $Tz^3$ to $Tz^6$ include an alkylene group, an arylene group, a heterocyclic group, -O-, -CO-, -COO-, -OCO-, -NR-, -CONR-, -NRCO-, -S-, -SO-, $-SO_2-$, and a linking group formed by linking two or more of these groups. Here, R's each independently represent a hydrogen atom, an alkyl group, or an aryl group.

The number of carbon atoms in the alkyl group and in the alkylene group is preferably 1 to 30. The upper limit is

more preferably 25 or less and still more preferably 20 or less. The lower limit is more preferably 2 or more and still more preferably 3 or more. The alkyl group and the alkylene group may be linear, branched, or cyclic.

The number of carbon atoms in the aryl group and in the arylene group is preferably 6 to 20 and more preferably 6 to 12.

The heterocyclic group is preferably a 5-membered ring or a 6-membered ring. A heteroatom included in the heterocyclic group is preferably an oxygen atom, a nitrogen atom, or a sulfur atom. The number of heteroatoms included in the heterocyclic group is preferably 1 to 3.

The alkylene group, the arylene group, the heterocyclic group, the alkyl group, and the aryl group may be unsubstituted or may have the above-described substituent.

Examples of the trivalent group represented by $Lz^3$ include a group obtained by removing one hydrogen atom from the above-described divalent linking group. Examples of the tetravalent group represented by $Lz^4$ include a group obtained by removing two hydrogen atoms from the above-described divalent linking group. Examples of the pentavalent group represented by $Lz^5$ include a group obtained by removing three hydrogen atoms from the above-described divalent linking group. Examples of the hexavalent group represented by $Lz^6$ include a group obtained by removing four hydrogen atoms from the above-described divalent linking group. The trivalent to hexavalent group represented by $Lz^3$ to $Lz^6$ may have the above-described substituent.

A chemical formula weight of $Z^1$ is preferably 20 to 3,000. The upper limit is preferably 2,000 or less and more preferably 1,500 or less. The lower limit is preferably 50 or more and more preferably 100 or more. The chemical formula weight of $Z^1$ is a value calculated from the structural formula.

Specific examples of the (m+n)-valent linking group can be found in paragraphs 0043 to 0055 of JP2014-177613A, the content of which is incorporated herein by reference.

In Formula (SP-1), $Y^1$ and $Y^2$ each independently represent a single bond or a linking group. Examples of the linking group include a group composed of 1 to 100 carbon atoms, 0 to 10 nitrogen atoms, 0 to 50 oxygen atoms, 1 to 200 hydrogen atoms, and 0 to 20 sulfur atoms. The above-described group may further have the above-described substituent. Specific examples of the linking group represented by $Y^1$ and $Y^2$ include a group composed of the following structural units or a combination of two or more of the structural units. In the formulae, * represents a bonding site.

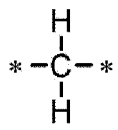 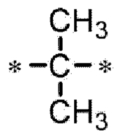 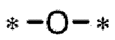 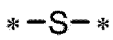 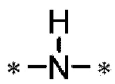 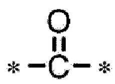 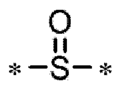 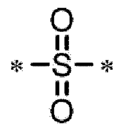

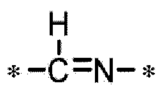 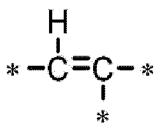 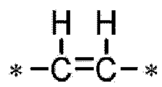 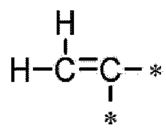 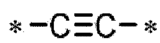

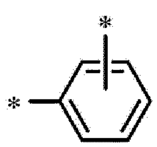 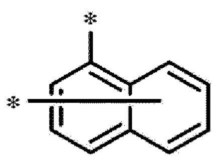 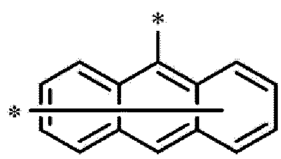 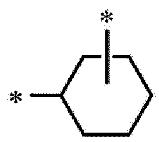

In Formula (SP-1), $P^1$ represents a polymer chain. The polymer chain represented by $P^1$ preferably includes a repeating unit having at least one structure selected from a polyether structure, a polyester structure, a poly(meth)acrylic structure, a polystyrene structure, a polyurethane structure, a polyurea structure, or a polyamide structure, more preferably includes a repeating unit having at least one structure selected from a polyether structure, a polyester structure, a poly(meth)acrylic structure, or a polystyrene structure, and still more preferably includes a repeating unit having a poly(meth)acrylic structure.

Examples of the repeating unit having a polyester structure include the repeating unit having a structure represented by Formula (G-1), Formula (G-4), or Formula (G-5) described above. Examples of the repeating unit having a polyether structure include the repeating unit having a structure represented by Formula (G-2) described above. Examples of the repeating unit having a poly(meth)acrylic structure include the repeating unit having a structure represented by Formula (G-3) described above. Examples of the repeating unit having a polystyrene structure include the repeating unit having a structure represented by Formula (G-6) described above.

The polymer chain represented by $P^1$ may include a repeating unit having an acid group. Examples of the acid group included in the repeating unit having an acid group include the above-described acid group, and a carboxy group is

preferable. The content of the repeating unit having an acid group in all the repeating units constituting $P^1$ is preferably 5 to 50 mol%. The lower limit is preferably 7 mol% or higher and more preferably 10 mol% or higher. The upper limit is preferably 45 mol% or lower and more preferably 40 mol% or lower.

The polymer chain represented by $P^1$ may include a repeating unit having a basic group. Examples of the basic group contained in the repeating unit having a basic group include the above-described basic group, and an amino group is preferable. The content of the repeating unit having a basic group in all the repeating units constituting $P^1$ is preferably 5 to 50 mol%. The lower limit is preferably 7 mol% or higher and more preferably 10 mol% or higher. The upper limit is preferably 45 mol% or lower and more preferably 40 mol% or lower.

The polymer chain represented by $P^1$ may further include a repeating unit having an ethylenically unsaturated bond-containing group. Examples of the ethylenically unsaturated bond-containing group include a vinyl group, a styrene group, a maleimide group, a (meth)allyl group, a (meth)acryloyl group, a (meth)acryloyloxy group, and a (meth) acryloylamide group; and a (meth)acryloyl group, a (meth)acryloyloxy group, or a (meth)acryloylamide group is preferable, a (meth)acryloyloxy group is more preferable, and an acryloyloxy group is still more preferable. The content of the repeating unit having an ethylenically unsaturated bond-containing group in all the repeating units constituting $P^1$ is preferably 1 to 65 mol%. The lower limit is preferably 3 mol% or higher and more preferably 5 mol% or higher. The upper limit is preferably 60 mol% or lower and more preferably 55 mol% or lower.

A weight-average molecular weight of the polymer chain represented by $P^1$ is preferably 1,000 or more and more preferably 1,000 to 10,000. The upper limit is preferably 9,000 or less, more preferably 6,000 or less, and still more preferably 3,000 or less. The lower limit is preferably 1,200 or more and more preferably 1,400 or more. The weight-average molecular weight of $P^1$ is a value calculated from the weight-average molecular weight of a raw material used for introducing into the polymer chain.

Specific examples of the resin (SP-1) include polymer compounds C-1 to C-31 described in paragraphs 0196 to 0209 of JP2013-043962A, polymer compounds (C-1) to (C-61) described in paragraphs 0256 to 0269 of JP2014-177613A, and a resin having a structure described in paragraph 0061 of WO2018/163668A, the contents of which are incorporated herein by reference.

As the resin, a random polymer or a block polymer can also be used.

As the resin used in the present invention, a resin having at least one selected from an acid value or a base number is used. The resin having at least one selected from an acid value or a base number is also referred to as a specific resin. The specific resin may be used as a dispersant or a binder. In the present specification, the acid value of a resin is a value representing a mass of potassium hydroxide required to neutralize an acidic component per 1 g of a solid content of the resin, and the base number is a value representing a mass of potassium hydroxide equivalent to that of hydrochloric acid required to neutralize a basic component per 1 g of a solid content of the resin.

Examples of the resin having an acid value, which is used as the specific resin, include a resin having an acid group. Examples of one aspect of the resin having an acid value include a resin having a repeating unit having an acid group.

Examples of the resin having a base number, which is used as the specific resin, include a resin having a basic group. Examples of one aspect of the resin having a base number include a resin having a repeating unit having a basic group.

Examples of the resin having an acid value and a base number, which is used as the specific resin, include a resin having each of an acid value and a basic group. Examples of one aspect of the resin having an acid value and a base number include a resin having a repeating unit having an acid group and a repeating unit having a basic group.

The specific resin is preferably a resin including a repeating unit having a graft chain or a resin having a structure in which a plurality of polymer chains are bonded to a tri- or higher valent linking group.

The specific resin preferably includes a repeating unit of at least one structure selected from a polyether structure, a polyester structure, a poly(meth)acrylic structure, a polystyrene structure, a polyurethane structure, a polyurea structure, or a polyamide structure, more preferably includes a repeating unit of at least one structure selected from a polyether structure, a polyester structure, or a poly(meth)acrylic structure, and still more preferably includes a repeating unit of at least one structure selected from a polyester structure or a poly(meth)acrylic structure.

It is also preferable that the resin contained in the photosensitive composition according to the embodiment of the present invention includes a resin having a repeating unit of a poly(meth)acrylic structure and a resin having a repeating unit of a polyester structure, and at least one of the resin having a repeating unit of a poly(meth)acrylic structure or the resin having a repeating unit of a polyester structure is the above-described specific resin. According to this aspect, the above-described phase-separated structure is easily formed in the film during film formation, and the light scattering properties of the obtained film can be further improved.

**In** a case where the resin having a repeating unit of a poly(meth)acrylic structure and the resin having a repeating unit of a polyester structure are contained, the content of the resin having a repeating unit of a polyester structure is preferably 20 to 250 parts by mass with respect to 100 parts by mass of the resin having a repeating unit of a poly(meth) acrylic structure. The upper limit is preferably 230 parts by mass or less and more preferably 200 parts by mass or less. The

lower limit thereof is preferably 30 parts by mass or more and more preferably 50 parts by mass or more.

In a case where the specific resin is a resin having an acid value, the acid value of the specific resin is preferably 30 to 250 mgKOH/g. The upper limit is preferably 230 mgKOH/g or less, and more preferably 200 mgKOH/g or less. The lower limit is preferably 35 mgKOH/g or higher and more preferably 40 mgKOH/g or higher.

In a case where the specific resin is a resin having a base number, the base number of the specific resin is preferably 20 to 150 mgKOH/g. The upper limit is preferably 140 mgKOH/g or less, and more preferably 130 mgKOH/g or less. The lower limit is preferably 25 mgKOH/g or higher and more preferably 30 mgKOH/g or higher.

In a case where the specific resin is a resin having an acid value and a base number, a ratio of the acid value to the base number (acid value/base number) of the specific resin is preferably 0.5 to 1.5. The lower limit of the peak intensity ratio is preferably 0.6 or more and more preferably 0.7 or more. The upper limit thereof is preferably 1.4 or less, more preferably 1.3 or less, and still more preferably 1.2 or less. In addition, the acid value of the specific resin is preferably 30 to 120 mgKOH/g, and the base number is preferably 20 to 130 mgKOH/g. The upper limit of the acid value is preferably 115 mgKOH/g or less, and more preferably 110 mgKOH/g or less. The lower limit of the acid value is preferably 35 mgKOH/g or higher and more preferably 40 mgKOH/g or higher. The upper limit of the base number is preferably 125 mgKOH/g or less, and more preferably 120 mgKOH/g or less. The lower limit of the base number is preferably 25 mgKOH/g or higher and more preferably 30 mgKOH/g or higher.

The weight-average molecular weight of the specific resin is preferably 4,000 to 50,000. The upper limit is preferably 45,000 or less and more preferably 40,000 or less. The lower limit is preferably 4,500 or more and more preferably 5,000 or more.

As a preferred embodiment, the resin used in the present invention includes an aspect including a resin having an acid value and a base number. That is, an aspect in which a resin having an acid value and a base number is used as the specific resin is shown as an example. According to this aspect, the storage stability of the photosensitive composition can be further improved, and furthermore, the developability is also good.

In this aspect, the resin having an acid value and a base number may be a dispersant or a binder, but from the reason that the storage stability of the photosensitive composition can be further improved, it is preferable that the resin as a dispersant includes a resin having an acid value and a base number. That is, it is preferable that the photosensitive composition includes a resin as a dispersant, and the resin as a dispersant includes a resin having an acid value and a base number. In addition, the resin having an acid value and a base number is preferably a resin including a repeating unit having a graft chain or a resin having a structure in which a plurality of polymer chains are bonded to a tri- or higher valent linking group. The photosensitive composition in this aspect may further contain a resin as a binder. From the reason of further improving developability, it is preferable that the resin as a binder includes a resin having an acid value.

As another preferred embodiment, an aspect is shown, in which the resin used in the present invention includes one or more kinds of resins having an acid value and one or more kinds of resins having a base number. That is, an aspect, in which the specific resin includes each of one or more kinds of resins having an acid value and one or more kinds of resins having a base number, is shown as an example. According to this aspect, the storage stability of the photosensitive composition can be further improved, and furthermore, the developability is also good. The resin having an acid value used in this aspect may be a resin having an acid value and not having a base number. In addition, the resin having a base number may be a resin having a base number and not having an acid value.

In this aspect, the resin having an acid value and the resin having a base number may be a dispersant or a binder. From the reason of further improving the storage stability of the photosensitive composition, it is preferable that the resin as a dispersant includes a resin having a base number. In addition, from the reason of further improving developability, it is preferable that the resin as a binder includes a resin having an acid value. That is, in this aspect, it is preferable that the photosensitive composition contains a resin as a dispersant and a resin as a binder, the resin as a dispersant contains a resin having a base number, and the resin as a binder contains a resin having an acid value. In addition the resin as a dispersant is preferably a resin including a repeating unit having a graft chain or a resin having a structure in which a plurality of polymer chains are bonded to a tri- or higher valent linking group.

As another preferred embodiment, the resin used in the present invention includes an aspect including a resin having an acid value. That is, an aspect in which a resin having an acid value is included as the specific resin is shown as an example. In this aspect, it is preferable that polyalkyleneimine described later is further contained, from the reason in which the storage stability of the photosensitive composition can be further improved. The resin having an acid value used in this aspect may not have a base number.

In this aspect, the resin having an acid value may be a dispersant or a binder. From the reason of further improving the storage stability and developability of the photosensitive composition, it is preferable to use a resin having an acid value as the resin as a dispersant and the resin as a binder. That is, in this aspect, it is preferable that the photosensitive composition includes a resin as a dispersant and a resin as a binder, and the resin as a dispersant and the resin as a binder include a resin having an acid value. In addition the resin as a dispersant is preferably a resin including a repeating unit having a graft chain or a resin having a structure in which a plurality of polymer chains are bonded to a tri- or higher valent linking group.

A content of the resin in the total solid content of the photosensitive composition is preferably 1% to 50% by mass. The lower limit is preferably 5% by mass or more and more preferably 10% by mass or more. The upper limit is preferably 45% by mass or less, more preferably 40% by mass or less, and still more preferably 35% by mass or less.

The content of the above-described specific resin in the resin contained in the photosensitive composition is preferably 10 to 100% by mass. The lower limit is preferably 20% by mass or more and more preferably 30% by mass or more.

In a case where a resin having an acid value and a base number is used as the specific resin, the content of the resin having an acid value and a base number in the resin contained in the photosensitive composition is preferably 10% to 100% by mass. The lower limit is preferably 20% by mass or more and more preferably 30% by mass or more. The upper limit is preferably 90% by mass or less and more preferably 80% by mass or less.

In a case where a resin having a base number is used as the specific resin, the content of the resin having a base number in the resin contained in the photosensitive composition is preferably 10% to 100% by mass. The lower limit is preferably 20% by mass or more and more preferably 30% by mass or more. The upper limit is preferably 90% by mass or less and more preferably 80% by mass or less.

In a case where a resin having an acid value is used as the specific resin, the content of the resin having an acid value in the resin contained in the photosensitive composition is preferably 10% to 100% by mass. The lower limit is preferably 20% by mass or more and more preferably 30% by mass or more.

One kind of resin may be used alone, or two or more kinds thereof may be used in combination. In a case where two or more kinds of resins are used in combination, the total content thereof is preferably within the above-described range.

<<Polymerizable monomer>>

The photosensitive composition according to the embodiment of the present invention preferably contains a polymerizable monomer. Examples of the polymerizable monomer include a compound having an ethylenically unsaturated bond-containing group. Examples of the ethylenically unsaturated bond-containing group include a vinyl group, a (meth)allyl group, and a (meth)acryloyl group. It is preferable that the polymerizable monomer is a radically polymerizable monomer.

The polymerizable monomer is preferably a compound including 2 or more ethylenically unsaturated bond-containing groups, more preferably a compound including 3 or more ethylenically unsaturated bond-containing groups, and still more preferably a compound including 4 or more ethylenically unsaturated bond-containing groups. The upper limit of the ethylenically unsaturated bond-containing group is preferably 15 or less, more preferably 10 or less, and still more preferably 6 or less. As the polymerizable monomer, a (meth)acrylate compound having 3 or more functional groups is preferable, a (meth)acrylate compound having 3 to 15 functional groups is more preferable, a (meth)acrylate compound having 3 to 10 functional groups is still more preferable, and a (meth)acrylate compound having 3 to 6 functional groups is particularly preferable.

The molecular weight of the polymerizable monomer is preferably 200 to 3,000. The upper limit of the molecular weight is preferably 2,500 or less and still more preferably 2,000 or less. The lower limit of the molecular weight is preferably 250 or more and still more preferably 300 or more.

In addition, it is also preferable that the polymerizable monomer is a compound having a group having an ethylenically unsaturated bond-containing group which has a boiling point at 100°C or higher under normal pressure and has at least one ethylene group capable of addition polymerization. Examples of the polymerizable monomer include: a monofunctional acrylate or methacrylate such as polyethylene glycol mono(meth)acrylate, polypropylene glycol mono(meth)acrylate, or phenoxyethyl (meth)acrylate; polyethylene glycol di(meth)acrylate, trimethylol ethane tri(meth)acrylate, neopentyl glycol di(meth)acrylate, pentaerythritol tri(meth)acrylate, pentaerythritol tetra(meth)acrylate, dipentaerythritol penta(meth)acrylate, dipentaerythritol hexa(meth)acrylate, hexanediol (meth)acrylate, trimethylol propane tri(acryloyloxypropyl)ether, or tri(acryloyloxyethyl)isocyanurate; and mixtures of the above-described compounds. Among these, pentaerythritol tetra(meth)acrylate is preferable.

In addition, as the polymerizable monomer, a compound represented by any one of the following Formulae (MO-1) to (MO-5) can also be suitably used. In a case where T in the formulae represents an oxyalkylene group, a terminal thereof on a carbon atom side in T is bonded to R.

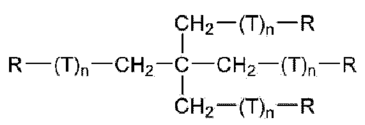

(MO-1)

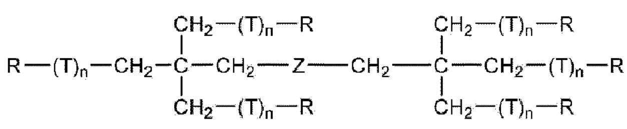

(MO-2)

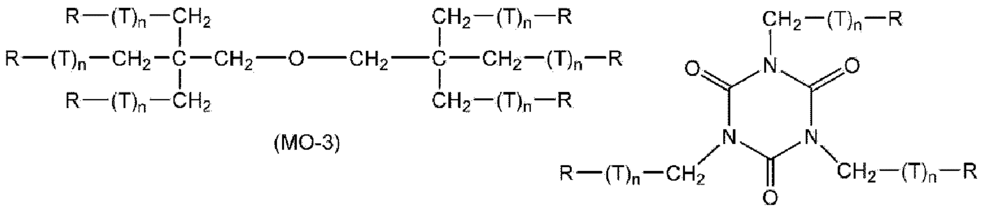

(MO-3)

(MO-4)

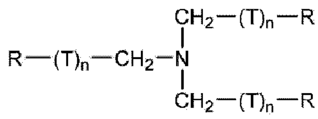

(MO-5)

R: 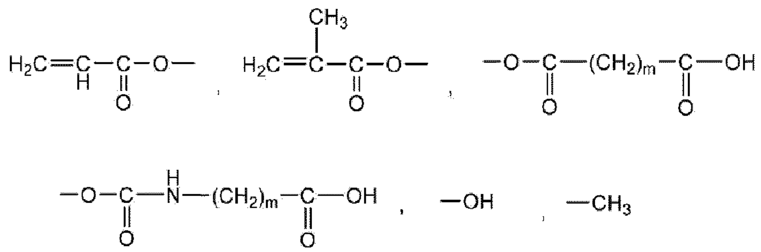

T: $—(CH_2)_m—$ , $—OCH_2—$ , $—OCH_2CH_2—$ , $—OCH_2CH_2CH_2—$ , $—OCH_2CH_2CH_2CH_2—$ ,

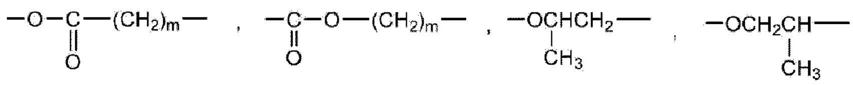

Z: 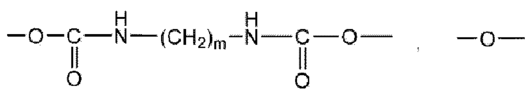

In the formulae, n represents 0 to 14, and m represents 1 to 8. A plurality of R's and a plurality of T's which are present in the same molecule may be the same as or different from each other. At least one of a plurality of R's which are present in each of the compounds represented by Formula (MO-1) to (MO-5) represents a group represented by $-OC(=O)CH=CH_2$ or $-OC(=O)C(CH_3)=CH_2$. Specific examples of the compounds represented by Formulae (MO-1) to (MO-5) include compounds described in paragraphs 0248 to 0251 of JP2007-269779A, the content of which is incorporated herein by reference.

As the polymerizable monomer, dipentaerythritol tri(meth)acrylate (as a commercially available product, KAYARAD D-330 manufactured by Nippon Kayaku Co., Ltd.), dipentaerythritol tetra(meth)acrylate (as a commercially available product, KAYARAD D-320 manufactured by Nippon Kayaku Co., Ltd.), dipentaerythritol penta(meth)acrylate (as a commercially available product, KAYARAD D-310 manufactured by Nippon Kayaku Co., Ltd.), dipentaerythritol hexa(meth)acrylate (as a commercially available product, KAYARAD DPHA manufactured by Nippon Kayaku Co., Ltd. and NK ESTER A-DPH-12E manufactured by Shin-Nakamura Chemical Co., Ltd.), a compound having a structure in which a (meth)acryloyl group thereof is bonded through an ethylene glycol residue and/or a propylene glycol residue (for example, SR454 and SR499 available from Sartomer Japan Inc.), diglycerin ethylene oxide (EO)-modified (meth)acrylate (as a commercially available product, M-460 manufactured by TOAGOSEI Co., Ltd.), pentaerythritol tetra(meth)acrylate (NK ESTER A-TMMT manufactured by Shin-Nakamura Chemical Co., Ltd.), 1,6-hexanediol diacrylate (KAYARAD HDDA manufactured by Nippon Kayaku Co., Ltd.), KAYARAD RP-1040 (manufactured by Nippon Kayaku Co., Ltd.), ARONIX TO-2349 (manufactured by TOAGOSEI Co., Ltd.), NK OLIGO UA-7200 (manufactured by Shin-Nakamura Chemical Co., Ltd.), 8UH-1006 and 8UH-1012 (manufactured by Taisei Fine Chemical Co., Ltd.), Light Acrylate POB-A0 (manufactured by KYOEISHA CHEMICAL Co., Ltd.), or the like can also be used.

In the polymerizable monomer, it is also preferable to use a trifunctional (meth)acrylate compound such as trimethylolpropane tri(meth)acrylate, trimethylolpropane propyleneoxide-modified tri(meth)acrylate, trimethylolpropane ethyleneoxide-modified tri(meth)acrylate, isocyanuric acid ethyleneoxide-modified tri(meth)acrylate, and pentaerythritol tri(meth)acrylate. Examples of a commercially available product of the trifunctional (meth)acrylate compound include ARONIX M-309, M-310, M-321, M-350, M-360, M-313, M-315, M-306, M-305, M-303, M-452, and M-450 (manufactured

by TOAGOSEI Co., Ltd.), NK ESTER A9300, A-GLY-9E, A-GLY-20E, A-TMM-3, A-TMM-3L, A -TMM-3LM-N, A-TMPT, and TMPT (manufactured by Shin-Nakamura Chemical Co., Ltd.), and KAYARAD GPO-303, TMPTA, THE-330, TPA-330, and PET-30 (manufactured by Nippon Kayaku Co., Ltd.).

The polymerizable monomer may be a compound having an acid group such as a carboxy group, a sulfo group, or a phosphoric acid group. Examples of the polymerizable monomer having an acid group include an ester of an aliphatic polyhydroxy compound and an unsaturated carboxylic acid. Examples of a commercially available product include ARONIX series M-305, M-510, or M-520 manufactured by Toagosei Co., Ltd. The acid value of the polymerizable monomer having an acid group is preferably 0.1 to 40 mgKOH/g. The lower limit is preferably 5 mgKOH/g or more. The upper limit thereof is preferably 30 mgKOH/g or less.

The polymerizable monomer may be a compound including a ring structure. By using a polymerizable monomer including a ring structure, it is easy to form a phase-separated structure in the film during film formation, and a film having more excellent light scattering properties can be formed. For the reason that the above-described effect can be obtained more remarkably, the ring structure included in the polymerizable monomer is preferably an aliphatic ring. In addition, the aliphatic ring is preferably an aliphatic crosslinked ring. The aliphatic crosslinked ring is an aliphatic ring having a structure in which two or more atoms that are not adjacent to each other are linked to one aliphatic ring. Specific examples of the aliphatic crosslinked ring include a tricyclodecane ring and an adamantane ring, and a tricyclodecane ring is preferable. From the viewpoint of mobility of the monomer, the number of ring structures included in the polymerizable monomer is preferably 1 to 5, more preferably 1 to 3, and still more preferably 1. Specific examples of the polymerizable monomer including a ring structure include dimethylol-tricyclodecanediacrylate and 1,3-adamantananediol diacrylate.

A content of the polymerizable monomer in the total solid content of the photosensitive composition is preferably 0.1% to 40% by mass. The lower limit is preferably 0.5% by mass or more, more preferably 1% by mass or more, still more preferably 5% by mass or more, and even still more preferably 10% by mass or more. The upper limit is preferably 35% by mass or less, more preferably 33% by mass or less, and still more preferably 30% by mass or less. As the polymerizable monomer, one kind may be used alone, or two or more kinds may be used in combination. In a case where two or more polymerizable monomers are used in combination, it is preferable that the total content thereof is within the above-described range.

In addition, the content of the polymerizable monomer is preferably 10 to 400 parts by mass with respect to 100 parts by mass of the resin. The lower limit is preferably 15 parts by mass or more and more preferably 20 parts by mass or more. The upper limit thereof is preferably 380 parts by mass or less and more preferably 350 parts by mass or less.

In addition, the total content of the polymerizable monomer and the resin in the total solid content of the photosensitive composition is preferably 10% to 80% by mass. The upper limit is preferably 70% by mass or less, more preferably 65% by mass or less, and still more preferably 60% by mass or less. The lower limit is preferably 20% by mass or more and more preferably 30% by mass or more.

<<Polyalkyleneimine>>

The photosensitive composition according to the embodiment of the present invention can also contain polyalkyleneimine. In particular, in a case where a resin having an acid value (more preferably, a resin having an acid value and not having a base number) is used as the resin, it is preferable that the photosensitive composition according to the embodiment of the present invention further contains polyalkyleneimine. According to this aspect, storage stability of the photosensitive composition can be further improved.

The polyalkyleneimine is a polymer obtained by a ring-opening polymerization of alkyleneimine. The polyalkyleneimine is a polymer having a branched structure including each of a primary amino group, a secondary amino group, and a tertiary amino group. The number of carbon atoms in the alkyleneimine is preferably 2 to 6, more preferably 2 to 4, still more preferably 2 or 3, and particularly preferably 2.

A molecular weight of the polyalkyleneimine is preferably 200 or more and more preferably 250 or more. The upper limit thereof is preferably 100,000 or less, more preferably 50,000 or less, still more preferably 10,000 or less, and particularly preferably 2,000 or less. With regard to the value of the molecular weight of the polyalkyleneimine, in a case where the molecular weight can be calculated from a structural formula, the molecular weight of the polyalkyleneimine is a value calculated from the structural formula. On the other hand, in a case where the molecular weight of the specific amine compound cannot be calculated from the structural formula or is difficult to calculate, a value of a number-average molecular weight measured by a boiling point increase method is used. In addition, even in a case where the molecular weight of the polyalkyleneimine cannot be measured by the boiling point increase method or is difficult to be measured, a value of a number-average molecular weight measured by a viscosity method is used. In addition, in a case where the molecular weight of the polyalkyleneimine cannot be measured by the viscosity method or is difficult to be measured by the viscosity method, a value of a number-average molecular weight in terms of polystyrene through measurement by a gel permeation chromatography (GPC) method is used.

An amine value of the polyalkyleneimine is preferably 5 mmol/g or more, more preferably 10 mmol/g or more, and

still more preferably 15 mmol/g or more.

Specific examples of the alkyleneimine include ethyleneimine, propyleneimine, 1,2-butyleneimine, and 2,3-butyleneimine, and ethyleneimine or propyleneimine is preferable and ethyleneimine is more preferable. The polyalkyleneimine is particularly preferably polyethyleneimine. In addition, the polyethyleneimine preferably includes the primary amino group in an amount of 10 mol% or higher, more preferably includes the primary amino group in an amount of 20 mol% or higher, and still more preferably includes the primary amino group in an amount of 30 mol% or higher with respect to the total of the primary amino group, the secondary amino group, and the tertiary amino group. Examples of a commercially available product of the polyethyleneimine include EPOMIN SP-003, SP-006, SP-012, SP-018, SP-200, and P-1000 (all of which are manufactured by NIPPON SHOKUBAI Co., Ltd.).

A content of the polyalkyleneimine in the total solid content of the photosensitive composition is preferably 0.05% to 5% by mass. The lower limit is preferably 0.10% by mass or more and more preferably 0.15% by mass or more. The upper limit thereof is preferably 4% by mass or less and more preferably 3% by mass or less. In addition, the content of the polyalkyleneimine is preferably 0.5 to 10 parts by mass with respect to 100 parts by mass of the specific particles. The lower limit is preferably 0.7 parts by mass or more and more preferably 1.0 parts by mass or more. The upper limit is preferably 5 parts by mass or less and more preferably 3 parts by mass or less. The polyalkyleneimine may be used alone or in combination of two or more kinds thereof. In a case where two or more kinds thereof are used, the total content thereof is preferably within the above-described range.

<<Solvent>>

The photosensitive composition according to the embodiment of the present invention preferably contains a solvent. Examples of the solvent include an organic solvent. Basically, the solvent is not particularly limited as long as it satisfies solubility of the respective components or coatability of the photosensitive composition. Examples of the organic solvent include an ester-based solvent, a ketone-based solvent, an alcohol-based solvent, an amide-based solvent, an ether-based solvent, and a hydrocarbon-based solvent. The details of the organic solvent can be found in paragraph 0223 of WO2015/166779A, the content of which is incorporated herein by reference. In addition, an ester-based solvent in which a cyclic alkyl group is substituted or a ketone-based solvent in which a cyclic alkyl group is substituted can also be preferably used. Specific examples of the organic solvent include acetone, methyl ethyl ketone, cyclohexane, cyclohexanone, cyclopentanone, ethyl acetate, butyl acetate, cyclohexyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, 2-methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxy propyl acetate, N,N-dimethylformamide, dimethyl sulfoxide, γ-butyrolactone, methyl lactate, ethyl lactate, butyl diglycol acetate, 3-methoxy butyl acetate, 3-methoxy-N,N-dimethylpropanamide, 3-butoxy-N,N-dimethylpropanamide, γ-butyrolactone, sulfolane, anisole, 1,4-diacetoxybutane, diethylene glycol monoethyl ether acetate, butane-1,3-diyl diacetate, dipropylene glycol methyl ether acetate, 2-methoxypropyl acetate, 2-methoxy-1-propanol, and isopropyl alcohol. Among these organic solvents, one kind can be used alone, or a mixture of two or more kinds can be used.

In the present invention, an organic solvent having a low metal content is preferably used. For example, the metal content in the organic solvent is preferably 10 mass parts per billion (ppb) or less. Optionally, an organic solvent having a metal content at a mass parts per trillion (ppt) level may be used. For example, such an organic solvent is available from Toyo Gosei Co., Ltd. (The Chemical Daily, November 13, 2015).

Examples of a method for removing impurities such as a metal from the organic solvent include distillation (such as molecular distillation and thin-film distillation) and filtration using a filter. The filter pore size of the filter used for the filtration is preferably 10 μm or less, more preferably 5 μm or less, and still more preferably 3 μm or less. As a material of the filter, polytetrafluoroethylene, polyethylene, or nylon is preferable.

The organic solvent may include an isomer (a compound having the same number of atoms and a different structure). In addition, only one kind of isomers may be included, or a plurality of isomers may be included.

The organic solvent preferably has the content of peroxides of 0.8 mmol/L or less, and more preferably, the organic solvent does not substantially contain peroxides.

A content of the solvent in the photosensitive composition is preferably 10% to 95% by mass. The lower limit is preferably 15% by mass or more, more preferably 20% by mass or more, still more preferably 25% by mass or more, even more preferably 30% by mass or more, and still even more preferably 40% by mass or more. The upper limit is preferably 90% by mass or less, more preferably 85% by mass or less, and still more preferably 80% by mass or less. As the solvent, one kind may be used alone, or two or more kinds may be used in combination. In a case where two or more solvents are used in combination, it is preferable that the total content of the solvents is within the above-described range.

<<Pigment derivative>>

The photosensitive composition according to the embodiment of the present invention can further include a pigment derivative. Examples of the pigment derivative include a compound having a structure in which a portion of a chromophore is substituted with an acidic group, a basic group, or a phthalimidomethyl group. Examples of the acid group include a sulfo group, a carboxy group, and a quaternary ammonium salt group thereof. Examples of the basic group include an amino group. The details of the pigment derivative can be found in paragraphs 0162 to 0183 of JP2011-252065A, the content of which is incorporated herein by reference. The content of the pigment derivative is preferably 1 to 30 parts by mass and more preferably 3 to 20 parts by mass with respect to 100 parts by mass of the pigment. Among these pigment derivatives, one kind may be used alone, or two or more kinds may be used in combination. In a case where two or more pigment derivatives are used in combination, it is preferable that the total content of the pigment derivatives is within the above-described range.

<<Anti-coloring agent>>

The photosensitive composition according to the embodiment of the present invention can contain an anti-coloring agent. Examples of the anti-coloring agent include a phenol compound, a phosphite compound, and a thioether compound. Among these, a phenol compound having a molecular weight of 500 or more, a phosphite compound having a molecular weight of 500 or more, or a thioether compound having a molecular weight of 500 or more is preferable. The anti-coloring agent is preferably a phenol compound, and more preferably a phenol compound having a molecular weight of 500 or more.
Examples of the phenol compound include a hindered phenol compound. In particular, a compound having a substituent at a position (ortho position) adjacent to a phenolic hydroxy group is preferable. As the substituent, a substituted or unsubstituted alkyl group having 1 to 22 carbon atoms is preferable. In addition, a compound having a phenol group and a phosphite group in the same molecule is also preferable.
As the phenolic hydroxy group-containing compound, a polysubstituted phenol compound is suitably used. The polysubstituted phenol compound can be classified into three types (a hindered type represented by the following Formula (A), a semi-hindered type represented by the following Formula (B), and a less-hindered type represented by the following Formula (C)) having different substitution sites and different structures in terms of reactivity to a peroxy radical trapped for the stable generation of a phenoxy radical.

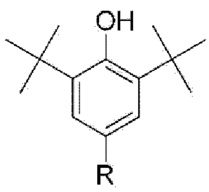
(A)

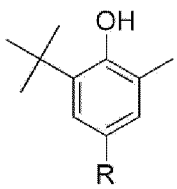
(B)

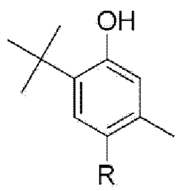
(C)

In Formulae (A) to (C), R represents a hydrogen atom or a substituent. R represents preferably a hydrogen atom, a halogen atom, an amino group which may have a substituent, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent, and more preferably an amino group which may have a substituent, an alkyl group which may have a substituent, an aryl group which may have a substituent, an alkoxy group which may have a substituent, an aryloxy group which may have a substituent, an alkylamino group which may have a substituent, or an arylamino group which may have a substituent.
As a further preferable form, a composite anti-coloring agent in which a plurality of structures represented by Formulae (A) to (C) described above, having an antioxidant function, are present in the same molecule is still more preferable. Specifically, a compound in which 2 to 4 structures represented by Formulae (A) to (C) described above, having an antioxidant function, are present in the same molecule is preferable. Among these, the semi-hindered type represented by Formula (B) is more preferable. Representative examples of a commercially available product of (A) include SUMILIZER BHT (manufactured by Sumitomo Chemical Co., Ltd.), IRGANOX 1010 and 1222 (manufactured by BASF), and ADEKA STAB AO-20, AO-50, and AO-60 (manufactured by ADEKA Corporation). Representative examples of a commercially available product of (B) include SUMILIZER BBM-S (manufactured by Sumitomo Chemical Co., Ltd.), IRGANOX 245 (manufactured by BASF), and ADEKA STAB AO-80 (manufactured by ADEKA Corporation). Representative examples of a commercially available product of (C) include ADEKA STAB AO-30 and AO-40 (manufactured by

ADEKA Corporation).

Examples of the phosphite compound and the thioether compound include compounds described in paragraphs 0213 and 0214 of WO2017/159910A and commercially available products. In addition to the above-described representative examples, examples of a commercially available product of the anti-coloring agent include ADEKA STAB AO-50F, ADEKA STAB AO-60G, and ADEKA STAB AO-330 (manufactured by ADEKA Corporation). In addition, as the anti-coloring agent, compounds described in paragraphs 0211 to 0223 of JP2015-034961 can also be used.

A content of the anti-coloring agent in the total solid content of the photosensitive composition is preferably 0.01 to 20% by mass, more preferably 0.1 to 15% by mass, and still more preferably 0.3 to 5% by mass. As the anti-coloring agent, one kind may be used alone, or two or more kinds may be used in combination. In a case where two or more kinds thereof are used in combination, it is preferable that the total content of the two or more kinds thereof is within the above-described range.

<<Ultraviolet absorber>>

The photosensitive composition according to the embodiment of the present invention can contain an ultraviolet absorber. Examples of the ultraviolet absorber, include a conjugated diene compound, an aminobutadiene compound, a methyldibenzoyl compound, a coumarin compound, a salicylate compound, a benzophenone compound, a benzotriazole compound, an acrylonitrile compound, and a hydroxyphenyltriazine compound. Specific examples of such a compound include compounds described in paragraphs 0038 to 0052 of JP2009-217221A, paragraphs 0052 to 0072 of JP2012-208374A, paragraphs 0317 to 0334 of JP2013-068814A, paragraphs 0061 to 0080 of JP2016-162946A, and paragraph 0022 to 0024 of WO2021/132247A, the contents of which are incorporated herein by reference. Examples of a commercially available product of the ultraviolet absorber include UV-503 (manufactured by Daito Chemical Co., Ltd.), Tinuvin series and Uvinul series manufactured by BASF SE, and Sumisorb series manufactured by Sumika Chemtex Co., Ltd. In addition, examples of the benzotriazole compound include MYUA series manufactured by Miyoshi Oil & Fat Co., Ltd. (The Chemical Daily, February 1, 2016). In addition, as the ultraviolet absorber, compounds described in paragraphs 0049 to 0059 of JP6268967B, compounds described in paragraphs 0059 to 0076 of WO2016/181987A, and thioaryl group-substituted benzotriazole type ultraviolet absorbers described in WO2020/137819A can also be used.

The maximal absorption wavelength of the ultraviolet absorber is preferably present in a wavelength range of 200 to 340 nm, more preferably present in a wavelength range of 210 to 320 nm, and still more preferably present in a wavelength range of 220 to 300 nm.

A content of the ultraviolet absorber in the total solid content of the photosensitive composition is preferably 0.1 to 10% by mass, more preferably 0.1 to 7% by mass, still more preferably 0.1 to 5% by mass, and particularly preferably 0.1 to 3% by mass. As the ultraviolet absorber, one kind may be used alone, or two or more kinds may be used in combination. In a case where two or more kinds thereof are used in combination, it is preferable that the total content of the two or more kinds thereof is within the above-described range.

It is also preferable that the photosensitive composition according to the embodiment of the present invention substantially does not include an ultraviolet absorber. In the present specification, the phrase "does not substantially contain an ultraviolet absorber" means that the content of the ultraviolet absorber in the total solid content of the photosensitive composition is 0.05% by mass or less, preferably 0.01% by mass or less, and it is more preferable that the ultraviolet absorber is not contained.

<<Silane coupling agent>>

The photosensitive composition according to the embodiment of the present invention can contain a silane coupling agent. In the present specification, the silane coupling agent refers to a silane compound having a functional group other than a hydrolyzable group. In addition, the hydrolyzable group refers to a substituent directly linked to a silicon atom and capable of forming a siloxane bond due to at least one of a hydrolysis reaction or a condensation reaction. Examples of the hydrolyzable group include a halogen atom, an alkoxy group, and an acyloxy group, and an alkoxy group is preferable. That is, it is preferable that the silane coupling agent is a compound having an alkoxysilyl group. Examples of the functional group other than a hydrolyzable group include a vinyl group, a (meth)allyl group, a (meth)acryloyl group, a (meth)acryloyloxy group, a mercapto group, an epoxy group, an oxetanyl group, an amino group, an ureido group, a sulfide group, an isocyanate group, and a phenyl group. Among these, an amino group, a (meth)acryloyl group, a (meth) acryloyloxy group, or an epoxy group is preferable. Specific examples of the silane coupling agent include the compounds described in paragraph 0177 of WO2022/085485A.

A content of the silane coupling agent in the total solid content of the photosensitive composition is preferably 0.01 to 10% by mass, more preferably 0.1 to 7% by mass, and still more preferably 1 to 5% by mass. As the silane coupling agent, one kind may be used alone, or two or more kinds may be used in combination. In a case where two or more kinds thereof are used in combination, it is preferable that the total content of the two or more kinds thereof is within the above-described range.

<<Polymerization inhibitor>>

The photosensitive composition according to the embodiment of the present invention can contain a polymerization inhibitor. Examples of the polymerization inhibitor include hydroquinone, p-methoxyphenol, di-tert-butyl-p-cresol, pyrogallol, tert-butyl catechol, 1,4-benzoquinone, 4,4'-thiobis(3-methyl-6-tert-butylphenol), 2,2'-methylenebis(4-methyl-6-t-butylphenol), and an N-nitrosophenylhydroxylamine salt (an ammonium salt, a cerous salt, or the like), and p-methoxyphenol is preferable. A content of the polymerization inhibitor in the total solid content of the photosensitive composition is preferably 0.0001 to 5% by mass, and more preferably 0.0001 to 1% by mass.

<<Chain transfer agent>>

The photosensitive composition according to the embodiment of the present invention can contain a chain transfer agent. As the chain transfer agent, the compound described in paragraph 0225 of WO2017/159190A can be used. A content of the chain transfer agent in the total solid content of the photosensitive composition is preferably 0.2% to 5.0% by mass and more preferably 0.4% to 3.0% by mass. In addition, the content of the chain transfer agent is preferably 1 to 40 parts by mass and more preferably 2 to 20 parts by mass with respect to 100 parts by mass of the polymerizable monomer. As the chain transfer agent, one kind may be used alone, or two or more kinds may be used in combination. In a case where two or more kinds thereof are used in combination, it is preferable that the total content of the two or more kinds thereof is within the above-described range.

<<Sensitizer>>

The photosensitive composition according to the embodiment of the present invention can further contain a sensitizer. It is preferable that the sensitizer is a compound sensitizing the photopolymerization initiator by an electron migration mechanism or an energy-transfer mechanism. Examples of the sensitizer include a compound having an absorption in a range of 300 to 450 nm. With regard to the sensitizer, the details can be found in the description of paragraphs 0231 to 0253 of JP2010-106268A (corresponding to paragraphs 0256 to 0273 of US2011/0124824A), the content of which is incorporated herein by reference. A content of the sensitizer in the total solid content of the photosensitive composition is preferably 0.1 to 20% by mass, and more preferably 0.5 to 15% by mass. As the sensitizer, one kind may be used alone, or two or more kinds may be used in combination. In a case where two or more kinds thereof are used in combination, it is preferable that the total content of the two or more kinds thereof is within the above-described range.

<<Co-sensitizer>>

The photosensitive composition according to the embodiment of the present invention can further contain a co-sensitizer. It is preferable that the co-sensitizer is a compound which has a function of further improving sensitivity of the photopolymerization initiator or the sensitizer to radioactive ray, or of suppressing inhibition of polymerization of the polymerizable monomer due to oxygen. With regard to the co-sensitizer, the details can be found in the description of paragraphs 0254 to 0257 of JP2010-106268A (corresponding to paragraphs 0277 to 0279 of US2011/0124824A), the content of which is incorporated herein by reference. A content of the co-sensitizer in the total solid content of the photosensitive composition is preferably 0.1% to 30% by mass, more preferably 1% to 25% by mass, and still more preferably 1.5% to 20% by mass. As the co-sensitizer, one kind may be used alone, or two or more kinds may be used in combination. In a case where two or more kinds thereof are used in combination, it is preferable that the total content of the two or more kinds thereof is within the above-described range.

<<Surfactant>>

The photosensitive composition according to the embodiment of the present invention can contain a surfactant. As the surfactant, various surfactants such as a fluorine-based surfactant, a nonionic surfactant, a cationic surfactant, an anionic surfactant, or a silicone-based surfactant can be used. The surfactant is preferably a silicone-based surfactant or a fluorine-based surfactant. With regard to the surfactant, surfactants described in paragraph Nos. 0238 to 0245 of WO2015/166779A can be referred to, the contents of which are incorporated herein by reference.
As the fluorine-based surfactant, the compounds described in paragraphs 0167 to 0173 of WO2022/085485A can be used.
Examples of the nonionic surfactant include the compounds described in paragraph 0174 of WO2022/085485A.

Examples of the silicone-based surfactant include DOWSIL SH8400, SH 8400 FLUID, FZ-2122, 67 Additive, 74 Additive, M Additive, and SF 8419 OIL (all of which are manufactured by Dow·TORAY); TSF-4300, TSF-4445, TSF-4460, and TSF-4452 (all of which are manufactured by Momentive Performance Materials Inc.); KP-341, KF-6000, KF-6001, KF-6002, and KF-6003 (all of which are manufactured by Shin-Etsu Chemical Co., Ltd.); and BYK-307, BYK-322, BYK-323, BYK-330, BYK-333, BYK-3760, and BYK-UV3510 (all of which are manufactured by BYK-Chemie).

As the silicone-based surfactant, a compound having the following structure can also be used.

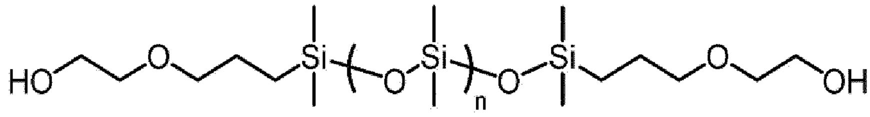

A content of the surfactant in the total solid content of the photosensitive composition is preferably 0.001% to 2.0% by mass and more preferably 0.005% to 1.0% by mass. As the surfactant, one kind may be used alone, or two or more kinds may be used in combination. In a case where two or more kinds thereof are used in combination, it is preferable that the total content of the two or more kinds thereof is within the above-described range.

<<Other additives>>

The photosensitive composition according to the embodiment of the present invention can contain known additives such as a plasticizer and an oil sensitizer. Examples of the plasticizer include dioctyl phthalate, didodecyl phthalate, triethylene glycol dicaprylate, dimethyl glycol phthalate, tricresyl phosphate, dioctyl adipate, dibutyl sebacate, and triacetyl glycerin.

<Storage container>

A storage container of the photosensitive composition according to the embodiment of the present invention is not particularly limited, and a known storage container can be used. In addition, as the storage container, the container described in paragraph 0187 of WO2022/085485A can be used.

<Method for preparing photosensitive composition>

The photosensitive composition according to the embodiment of the present invention can be prepared by mixing the above-described components with each other. During the preparation of the photosensitive composition, the respective components may be mixed with each other collectively, or may be mixed with each other sequentially after at least dissolved or dispersed in a solvent. In addition, during mixing, the order of addition or working conditions are not particularly limited.

It is preferable that a process of dispersing the particles is provided in order to prepare the photosensitive composition. Examples of a mechanical force used for dispersing the particles in the process of dispersing the particles include compression, squeezing, impact, shearing, and cavitation. Specific examples of these processes include a beads mill, a sand mill, a roll mill, a ball mill, a paint shaker, a microfluidizer, a high-speed impeller, a sand grinder, a flow jet mixer, high-pressure wet atomization, and ultrasonic dispersion. In addition, in the pulverization of the particles in a sand mill (beads mill), it is preferable to perform treatment under the condition for increasing a pulverization efficiency by using beads having small diameters; increasing the filling rate of the beads; or the like. Incidentally, it is preferable to remove coarse particles by filtration, centrifugation, or the like after the pulverization treatment. In addition, as the process and the dispersing machine for dispersing the particles, the process and the dispersing machine described in "Dispersion Technology Comprehension, published by Johokiko Co., Ltd., July 15, 2005", "Actual comprehensive data collection on dispersion technology and industrial application centered on suspension (solid/liquid dispersion system), published by Publication Department, Management Development Center, October 10, 1978", and paragraph 0022 of JP2015-157893A can be suitably used. In addition, in the process of dispersing the particles, the particles may be miniaturized in a salt milling step. A material, a device, process conditions, and the like used in the salt milling step can be found in, for example, JP2015-194521A and JP2012-046629A.

It is preferable that, in the preparation of the photosensitive composition, the photosensitive coloring composition is filtered through a filter for the purpose of removing foreign matters, reducing defects, or the like. As the filter, any filter which is used in the related art for filtering or the like can be used without any particular limitation. Examples of a material of the filter include: a fluororesin such as polytetrafluoroethylene (PTFE); a polyamide resin such as nylon (for example, nylon-6 or nylon-6,6); and a polyolefin resin (including a polyolefin resin having a high density and an ultrahigh molecular weight) such as polyethylene or polypropylene (PP). Among these materials, polypropylene (including high-density

polypropylene) or nylon is preferable.

The pore size of the filter is preferably 0.01 to 10.0 μm, more preferably 0.05 to 3.0 μm, and still more preferably about 0.1 to 2.0 μm. With regard to the pore size value of the filter, reference can be made to a nominal value of filter manufacturers. As the filter, various filters provided by Nihon Pall Corporation (DFA4201NIEY and the like), Toyo Roshi Kaisha., Ltd., Nihon Entegris K.K. (formerly Nippon Microlith Co., Ltd.), Kitz Micro Filter Corporation, and the like can be used.

It is preferable that a fibrous filter material is used as the filter. Examples of the fibrous filter material include polypropylene fiber, nylon fiber, and glass fiber. Examples of a commercially available product include SBP type series (SBP008 and the like), TPR type series (TPR002, TPR005, and the like), or SHPX type series (SHPX003 and the like), all manufactured by Roki Techno Co., Ltd.

In a case where a filter is used, a combination of different filters (for example, a first filter and a second filter) may be used. In this case, the filtering using each of the filters may be performed once, or twice or more. In addition, a combination of filters having different pore sizes in the above-described range may be used. In addition, the filtering using the first filter may be performed only on the dispersion liquid, and the filtering using the second filter may be performed on a mixture of the dispersion liquid and other components.

<Film>

The film according to the embodiment of the present invention is a film formed of the above-described photosensitive composition according to the embodiment of the present invention.

The maximum value of transmittance of the film according to the embodiment of the present invention with respect to light in a wavelength range of 400 to 700 nm is preferably 80% or less, more preferably 70% or less, still more preferably 60% or less, and particularly preferably 50% or less. The lower limit of the maximum value of the above-described transmittance is preferably 1% or more, more preferably 5% or more, still more preferably 10% or more, even more preferably 15% or more, and particularly preferably 20% or more.

The transmittance of the film according to the embodiment of the present invention with respect to light having a wavelength of 365 nm is preferably 15% or more, more preferably 25% or more, still more preferably 35% or more, and particularly preferably 45% or more.

The maximum value of transmittance of the film according to the embodiment of the present invention with respect to light in a wavelength range of 400 to 700 nm is preferably 90% or less, more preferably 85% or less, still more preferably 80% or less, even more preferably 75% or less, and particularly preferably 70% or less. The lower limit of the maximum value of the above-described transmittance is preferably 15% or more, more preferably 20% or more, still more preferably 30% or more, even more preferably 40% or more, and particularly preferably 45% or more.

The maximum value of transmittance of the film according to the embodiment of the present invention with respect to light in a wavelength range of 400 to 1000 nm is preferably 90% or less, more preferably 85% or less, still more preferably 80% or less, even more preferably 75% or less, and particularly preferably 70% or less. The lower limit of the maximum value of the above-described transmittance is preferably 20% or more, more preferably 25% or more, still more preferably 35% or more, even more preferably 45% or more, and particularly preferably 50% or more.

From the viewpoint of light scattering properties, it is preferable that a phase-separated structure of a first phase containing the above-described particles A and a second phase having a lower content of the particles A than that of the first phase is formed in the film according to the embodiment of the present invention. In addition, the above-described phase-separated structure is preferably a sea-island structure or a co-continuous phase structure. By forming these phase-separated structures, light can be effectively scattered between the first phase and the second phase, and particularly excellent light scattering properties can be easily obtained. In the sea-island structure, the second phase may form the sea and the first phase may form the island, or the first phase may form the sea and the second phase may form the island. The case where the first phase forms the sea and the second phase forms the island is preferable from the viewpoint of transmittance. The case where the first phase forms the island and the second phase forms the sea is preferable from the viewpoint of angle dependence.

A haze of the film according to the embodiment of the present invention based on JIS K 7136 is preferably 30% to 100%. The upper limit is preferably 99% or less, more preferably 95% or less, and still more preferably 90% or less. The lower limit is preferably 35% or more, more preferably 40% or more, and still more preferably 50% or more. In a case where the haze of the film is within the above-described range, a sufficient light scattering ability can be obtained while securing a sufficient light transmission amount.

The value of L* of the film according to the embodiment of the present invention in the L*a*b* color system of CIE 1976 is preferably 35 to 100. The value of L* is preferably 40 or higher, more preferably 50 or higher, and still more preferably 60 or higher. According to this aspect, a film having excellent whiteness can be formed. In addition, the value of L* is preferably 95 or lower, more preferably 90 or lower, and still more preferably 85 or lower. According to this aspect, a film having appropriate visible transparency can be used.

The value of a* is preferably -15 or more, more preferably -10 or more, and still more preferably -5 or more. In addition, the value of a* is preferably 10 or lower, more preferably 5 or lower, and still more preferably 0 or lower. According to this aspect, a film having excellent whiteness can be formed.

The value of b* is preferably -35 or more, more preferably -30 or more, and still more preferably -25 or more. In addition, the value of b* is preferably 20 or lower, more preferably 10 or lower, and still more preferably 0 or lower. According to this aspect, a film having excellent whiteness can be formed.

A thickness of the film according to the embodiment of the present invention is preferably 1 to 50 μm. The upper limit of the film thickness is preferably 40 μm or less, more preferably 35 μm or less, and still more preferably 30 μm or less. The lower limit of the film thickness is preferably 1 μm or more, more preferably 2 μm or more, and still more preferably 3 μm or more. In a case where the film thickness is within the above-described range, a sufficient light scattering ability can be obtained. Furthermore, an effect of improving a device optical sensitivity by reducing the thickness of a sensor and suppressing crosstalk can also be expected.

The film according to the embodiment of the present invention has high light scattering properties, and is preferably used as a light scattering film. For example, the film according to the embodiment of the present invention can be suitably used for a scattering layer for a light emitting element, a scattering layer for a display element, a scattering layer for an ambient optical sensor, and the like.

The film according to the embodiment of the present invention can also be suitably used for a head-mounted display. The head-mounted display includes a display element, an eyepiece unit, a light source, a projection unit, and the like, and can be used at any position inside, between, and among them. Examples of the head-mounted display include head-mounted displays described in JP2019-061199A, JP2021-032975A, JP2019-032434A, JP2018-018077A, JP2016-139112A, US2021/0063745A, CN112394509B, US10921499B, KR10-2018-0061467A, JP2018-101034A, JP2020-101671A, TW2020-28805A, and the like.

<Method for manufacturing film>

The film according to the embodiment of the present invention can be formed through a step of applying the photosensitive composition according to the embodiment of the present invention to a support. The method of producing the film may further include a step of forming a pattern. Examples of the pattern forming method include a pattern forming method using a photolithography method.

It is preferable that the pattern forming method using a photolithography method includes: a step (exposure step) of exposing the composition layer, which is formed by applying the photosensitive composition according to the embodiment of the present invention onto the support, in a patterned manner; and a step (development step) of forming a pattern by removing a non-exposed portion of the composition layer for development. Optionally, the pattern forming method may further include a step (post-baking step) of baking the developed pattern. Hereinafter, the respective steps will be described.

The support to which the photosensitive composition is applied is not particularly limited. A substrate formed of a material such as silicon, non-alkali glass, soda glass, PYREX (registered trade name) glass, or quartz glass is shown as an example. For example, an organic film or an inorganic film may be formed on the substrate. Examples of a material of the organic film include a resin. In addition, as the support, a substrate formed of the resin can also be used. In addition, a charge coupled device (CCD), a complementary metal-oxide semiconductor (CMOS), a transparent conductive film, or the like may be formed on the support. In addition, a black matrix that separates pixels from each other may be formed on the support. In addition, optionally, an undercoat layer may be provided on the support to improve adhesiveness with a layer above the support, to prevent diffusion of materials, or to make a surface of the substrate flat. In addition, in a case where a glass substrate is used as the support, it is preferable that an inorganic film is formed on the glass substrate or the glass substrate may be dealkalized to be used.

As a method of applying the photosensitive composition to the support, a well-known method can be used. Examples thereof include a dropping method (drop casting); a slit coating method; a spray method; a roll coating method; a spin coating method (spin coating); a cast coating method; a slit and spin method; a pre-wet method (for example, a method described in JP2009-145395A), various printing methods such as an ink jet (for example, on-demand type, piezo type, thermal type), a discharge printing such as nozzle jet, a flexo printing, a screen printing, a gravure printing, a reverse offset printing, and a metal mask printing; a transfer method using molds and the like; and a nanoimprinting method. The application method using an ink jet method is not particularly limited, and examples thereof include a method (in particular, pp. 115 to 133) described in "Extension of Use of Ink Jet - Infinite Possibilities in Patent-" (February, 2005, S.B.Research Co., Ltd.) and methods described in JP2003-262716A, JP2003-185831A, JP2003-261827A, JP2012-126830A, and JP2006-169325A. From the viewpoint of suitability for application, the application using a spin coating method is preferably spin coating at 300 to 6000 rpm and more preferably spin coating at 400 to 3000 rpm. In addition, the temperature of the support during spin coating is preferably 10°C to 100°C and more preferably 20°C to 70°C. In a case where the temperature of the support is in the above-described range, a film having excellent application uniformity is likely

to be formed. In a case where the drop casting method is used, it is preferable that a drop range of the photosensitive composition in which a photoresist is used as a partition wall is formed on the support such that a film having a predetermined uniform film thickness can be obtained. A desired film thickness can be obtained by controlling the drop amount and concentration of solid contents of the photosensitive composition and the area of the drop range.

The composition layer formed on the support may be dried (pre-baked). For example, it is preferable that the dry is performed under pre-baking conditions of a temperature of 60°C to 150°C and 30 seconds to 15 minutes.

In the exposure step, the composition layer is exposed in a patterned manner. For example, the composition layer can be exposed in a pattern shape using an exposure device such as a stepper through a mask having a predetermined mask pattern. Thus, the exposed portion can be cured. Examples of the radiation (light) which can be used during the exposure include g-rays and i-rays. In addition, light (preferably light having a wavelength of 180 to 300 nm) having a wavelength of 300 nm or less can also be used. Examples of the light having a wavelength of 300 nm or less include KrF-rays (wavelength: 248 nm) and ArF-rays (wavelength: 193 nm), and KrF-rays (wavelength: 248 nm) are preferable.

In a case of exposure, the composition layer may be irradiated with light continuously to expose the composition layer, or the composition layer may be irradiated with light in a pulse to expose the composition layer (pulse exposure). The pulse exposure refers to an exposing method in which light irradiation and resting are repeatedly performed in a short cycle (for example, millisecond-level or less). In a case of the pulse exposure, the pulse width is preferably 100 nanoseconds (ns) or less, more preferably 50 nanoseconds or less, and still more preferably 30 nanoseconds or less. The lower limit of the pulse width is not particularly limited, and can be 1 femtosecond (fs) or more or 10 femtoseconds or more. The frequency is preferably 1 kHz or more, more preferably 2 kHz or more, and still more preferably 4 kHz or more. The upper limit of the frequency is preferably 50 kHz or less, more preferably 20 kHz or less, and still more preferably 10 kHz or less. The maximum instantaneous illuminance is preferably 50,000,000 $W/m^2$ or more, more preferably 100,000,000 $W/m^2$ or more, and still more preferably 200,000,000 $W/m^2$ or more. The upper limit of the maximum instantaneous illuminance is preferably 1,000,000,000 $W/m^2$ or less, more preferably 800,000,000 $W/m^2$ or less, and still more preferably 500,000,000 $W/m^2$ or less. Furthermore, the pulse width is a time during which light is radiated in the pulse period. The frequency is the number of pulse periods per second. The maximum instantaneous illuminance is average illuminance within the time during which light is radiated in the pulse period. The pulse period is a period in which irradiation with light and resting are one cycle in the pulse exposure.

The irradiation dose (exposure dose) is preferably 0.03 to 2.5 $J/cm^2$, more preferably 0.05 to 1.0 $J/cm^2$, and still more preferably 0.08 to 0.5 $J/cm^2$. The oxygen concentration in a case of the exposure can be appropriately selected. For example, the exposure may be performed in air, in a low-oxygen atmosphere having an oxygen concentration of 19 vol% or less (for example, 15 vol%, 5 vol%, or substantially oxygen-free), or in a high-oxygen atmosphere having an oxygen concentration of more than 21 vol% (for example, 22 vol%, 30 vol%, or 50 vol%). In addition, the exposure illuminance can be appropriately set, and is preferably selected in a range of 1,000 to 100,000 $W/m^2$. Appropriate conditions of each of the oxygen concentration and the exposure illuminance may be combined, and for example, a combination of the oxygen concentration of 10% by volume and the illuminance of 10,000 $W/m^2$, a combination of the oxygen concentration of 35% by volume and the illuminance of 20,000 $W/m^2$, or the like is available.

<<Development step>>

Next, a pattern is formed by removing a non-exposed portion of the exposed composition layer by development. The non-exposed portion of the composition layer can be removed by development using a developer. As a result, a non-exposed portion of the composition layer in the exposure step is eluted into the developer, and only the photocured portion remains on the support. The temperature of the developer is preferably, for example, 20°C to 30°C. The development time is preferably 20 to 180 seconds. In addition, in order to further improve residues removing properties, a step of shaking the developer off per 60 seconds and supplying a new developer may be repeated multiple times.

Examples of the developer include an organic solvent and an alkali developer, and an alkali developer is preferably used. As the alkali developer, an alkaline aqueous solution (alkali developer) in which an alkaline agent is diluted with pure water is preferable. Examples of the alkaline agent include organic alkaline compounds such as ammonia, ethylamine, diethylamine, dimethylethanolamine, diglycol amine, diethanolamine, hydroxyamine, ethylenediamine, tetramethylammonium hydroxide, tetraethylammonium hydroxide, tetrapropylammonium hydroxide, tetrabutylammonium hydroxide, ethyltrimethylammonium hydroxide, benzyltrimethylammonium hydroxide, dimethylbis(2-hydroxyethyl)ammonium hydroxide, choline, pyrrole, piperidine, and 1,8-diazabicyclo[5.4.0]-7-undecene, and inorganic alkaline compounds such as sodium hydroxide, potassium hydroxide, sodium carbonate, sodium hydrogen carbonate, sodium silicate, and sodium metasilicate. In consideration of environmental aspects and safety aspects, the alkaline agent is preferably a compound having a high molecular weight. The concentration of the alkaline agent in the alkaline aqueous solution is preferably 0.001% to 10% by mass and more preferably 0.01% to 1% by mass. The developer may contain a surfactant. Examples of the surfactant include the surfactants described above. Among these, a nonionic surfactant is preferable. From the viewpoint of transportation, storage, and the like, the developer may be first produced as a

concentrated solution and then diluted to a concentration required upon the use. The dilution factor is not particularly limited and, for example, can be set to be in a range of 1.5 to 100 times. **In** a case where the alkaline aqueous solution is used as a developer, it is preferable that the layer is washed (rinsed) with pure water after development. In addition, it is preferable that the rinsing is performed by supplying a rinsing liquid to the composition layer after development while rotating the support on which the composition layer after development is formed. In addition, it is preferable that the rinsing is performed by moving a nozzle discharging the rinsing liquid from a center of the support to a peripheral edge of the support. In this case, in the movement of the nozzle from the center of the support to the peripheral edge of the support, the nozzle may be moved while gradually decreasing the moving speed of the nozzle. By performing rinsing in this manner, in-plane variation of rinsing can be suppressed. In addition, the same effect can be obtained by gradually decreasing the rotating speed of the support while moving the nozzle from the center of the support to the peripheral edge of the support.

After the development, it is preferable to carry out an additional exposure treatment or a heating treatment (post-baking) after carrying out drying. The additional exposure treatment or the post-baking is a curing treatment after development in order to complete curing. The heating temperature in the post-baking is preferably, for example, 100°C to 260°C. The lower limit of the heating temperature is preferably 120°C or higher and more preferably 160°C or higher. The upper limit of the heating temperature is preferably 240°C or lower and more preferably 220°C or lower. The film after development is post-baked continuously or batchwise using a heating unit such as a hot plate, a convection oven (hot air circulation dryer), and a high-frequency heater under the above-described conditions. In a case of performing the additional exposure treatment, light used for the exposure is preferably light having a wavelength of 400 nm or less. In addition, the additional exposure treatment may be carried out by the method described in KR10-2017-0122130A.

<Optical sensor>

The optical sensor according to the embodiment of the present invention includes the film according to the embodiment of the present invention. Examples of the type of the optical sensor include an ambient optical sensor and an illuminance sensor, and the optical sensor is preferably used as an ambient optical sensor. The ambient optical sensor is a sensor which detects hue of ambient light.

It is also preferable that the optical sensor according to the embodiment of the present invention has an optical filter having at least one pixel selected from a colored pixel or a pixel of an infrared transmitting filter, in addition to the film according to the embodiment of the present invention. Examples of the colored pixel include a red pixel, a blue pixel, a green pixel, a yellow pixel, a cyan pixel, and a magenta pixel. In addition, it is preferable that the film according to the embodiment of the present invention is provided closer to a light incident side than the above-described optical filter. By providing the film according to the embodiment of the present invention closer to the light incident side than the optical filter, angle dependence can be further reduced for each pixel.

An embodiment of the optical sensor is shown with reference to the drawings. An optical sensor 1 shown in Fig. 1 is provided with an optical filter 110 having pixels 111 to 114 on a photoelectric conversion element 101. A film 121 according to the embodiment of the present invention is formed on the optical filter 110. As an example of the pixels 111 to 114 constituting the optical filter 110, a combination in which the pixel 111 is a red pixel, the pixel 112 is a blue pixel, the pixel 113 is a green pixel, and the pixel 114 is a pixel of an infrared transmitting filter can be mentioned. In the optical sensor 1 shown in Fig. 1, the optical filter 110 having four types of pixels (pixels 111 to 114) is used, but the types of pixels may be one to three types or may be five or more types. The types can be appropriately selected according to the application. In addition, a planarizing layer may be interposed between the photoelectric conversion element 101 and the optical filter 110, or between the optical filter 110 and the film 121 according to the embodiment of the present invention.

Fig. 2 shows another embodiment of the optical sensor. An optical sensor 2 shown in Fig. 2 is provided with an optical filter 110 having pixels 111 to 114 on a photoelectric conversion element 101. The optical filter 110 has the same configuration as that of the above-described embodiment. A member in which a film 122 according to the embodiment of the present invention is formed on a surface of a transparent support 130 is disposed on the optical filter 110. Examples of the transparent support 130 include a glass substrate and a resin substrate. In the optical sensor 2 shown in Fig. 2, the member in which the film 122 according to the embodiment of the present invention is formed on the surface of the transparent support 130 is disposed on the optical filter 110 at predetermined intervals, but the optical filter 110 and the member in which the film 122 according to the embodiment of the present invention is formed on the surface of the transparent support 130 may be in contact with each other. In addition, in the optical sensor 2 shown in Fig. 2, the film 122 according to the embodiment of the present invention is formed on only one surface of the transparent support 130, but the film 122 according to the embodiment of the present invention may be formed on both surfaces of the transparent support 130. In addition, in the optical sensor 2 shown in Fig. 2, the film 122 according to the embodiment of the present invention is formed on the surface of the transparent support 130 on the optical filter 110 side, but the film 122 according to the embodiment of the present invention may be formed on the surface of the transparent support 130 opposite to the optical filter 110 side. In addition, a planarizing layer may be interposed between the photoelectric conversion element 101 and the optical filter 110, or between the film 122 according to the embodiment of the present invention and the transparent support

130.

Examples

Hereinafter, the present invention will be described in more detail using Examples, but the present invention is not limited to these examples.

<Measurement of average primary particle diameter of particles>

The primary particle diameter of the particles was obtained by observing particles with a transmission electron microscope (TEM) and observing a portion (primary particle) where the particles did not aggregate. Specifically, a particle size distribution was obtained by imaging a transmission electron micrograph of primary particles using a transmission microscope and measuring a particle size distribution with an image processing device using the micrograph. The average primary particle diameter of the particles refers to the number average particle size calculated from the particle size distribution. An electron microscope (H-7000, manufactured by Hitachi, Ltd.) was used as the transmission electron microscope, and a LUZEX AP (manufactured by Nireco Corporation) was used as the image processing device.

<Measurement of crystal system of particles>

Using an X-ray diffractometer (RINT-TTR III manufactured by Rigaku Corporation), a crystal system of the particles was measured by filling a dedicated glass holder with the particles and applying a voltage-current of 50 kV-300 mA, and performing measurement under conditions of a sampling angle of 0.02° and a scanning speed of 5.0°/min with CuK$\alpha$ rays generated by the application.

<Measurement of weight-average molecular weight of resin>

The weight-average molecular weight of a resin was measured by gel permeation chromatography (GPC) according to the following conditions.
Type of column: a column in which TOSOH TSK gel Super HZM-H, TOSOH TSK gel Super HZ4000, and TOSOH TSK gel Super HZ2000 were linked to each other

Developing solvent: tetrahydrofuran
Column temperature: 40°C
Flow rate (sample injection volume): 1.0 $\mu$L (sample concentration: 0.1% by mass)
Device name: HLC-8220 GPC (manufactured by Tosoh Corporation)
Detector: refractive index (RI) detector
Calibration curve base resin: a polystyrene resin

<Measurement of acid value of resin>

The acid value represents a mass of potassium hydroxide required to neutralize acidic components per 1 g of solid content of the resin. A measurement sample was dissolved in a mixed solvent including tetrahydrofuran and water at a ratio (tetrahydrofuran/water) of 9/1, and the obtained solution was neutralized and titrated with a 0.1 mol/L sodium hydroxide aqueous solution at 25°C using a potentiometric titrator (trade name: AT-510, manufactured by Kyoto Electronics Manufacturing Co., Ltd.). An inflection point of a titration pH curve was set as a titration end point, and the acid value was calculated from the following expression.

$$A = 56.11 \times Vs \times 0.5 \times f/w$$

A: acid value (mgKOH/g)
Vs: amount (mL) of the 0.1 mol/L sodium hydroxide aqueous solution used for the titration
f: titer of the 0.1 mol/L sodium hydroxide aqueous solution
w: mass (g) of the measurement sample (expressed in terms of solid contents)

<Measurement of base number of resin>

The base number represents the mass of potassium hydroxide equivalent that of hydrochloric acid required to

neutralize a basic component per 1 g of solid content of the resin. A measurement sample was dissolved in a mixed solvent including tetrahydrofuran and water at a ratio (tetrahydrofuran/water) of 9/1, and the obtained solution was neutralized and titrated with a 0.1 mol/L hydrochloric acid at 25°C using a potentiometric titrator (trade name: AT-510, manufactured by Kyoto Electronics Manufacturing Co., Ltd.). An inflection point of a titration pH curve was set as a titration end point, and the base number was calculated from the following expression.

$$A=56.11 \times Vs \times 0.5 \times f/w$$

A: base number (mgKOH/g)
Vs: amount (mL) of 0.1 mol/L hydrochloric acid used for titration
f: 0.1 mol/L hydrochloric acid titer
w: mass (g) of the measurement sample (expressed in terms of solid contents)

<Synthesis of particles>

(Synthesis Example 1) Synthesis of particles P1

300 g of water was measured in a glass container 1, 30.8 g of 60% nitric acid (manufactured by FUJIFILM Wako Pure Chemical Corporation) and 14.9 g of $Gd_2O_3$ (manufactured by Japan Yttrium Co., Ltd.) as a rare earth oxide were added thereto, and the mixture was heated to 80°C to be dissolved.

300 g of water and 9.4 g of 85% phosphoric acid (manufactured by FUJIFILM Wako Pure Chemical Corporation) were added to another glass container 2.

After adding the contents of the glass container 2 to the glass container 1, aging was carried out at 75°C for 30 minutes. The obtained precipitate was washed by decantation washing until the conductivity of the supernatant was 200 μS/cm or less. After washing, solid-liquid separation was carried out by decompression filtration, drying was carried out in the atmosphere at 120°C × 5 hours, and baking was carried out in the atmosphere at 600°C × 5 hours to obtain particles P1. In a case where a crystal system of the particles P1 was measured using an X-ray diffractometer, it was confirmed that the particles P1 were monoclinic $GdPO_4$. In addition, the average primary particle diameter of the particles P1 was 127 nm.

(Synthesis Examples 2 to 7) Synthesis of particles P2 to P7

Particles P2 to P7 were synthesized by the same method as that in Synthesis Example 1, except that each of the kind, the addition amount, and the baking temperature of the rare earth oxide was changed as follows. The crystal systems and average primary particle diameters of the particles P2 to P7 are shown in the following table.

[Table 1]

| Name of particle | Rare earth oxide | | Baking temperature [°C] | Synthesized particle | | |
|---|---|---|---|---|---|---|
| | Type | Addition amount [g] | | Type | Average primary particle diameter [nm] | Crystal system |
| P1 | $Gd_2O_3$ | 14.9 | 600 | $GdPO_4$ | 127 | Monoclinic |
| P2 | $Y_2O_3$ | 9.3 | 600 | $YPO_4$ | 81 | Tetragonal |
| P3 | $Lu_2O_3$ | 16.3 | 600 | $LuPO_4$ | 99 | Tetragonal |
| P4 | $Yb_2O_3$ | 16.2 | 600 | $YbPO_4$ | 118 | Tetragonal |
| P5 | $Dy_2O_3$ | 15.3 | 600 | $DyPO_4$ | 135 | Tetragonal |
| P6 | $Gd_2O_3$ | 14.9 | 1200 | $GdPO_4$ | 192 | Monoclinic |
| P7 | $Gd_2O_3$ | 14.9 | 400 | $GdPO_4$ | 38 | Monoclinic |

<Production of dispersion liquid>

By using ULTRA APEX MILL (manufactured by Kotobuki Industries Co., Ltd.) as a circulation type dispersion apparatus (beads mill), a mixed solution having the following composition shown in the following table was dispersed. In this way, a dispersion liquid was produced. Bead diameter: 0.2 mm

Bead filling rate: 65 vol%
Circumferential speed: 6 m/sec
Pump supply rate: 10.8 kg/hr
Cooling water: tap water
Inner volume of circular path of beads mill: 0.15 L
Amount of mixed Solution to be dispersed: 0.65 kg

[Table 2]

| Dispersion liquid | Particle | | Resin (dispersant) | | Additive | | Solvent | |
|---|---|---|---|---|---|---|---|---|
| | Type | Parts by mass | Type | Parts by mass | Type | Parts by mass | Type | Parts by mass |
| DL-1 | P1 | 20.0 | C-001 | 20.0 | - | 0 | S-1 | 60.0 |
| DL-2 | P2 | 20.0 | C-001 | 20.0 | - | 0 | S-1 | 60.0 |
| DL-3 | P3 | 20.0 | C-001 | 20.0 | - | 0 | S-1 | 60.0 |
| DL-4 | P4 | 20.0 | C-001 | 20.0 | - | 0 | S-1 | 60.0 |
| DL-5 | P5 | 20.0 | C-001 | 20.0 | - | 0 | S-1 | 60.0 |
| DL-6 | P6 | 20.0 | C-001 | 20.0 | - | 0 | S-1 | 60.0 |
| DL-7 | P7 | 20.0 | C-001 | 20.0 | - | 0 | S-1 | 60.0 |
| DL-8 | P2 | 20.0 | C-011 | 20.0 | - | 0 | S-1 | 60.0 |
| DL-9 | P2 | 20.0 | C-021 | 20.0 | - | 0 | S-1 | 60.0 |
| DL-10 | P2 | 20.0 | C-031 | 30.0 | - | 0 | S-1 | 50.0 |
| DL-11 | P2 | 20.0 | C-101 | 20.0 | - | 0 | S-1 | 60.0 |
| DL-12 | P2 | 20.0 | C-111 | 20.0 | - | 0 | S-1 | 60.0 |
| DL-13 | P2 | 20.0 | C-201 | 20.0 | - | 0 | S-1 | 60.0 |
| DL-14 | P2 | 20.0 | C-301 | 20.0 | - | 0 | S-1 | 60.0 |
| DL-15 | P2 | 20.0 | C-001/C-011 (mass ratio of 50/50) | 20.0 | - | 0 | S-1 | 60.0 |
| DL-16 | P2 | 20.0 | C-001 | 20.0 | - | 0 | S-2 | 60.0 |
| DL-17 | P2 | 20.0 | C-001 | 20.0 | - | 0 | S-3 | 60.0 |
| DL-18 | P2 | 20.0 | C-001 | 20.0 | - | 0 | S-1/S-2 (mass ratio of 50/50) | 60.0 |
| DL-19 | P2/P3 (mass ratio of 50/50) | 20.0 | C-001 | 20.0 | - | 0 | S-1 | 60.0 |
| DL-20 | P2 | 20.0 | C-401 | 20.0 | - | 0 | S-1 | 60.0 |
| DL-21 | P2 | 20.0 | C-411 | 30.0 | - | 0 | S-1 | 50.0 |
| DL-22 | P2 | 20.0 | C-421 | 17.1 | - | 0 | S-1 | 62.9 |
| DL-23 | P2 | 20.0 | C-431 | 20.0 | - | 0 | S-1 | 60.0 |
| DL-24 | P2 | 20.0 | C-441 | 20.0 | - | 0 | S-1 | 60.0 |
| DL-25 | P2 | 20.0 | C-451 | 17.1 | - | 0 | S-1 | 62.9 |
| DL-26 | P2 | 20.0 | C-501 | 15.0 | - | 0 | S-1 | 65.0 |
| DL-27 | P2 | 20.0 | C-511 | 15.0 | - | 0 | S-1 | 65.0 |

(continued)

| Dispersion liquid | Particle | | Resin (dispersant) | | Additive | | Solvent | |
|---|---|---|---|---|---|---|---|---|
| | Type | Parts by mass | Type | Parts by mass | Type | Parts by mass | Type | Parts by mass |
| DL-28 | P2 | 20.0 | C-401 | 18.9 | Ad-1 | 0.3 | S-1 | 60.7 |
| DL-29 | P2 | 20.0 | C-411 | 28.4 | Ad-1 | 0.3 | S-1 | 51.3 |
| DL-30 | P2 | 20.0 | C-421 | 16.2 | Ad-1 | 0.3 | S-1 | 63.4 |
| DL-31 | P2 | 20.0 | C-431 | 18.9 | Ad-1 | 0.3 | S-1 | 60.7 |
| DL-32 | P2 | 20.0 | C-441 | 18.9 | Ad-1 | 0.3 | S-1 | 60.7 |
| DL-33 | P2 | 20.0 | C-451 | 16.2 | Ad-1 | 0.3 | S-1 | 63.4 |
| DL-34 | P2 | 20.0 | C-501 | 14.2 | Ad-1 | 0.3 | S-1 | 65.5 |
| DL-35 | P1 | 20.0 | C-511 | 14.2 | Ad-1 | 0.3 | S-1 | 65.5 |
| DL-36 | P2 | 20.0 | C-511 | 14.2 | Ad-1 | 0.3 | S-1 | 65.5 |
| DL-37 | P3 | 20.0 | C-511 | 14.2 | Ad-1 | 0.3 | S-1 | 65.5 |
| DL-38 | P4 | 20.0 | C-511 | 14.2 | Ad-1 | 0.3 | S-1 | 65.5 |
| DL-39 | P5 | 20.0 | C-511 | 14.2 | Ad-1 | 0.3 | S-1 | 65.5 |
| DL-40 | P6 | 20.0 | C-511 | 14.2 | Ad-1 | 0.3 | S-1 | 65.5 |

[Table 3]

| Disperson liquid | Particle | | Resin (dispersant) | | Additive | | Solvent | |
|---|---|---|---|---|---|---|---|---|
| | Type | Parts by mass | Type | Parts by mass | Type | Parts by mass | Type | Parts by mass |
| DL-41 | P7 | 20.0 | C-511 | 14.2 | Ad-1 | 0.3 | S-1 | 65.5 |
| DL-42 | P2 | 20.0 | C-511 | 14.8 | Ad-1 | 0.1 | S-1 | 65.1 |
| DL-43 | P2 | 20.0 | C-511 | 14.7 | Ad-1 | 0.1 | S-1 | 65.2 |
| DL-44 | P2 | 20.0 | C-511 | 13.3 | Ad-1 | 0.7 | S-1 | 66.0 |
| DL-45 | P2 | 20.0 | C-511 | 12.4 | Ad-1 | 1.1 | S-1 | 66.6 |
| DL-46 | P2 | 20.0 | C-511 | 14.2 | Ad-2 | 0.3 | S-1 | 65.5 |
| DL-47 | P2 | 20.0 | C-511 | 14.2 | Ad-1/Ad-2 (mass ratio of 95/5) | 0.3 | S-1 | 65.5 |
| DL-48 | P2 | 20.0 | C-501/C-511 (mass ratio of 10/90) | 14.2 | Ad-1 | 0.3 | S-1 | 65.5 |
| DL-49 | P2 | 20.0 | C-511 | 14.2 | Ad-1 | 0.3 | S-2 | 65.5 |
| DL-50 | P2 | 20.0 | C-511 | 14.2 | Ad-1 | 0.3 | S-3 | 65.5 |
| DL-51 | P2 | 20.0 | C-511 | 14.2 | Ad-1 | 0.3 | S-1/S-2 (mass ratio of 50/50) | 65.5 |
| DL-52 | P2/P3 (mass ratio of 50/50) | 20.0 | C-511 | 14.2 | Ad-1 | 0.3 | S-1 | 65.5 |

(continued)

| Disperson liquid | Particle | | Resin (dispersant) | | Additive | | Solvent | |
|---|---|---|---|---|---|---|---|---|
| | Type | Parts by mass | Type | Parts by mass | Type | Parts by mass | Type | Parts by mass |
| DL-S1 | P2 | 20.0 | CC-001 | 20.0 | - | 0 | S-1 | 60.0 |

The raw materials shown above in the table are as follows.

(Particles)

P1 to P7: particles P1 to P7 described above

(Resin (dispersant))

C-001, C-011, C-021, C-031, C-101, C-111, C-201, C-301, C-401, C-411, C-421, C-431, C-441, C-451, C-501, C-511, CC-001: propylene glycol monomethyl ether acetate solution of resin having the following structure

(C-001)

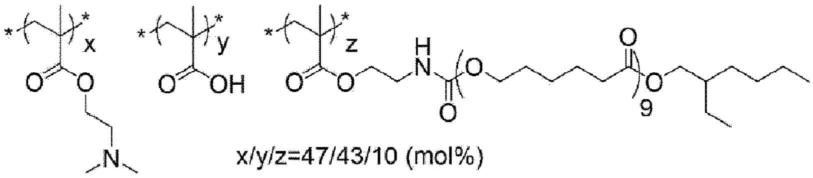

x/y/z=47/43/10 (mol%)

(C-011)

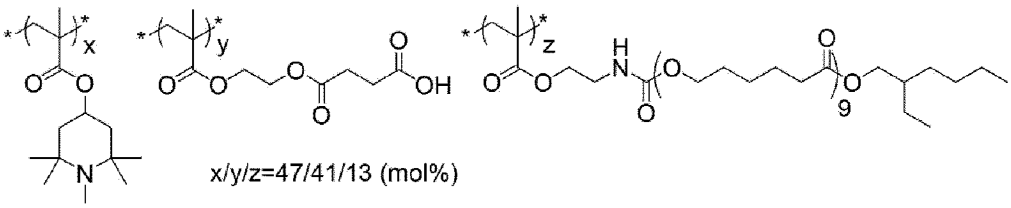

x/y/z=47/41/13 (mol%)

(C-021)

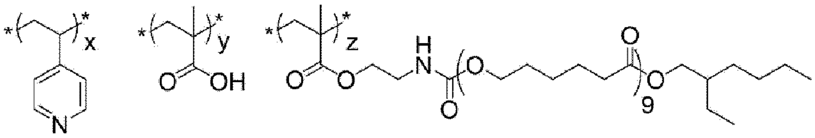

x/y/z=46/42/12 (mol%)

(C-031)

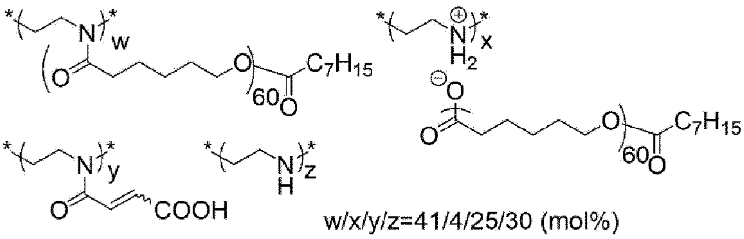

w/x/y/z=41/4/25/30 (mol%)

(C-101)

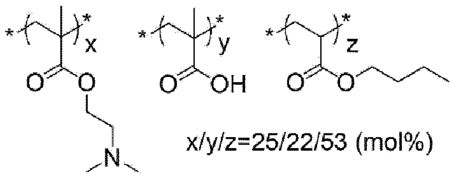

x/y/z=25/22/53 (mol%)

(C-111)

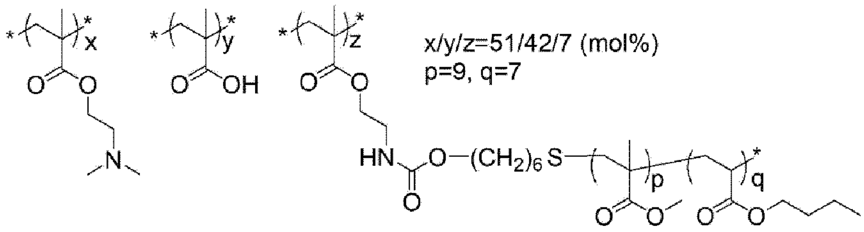

x/y/z=51/42/7 (mol%)
p=9, q=7

(C-201)

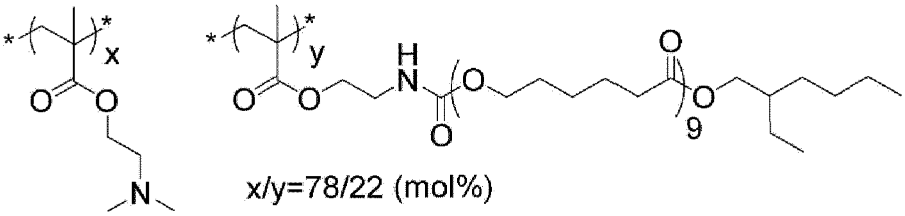

x/y=78/22 (mol%)

(C-301)

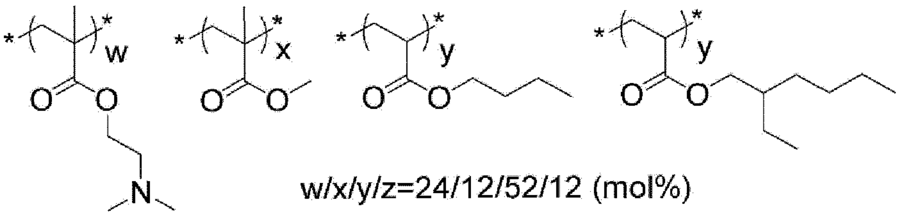

w/x/y/z=24/12/52/12 (mol%)

(C-401)

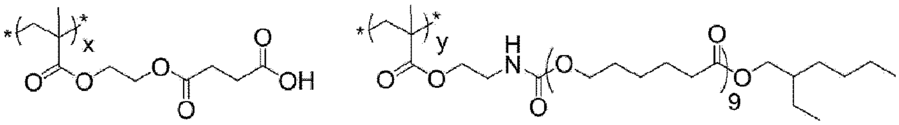

x/y=61/39 (mol%)

(C-411)

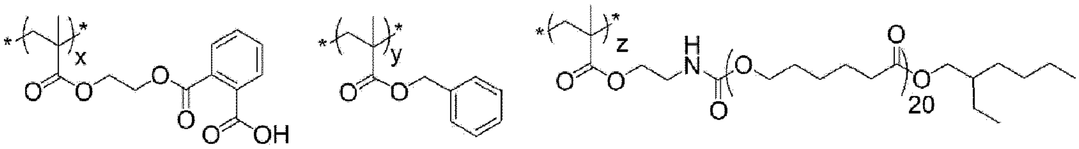

x/y/z=43/49/8 (mol%)

(C-421)

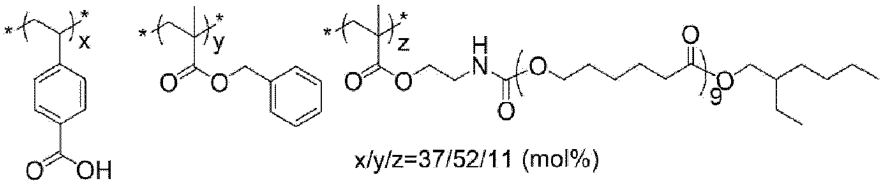

x/y/z=37/52/11 (mol%)

(C-431)

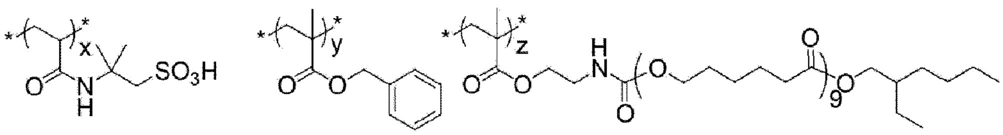

x/y/z=25/65/10 (mol%)

**(C-441)**

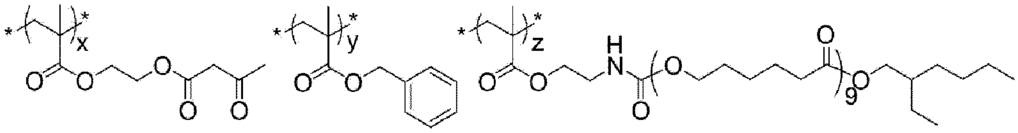

x/y/z=40/48/12 (mol%)

**(C-451)**

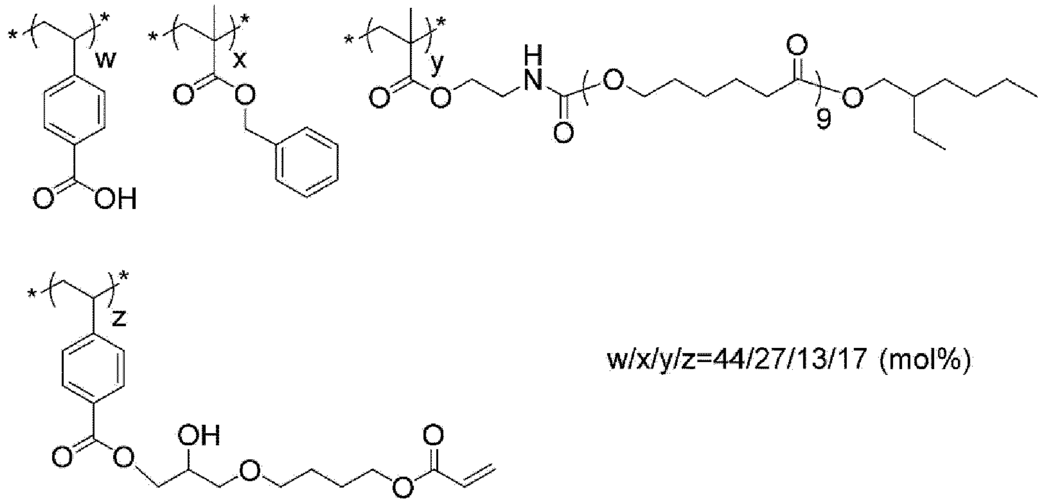

w/x/y/z=44/27/13/17 (mol%)

**(C-501)**

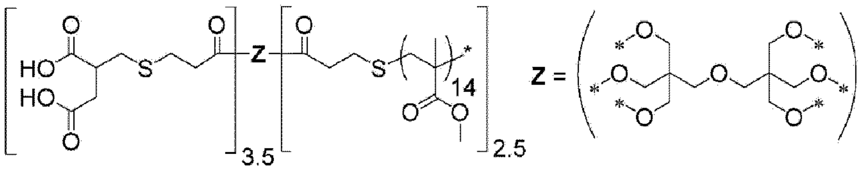

**(C-511)**

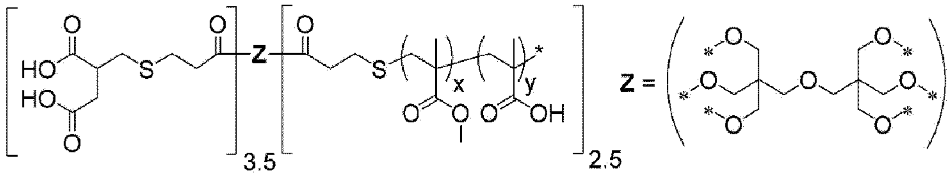

x/y=77/23 (mol%)

**(CC-001)**

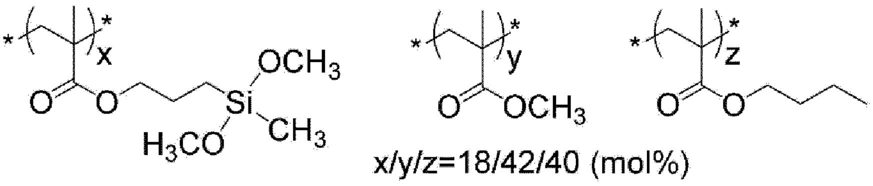

x/y/z=18/42/40 (mol%)

The concentration of solid contents, the weight-average molecular weight, the acid value, and the base number of each resin are as follows.

[Table 4]

| Resin name | Concentration of solid content [mass %] | Weight-average molecular weight | Acid value [mgKOH/g] | Base number [mgKOH/g] |
|---|---|---|---|---|
| C-001 | 30 | 20,000 | 101 | 109 |
| C-011 | 30 | 22,000 | 61 | 70 |

(continued)

| Resin name | Concentration of solid content [mass %] | Weight-average molecular weight | Acid value [mgKOH/g] | Base number [mgKOH/g] |
|---|---|---|---|---|
| C-021 | 30 | 19,000 | 98 | 108 |
| C-031 | 20 | 23,000 | 46 | 33 |
| C-101 | 30 | 13,000 | 99 | 112 |
| C-111 | 30 | 13,000 | 91 | 110 |
| C-201 | 30 | 18,000 | - | 107 |
| C-301 | 30 | 10,000 | - | 99 |
| C-401 | 30 | 25,000 | 52 | - |
| C-411 | 20 | 33,000 | 61 | - |
| C-421 | 35 | 32,000 | 70 | - |
| C-431 | 30 | 28,000 | 49 | - |
| C-441 | 30 | 30,000 | 70 | - |
| C-451 | 35 | 28,000 | 74 | - |
| C-501 | 40 | 6,500 | 83 | - |
| C-511 | 40 | 11,000 | 158 | - |
| CC-001 | 30 | 7,000 | - | - |

(Additive)

Ad-1: Epomin SP-003 (manufactured by NIPPON SHOKUBAI Co., Ltd., polyethyleneimine)

Ad-2: EPOMIN SP-006 (manufactured by NIPPON SHOKUBAI Co., Ltd., polyethyleneimine)

(Solvent)

S-1: propylene glycol monomethyl ether acetate

S-2: propylene glycol monomethyl ether

S-3: cyclopentanone

<Preparation of photosensitive composition>

Raw materials shown in the following table were mixed to produce a photosensitive composition.

[Table 5]

| | Dispersion liquid | | Resin (binder resin) | | Photopolymerization initiator | | Polymerizable monomer | |
|---|---|---|---|---|---|---|---|---|
| | Type | Parts by mass | Type | Parts by mass | Type | Parts by mass | Type | Parts by mass |
| Example 1 | DL-1 | 65.1 | C-601 | 16.6 | I-3 | 1.8 | M-2 | 6.3 |

(continued)

| | Dispersion liquid | | Resin (binder resin) | | Photopolymerization initiator | | Polymerizable monomer | |
|---|---|---|---|---|---|---|---|---|
| | Type | Parts by mass | Type | Parts by mass | Type | Parts by mass | Type | Parts by mass |
| Example 2 | DL-2 | 65.1 | C-601 | 16.6 | I-3 | 1.8 | M-2 | 6.3 |
| Example 3 | DL-3 | 65.1 | C-601 | 16.6 | I-3 | 1.8 | M-2 | 6.3 |
| Example 4 | DL-4 | 65.1 | C-601 | 16.6 | I-3 | 1.8 | M-2 | 6.3 |
| Example 5 | DL-5 | 65.1 | C-601 | 16.6 | I-3 | 1.8 | M-2 | 6.3 |
| Example 6 | DL-6 | 65.1 | C-601 | 16.6 | I-3 | 1.8 | M-2 | 6.3 |
| Example 7 | DL-7 | 65.1 | C-601 | 16.6 | I-3 | 1.8 | M-2 | 6.3 |
| Example 8 | DL-8 | 65.1 | C-601 | 16.6 | I-3 | 1.8 | M-2 | 6.3 |
| Example 9 | DL-9 | 65.1 | C-601 | 16.6 | I-3 | 1.8 | M-2 | 6.3 |
| Example 10 | DL-10 | 65.1 | C-601 | 16.6 | I-3 | 1.8 | M-2 | 6.3 |
| Example 11 | DL-11 | 65.1 | C-421 | 16.6 | I-3 | 1.8 | M-2 | 6.3 |
| Example 12 | DL-12 | 65.1 | C-421 | 16.6 | I-3 | 1.8 | M-2 | 6.3 |
| Example 13 | DL-13 | 65.1 | C-421 | 16.6 | I-3 | 1.8 | M-2 | 6.3 |
| Example 14 | DL-14 | 65.1 | C-421 | 16.6 | I-3 | 1.8 | M-2 | 6.3 |
| Example 15 | DL-15 | 65.1 | C-601 | 16.6 | I-3 | 1.8 | M-2 | 6.3 |
| Example 16 | DL-16 | 65.1 | C-601 | 16.6 | I-3 | 1.8 | M-2 | 6.3 |
| Example 17 | DL-17 | 65.1 | C-601 | 16.6 | I-3 | 1.8 | M-2 | 6.3 |
| Example 18 | DL-18 | 65.1 | C-601 | 16.6 | I-3 | 1.8 | M-2 | 6.3 |
| Example 19 | DL-19 | 65.1 | C-601 | 16.6 | I-3 | 1.8 | M-2 | 6.3 |
| Example 20 | DL-2 | 65.1 | C-601 | 16.6 | I-1 | 1.8 | M-2 | 6.3 |
| Example 21 | DL-2 | 65.1 | C-601 | 16.6 | I-2 | 1.8 | M-2 | 6.3 |
| Example 22 | DL-2 | 65.1 | C-601 | 16.6 | I-3/I-4 (mass ratio of 95/5) | 1.8 | M-2 | 6.3 |

(continued)

| | Dispersion liquid | | Resin (binder resin) | | Photopolymerization initiator | | Polymerizable monomer | |
|---|---|---|---|---|---|---|---|---|
| | Type | Parts by mass | Type | Parts by mass | Type | Parts by mass | Type | Parts by mass |
| Example 23 | DL-2 | 65.1 | C-601 | 16.6 | I-5/I-6/I-7 (mass ratio of 1/1/1) | 1.8 | M-2 | 6.3 |

[Table 6]

| | Additive 1 | | Additive 2 | | Surfactant | | Polymerization inhibitor | | Solvent | |
|---|---|---|---|---|---|---|---|---|---|---|
| | Type | Parts by mass | Type | Parts by mass | Type | Parts by mass | Type | Parts by mass | Type | Parts by mass |
| Example 1 | Ad-3 | 0.1 | Ad-5 | 1.6 | Su-3 | 0.8 | In-1 | 0.003 | S-1 | 7.7 |
| Example 2 | Ad-3 | 0.1 | Ad-5 | 1.6 | Su-3 | 0.8 | In-1 | 0.003 | S-1 | 7.7 |
| Example 3 | Ad-3 | 0.1 | Ad-5 | 1.6 | Su-3 | 0.8 | In-1 | 0.003 | S-1 | 7.7 |
| Example 4 | Ad-3 | 0.1 | Ad-5 | 1.6 | Su-3 | 0.8 | In-1 | 0.003 | S-1 | 7.7 |
| Example 5 | Ad-3 | 0.1 | Ad-5 | 1.6 | Su-3 | 0.8 | In-1 | 0.003 | S-1 | 7.7 |
| Example 6 | Ad-3 | 0.1 | Ad-5 | 1.6 | Su-3 | 0.8 | In-1 | 0.003 | S-1 | 7.7 |
| Example 7 | Ad-3 | 0.1 | Ad-5 | 1.6 | Su-3 | 0.8 | In-1 | 0.003 | S-1 | 7.7 |
| Example 8 | Ad-3 | 0.1 | Ad-5 | 1.6 | Su-3 | 0.8 | In-1 | 0.003 | S-1 | 7.7 |
| Example 9 | Ad-3 | 0.1 | Ad-5 | 1.6 | Su-3 | 0.8 | In-1 | 0.003 | S-1 | 7.7 |
| Example 10 | Ad-3 | 0.1 | Ad-5 | 1.6 | Su-3 | 0.8 | In-1 | 0.003 | S-1 | 7.7 |
| Example 11 | Ad-3 | 0.1 | Ad-5 | 1.6 | Su-3 | 0.8 | In-1 | 0.003 | S-1 | 7.7 |
| Example 12 | Ad-3 | 0.1 | Ad-5 | 1.6 | Su-3 | 0.8 | In-1 | 0.003 | S-1 | 7.7 |
| Example 13 | Ad-3 | 0.1 | Ad-5 | 1.6 | Su-3 | 0.8 | In-1 | 0.003 | S-1 | 7.7 |
| Example 14 | Ad-3 | 0.1 | Ad-5 | 1.6 | Su-3 | 0.8 | In-1 | 0.003 | S-1 | 7.7 |
| Example 15 | Ad-3 | 0.1 | Ad-5 | 1.6 | Su-3 | 0.8 | In-1 | 0.003 | S-1 | 7.7 |
| Example 16 | Ad-3 | 0.1 | Ad-5 | 1.6 | Su-3 | 0.8 | In-1 | 0.003 | S-1 | 7.7 |
| Example 17 | Ad-3 | 0.1 | Ad-5 | 1.6 | Su-3 | 0.8 | In-1 | 0.003 | S-1 | 7.7 |
| Example 18 | Ad-3 | 0.1 | Ad-5 | 1.6 | Su-3 | 0.8 | In-1 | 0.003 | S-1 | 7.7 |
| Example 19 | Ad-3 | 0.1 | Ad-5 | 1.6 | Su-3 | 0.8 | In-1 | 0.003 | S-1 | 7.7 |
| Example 20 | Ad-3 | 0.1 | Ad-5 | 1.6 | Su-3 | 0.8 | In-1 | 0.003 | S-1 | 7.7 |
| Example 21 | Ad-3 | 0.1 | Ad-5 | 1.6 | Su-3 | 0.8 | In-1 | 0.003 | S-1 | 7.7 |
| Example 22 | Ad-3 | 0.1 | Ad-5 | 1.6 | Su-3 | 0.8 | In-1 | 0.003 | S-1 | 7.7 |
| Example 23 | Ad-3 | 0.1 | Ad-5 | 1.6 | Su-3 | 0.8 | In-1 | 0.003 | S-1 | 7.7 |

[Table 7]

| | Dispersion liquid | | Resin (binder resin) | | Photopolymerization initiator | | Polymerizable monomer | |
|---|---|---|---|---|---|---|---|---|
| | Type | Parts by mass | Type | Parts by mass | Type | Parts by mass | Type | Parts by mass |
| Example 24 | DL-2 | 65.1 | C-601 | 15.0 | I-3 | 3.4 | M-2 | 6.3 |
| Example 25 | DL-2 | 65.1 | C-601 | 15.3 | I-3 | 3.1 | M-2 | 6.3 |
| Example 26 | DL-2 | 65.1 | C-601 | 17.2 | I-3 | 1.2 | M-2 | 6.3 |
| Example 27 | DL-2 | 65.1 | C-601 | 17.5 | I-3 | 0.9 | M-2 | 6.3 |
| Example 28 | DL-2 | 65.1 | C-601 | 16.6 | I-1 | 1.8 | M-1 | 6.3 |
| Example 29 | DL-2 | 65.1 | C-601 | 16.6 | I-1 | 1.8 | M-3 | 6.3 |
| Example 30 | DL-2 | 65.1 | C-601 | 16.6 | I-1 | 1.8 | M-4 | 6.3 |
| Example 31 | DL-2 | 65.1 | C-601 | 16.6 | I-1 | 1.8 | M-1/M-2 (mass ratio of 25/75) | 6.3 |
| Example 32 | DL-2 | 65.1 | C-601 | 12.0 | I-3 | 1.8 | M-2 | 10.9 |
| Example 33 | DL-2 | 65.1 | C-601 | 13.5 | I-3 | 1.8 | M-2 | 9.4 |
| Example 34 | DL-2 | 65.1 | C-601 | 20.0 | I-3 | 1.8 | M-2 | 2.9 |
| Example 35 | DL-2 | 65.1 | C-601 | 21.5 | I-3 | 1.8 | M-2 | 1.4 |
| Example 36 | DL-2 | 65.1 | C-601 | 16.6 | I-1 | 1.8 | M-2 | 6.3 |
| Example 37 | DL-2 | 65.1 | C-601 | 16.6 | I-1 | 1.8 | M-2 | 6.3 |
| Example 38 | DL-2 | 65.1 | C-601 | 16.6 | I-1 | 1.8 | M-2 | 6.3 |
| Example 39 | DL-2 | 65.1 | C-601 | 16.6 | I-3 | 1.8 | M-2 | 6.3 |
| Example 40 | DL-2 | 65.1 | C-601 | 16.6 | I-1 | 1.8 | M-2 | 6.3 |
| Example 41 | DL-2 | 65.1 | C-601 | 16.6 | I-3 | 1.8 | M-2 | 6.3 |
| Example 42 | DL-2 | 65.1 | C-601 | 16.6 | I-3 | 1.8 | M-2 | 6.3 |
| Example 43 | DL-2 | 65.1 | C-601 | 16.6 | I-3 | 1.8 | M-2 | 6.3 |
| Example 44 | DL-2 | 64.0 | C-601 | 18.0 | I-3 | 1.8 | M-2 | 8 |

(continued)

| | Dispersion liquid | | Resin (binder resin) | | Photopolymerization initiator | | Polymerizable monomer | |
|---|---|---|---|---|---|---|---|---|
| | Type | Parts by mass | Type | Parts by mass | Type | Parts by mass | Type | Parts by mass |
| Example 45 | DL-2 | 62.0 | C-601 | 19.0 | I-3 | 1.8 | M-2 | 9 |
| Example 46 | DL-2 | 60.0 | C-601 | 20.0 | I-3 | 1.8 | M-2 | 10 |

[Table 8]

| | Additive 1 | | Additive 2 | | Surfactant | | Polymerization inhibitor | | Solvent | |
|---|---|---|---|---|---|---|---|---|---|---|
| | Type | Parts by mass | Type | Parts by mass | Type | Parts by mass | Type | Parts by mass | Type | Parts by mass |
| Example 24 | Ad-3 | 0.1 | Ad-5 | 1.6 | Su-3 | 0.8 | In-1 | 0.003 | S-1 | 7.7 |
| Example 25 | Ad-3 | 0.1 | Ad-5 | 1.6 | Su-3 | 0.8 | In-1 | 0.003 | S-1 | 7.7 |
| Example 26 | Ad-3 | 0.1 | Ad-5 | 1.6 | Su-3 | 0.8 | In-1 | 0.003 | S-1 | 7.7 |
| Example 27 | Ad-3 | 0.1 | Ad-5 | 1.6 | Su-3 | 0.8 | In-1 | 0.003 | S-1 | 7.7 |
| Example 28 | Ad-3 | 0.1 | Ad-5 | 1.6 | Su-3 | 0.8 | In-1 | 0.003 | S-1 | 7.7 |
| Example 29 | Ad-3 | 0.1 | Ad-5 | 1.6 | Su-3 | 0.8 | In-1 | 0.003 | S-1 | 7.7 |
| Example 30 | Ad-3 | 0.1 | Ad-5 | 1.6 | Su-3 | 0.8 | In-1 | 0.003 | S-1 | 7.7 |
| Example 31 | Ad-3 | 0.1 | Ad-5 | 1.6 | Su-3 | 0.8 | In-1 | 0.003 | S-1 | 7.7 |
| Example 32 | Ad-3 | 0.1 | Ad-5 | 1.6 | Su-3 | 0.8 | In-1 | 0.003 | S-1 | 7.7 |
| Example 33 | Ad-3 | 0.1 | Ad-5 | 1.6 | Su-3 | 0.8 | In-1 | 0.003 | S-1 | 7.7 |
| Example 34 | Ad-3 | 0.1 | Ad-5 | 1.6 | Su-3 | 0.8 | In-1 | 0.003 | S-1 | 7.7 |
| Example 35 | Ad-3 | 0.1 | Ad-5 | 1.6 | Su-3 | 0.8 | In-1 | 0.003 | S-1 | 7.7 |
| Example 36 | Ad-4 | 0.1 | Ad-5 | 1.6 | Su-3 | 0.8 | In-1 | 0.003 | S-1 | 7.7 |
| Example 37 | Ad-3 | 0.1 | Ad-5 | 1.6 | Su-1 | 0.8 | In-1 | 0.003 | S-1 | 7.7 |
| Example 38 | Ad-3 | 0.1 | Ad-5 | 1.6 | Su-2 | 0.8 | In-1 | 0.003 | S-1 | 7.7 |

(continued)

| | Additive 1 | | Additive 2 | | Surfactant | | Polymerization inhibitor | | Solvent | |
|---|---|---|---|---|---|---|---|---|---|---|
| | Type | Parts by mass | Type | Parts by mass | Type | Parts by mass | Type | Parts by mass | Type | Parts by mass |
| Example 39 | Ad-3 | 0.1 | Ad-5 | 1.6 | Su-2/Su-3 (mass ratio of 50/50) | 0.8 | In-1 | 0.003 | S-1 | 7.7 |
| Example 40 | Ad-3 | 0.1 | Ad-5 | 1.6 | Su-3 | 0.8 | In-2 | 0.003 | S-1 | 7.7 |
| Example 41 | Ad-3 | 0.1 | Ad-5 | 1.6 | Su-3 | 0.8 | In-1/In-2 (mass ratio of 50/50) | 0.003 | S-1 | 7.7 |
| Example 42 | Ad-3 | 0.1 | Ad-5 | 1.6 | Su-3 | 0.8 | In-1 | 0.3 | S-1 | 7.7 |
| Example 43 | Ad-3 | 0.1 | Ad-5 | 1.6 | Su-3 | 0.8 | In-1 | 0.4 | S-1 | 7.7 |
| Example 44 | Ad-3 | 0.1 | Ad-5 | 1.6 | Su-3 | 0.8 | In-1 | 0.003 | S-1 | 7.7 |
| Example 45 | Ad-3 | 0.1 | Ad-5 | 1.6 | Su-3 | 0.8 | In-1 | 0.003 | S-1 | 7.7 |
| Example 46 | Ad-3 | 0.1 | Ad-5 | 1.6 | Su-3 | 0.8 | In-1 | 0.003 | S-1 | 7.7 |

[Table 9]

| | Dispersion liquid | | Resin (binder resin) | | Photopolymerization initiator | | Polymerizable monomer | |
|---|---|---|---|---|---|---|---|---|
| | Type | Parts by mass | Type | Parts by mass | Type | Parts by mass | Type | Parts by mass |
| Example 47 | DL-2 | 65.1 | C-601/C-602 (mass ratio of 90/10) | 16.6 | I-3 | 1.8 | M-2 | 6.3 |
| Example 48 | DL-2 | 65.1 | C-601 | 16.6 | I-3 | 1.8 | M-2 | 6.3 |
| Example 49 | DL-2 | 65.1 | C-601 | 16.6 | I-3 | 1.8 | M-2 | 6.3 |
| Example 50 | DL-2 | 65.1 | C-601 | 16.6 | I-3 | 1.8 | M-2 | 6.3 |
| Example 51 | DL-8/DL-9 (mass ratio of 50/50) | 65.1 | C-601 | 16.6 | I-3 | 1.8 | M-2 | 6.3 |
| Example 52 | DL-20 | 65.1 | C-601 | 16.6 | I-3 | 1.8 | M-2 | 6.3 |
| Example 53 | DL-21 | 65.1 | C-601 | 16.6 | I-3 | 1.8 | M-2 | 6.3 |

(continued)

| | Dispersion liquid | | Resin (binder resin) | | Photopolymerization initiator | | Polymerizable monomer | |
|---|---|---|---|---|---|---|---|---|
| | Type | Parts by mass | Type | Parts by mass | Type | Parts by mass | Type | Parts by mass |
| Example 54 | DL-22 | 65.1 | C-601 | 16.6 | I-3 | 1.8 | M-2 | 6.3 |
| Example 55 | DL-23 | 65.1 | C-601 | 16.6 | I-3 | 1.8 | M-2 | 6.3 |
| Example 56 | DL-24 | 65.1 | C-601 | 16.6 | I-3 | 1.8 | M-2 | 6.3 |
| Example 57 | DL-25 | 65.1 | C-601 | 16.6 | I-3 | 1.8 | M-2 | 6.3 |
| Example 58 | DL-26 | 65.1 | C-421 | 16.6 | I-3 | 1.8 | M-2 | 6.3 |
| Example 59 | DL-27 | 65.1 | C-421 | 16.6 | I-3 | 1.8 | M-2 | 6.3 |
| Example 60 | DL-28 | 65.1 | C-601 | 16.6 | I-3 | 1.8 | M-2 | 6.3 |
| Example 61 | DL-29 | 65.1 | C-601 | 16.6 | I-3 | 1.8 | M-2 | 6.3 |
| Example 62 | DL-30 | 65.1 | C-601 | 16.6 | I-3 | 1.8 | M-2 | 6.3 |
| Example 63 | DL-31 | 65.1 | C-601 | 16.6 | I-3 | 1.8 | M-2 | 6.3 |
| Example 64 | DL-32 | 65.1 | C-601 | 16.6 | I-3 | 1.8 | M-2 | 6.3 |
| Example 65 | DL-33 | 65.1 | C-601 | 16.6 | I-3 | 1.8 | M-2 | 6.3 |
| Example 66 | DL-34 | 65.1 | C-421 | 16.6 | I-3 | 1.8 | M-2 | 6.3 |
| Example 67 | DL-35 | 65.1 | C-421 | 16.6 | I-3 | 1.8 | M-2 | 6.3 |
| Example 68 | DL-36 | 65.1 | C-421 | 16.6 | I-3 | 1.8 | M-2 | 6.3 |
| Example 69 | DL-37 | 65.1 | C-421 | 16.6 | I-3 | 1.8 | M-2 | 6.3 |

[Table 10]

| | Additive 1 | | Additive 2 | | Surfactant | | Polymerization inhibitor | | Solvent | |
|---|---|---|---|---|---|---|---|---|---|---|
| | Type | Parts by mass | Type | Parts by mass | Type | Parts by mass | Type | Parts by mass | Type | Parts by mass |
| Example 47 | Ad-3 | 0.1 | Ad-5 | 1.6 | Su-3 | 0.8 | In-1 | 0.003 | S-1 | 7.7 |

(continued)

| | Additive 1 | | Additive 2 | | Surfactant | | Polymerization inhibitor | | Solvent | |
|---|---|---|---|---|---|---|---|---|---|---|
| | Type | Parts by mass | Type | Parts by mass | Type | Parts by mass | Type | Parts by mass | Type | Parts by mass |
| Example 48 | Ad-3 | 0.1 | Ad-5 | 1.6 | Su-3 | 0.8 | In-1 | 0.003 | S-1/S-2 (mass ratio of 50/50) | 7.7 |
| Example 49 | Ad-3 | 0.1 | Ad-5 | 1.6 | Su-3 | 0.8 | In-1 | 0.003 | S-1 | 45 |
| Example 50 | Ad-3 | 0.1 | Ad-5 | 1.6 | Su-3 | 0.8 | In-1 | 0.003 | S-1 | 80 |
| Example 51 | Ad-3 | 0.1 | Ad-5 | 1.6 | Su-3 | 0.8 | In-1 | 0.003 | S-1 | 7.7 |
| Example 52 | Ad-3 | 0.1 | Ad-5 | 1.6 | Su-3 | 0.8 | In-1 | 0.003 | S-1 | 7.7 |
| Example 53 | Ad-3 | 0.1 | Ad-5 | 1.6 | Su-3 | 0.8 | In-1 | 0.003 | S-1 | 7.7 |
| Example 54 | Ad-3 | 0.1 | Ad-5 | 1.6 | Su-3 | 0.8 | In-1 | 0.003 | S-1 | 7.7 |
| Example 55 | Ad-3 | 0.1 | Ad-5 | 1.6 | Su-3 | 0.8 | In-1 | 0.003 | S-1 | 7.7 |
| Example 56 | Ad-3 | 0.1 | Ad-5 | 1.6 | Su-3 | 0.8 | In-1 | 0.003 | S-1 | 7.7 |
| Example 57 | Ad-3 | 0.1 | Ad-5 | 1.6 | Su-3 | 0.8 | In-1 | 0.003 | S-1 | 7.7 |
| Example 58 | Ad-3 | 0.1 | Ad-5 | 1.6 | Su-3 | 0.8 | In-1 | 0.003 | S-1 | 7.7 |
| Example 59 | Ad-3 | 0.1 | Ad-5 | 1.6 | Su-3 | 0.8 | In-1 | 0.003 | S-1 | 7.7 |
| Example 60 | Ad-3 | 0.1 | Ad-5 | 1.6 | Su-3 | 0.8 | In-1 | 0.003 | S-1 | 7.7 |
| Example 61 | Ad-3 | 0.1 | Ad-5 | 1.6 | Su-3 | 0.8 | In-1 | 0.003 | S-1 | 7.7 |
| Example 62 | Ad-3 | 0.1 | Ad-5 | 1.6 | Su-3 | 0.8 | In-1 | 0.003 | S-1 | 7.7 |
| Example 63 | Ad-3 | 0.1 | Ad-5 | 1.6 | Su-3 | 0.8 | In-1 | 0.003 | S-1 | 7.7 |
| Example 64 | Ad-3 | 0.1 | Ad-5 | 1.6 | Su-3 | 0.8 | In-1 | 0.003 | S-1 | 7.7 |
| Example 65 | Ad-3 | 0.1 | Ad-5 | 1.6 | Su-3 | 0.8 | In-1 | 0.003 | S-1 | 7.7 |
| Example 66 | Ad-3 | 0.1 | Ad-5 | 1.6 | Su-3 | 0.8 | In-1 | 0.003 | S-1 | 7.7 |
| Example 67 | Ad-3 | 0.1 | Ad-5 | 1.6 | Su-3 | 0.8 | In-1 | 0.003 | S-1 | 7.7 |

(continued)

| | Additive 1 | | Additive 2 | | Surfactant | | Polymerization inhibitor | | Solvent | |
|---|---|---|---|---|---|---|---|---|---|---|
| | Type | Parts by mass | Type | Parts by mass | Type | Parts by mass | Type | Parts by mass | Type | Parts by mass |
| Example 68 | Ad-3 | 0.1 | Ad-5 | 1.6 | Su-3 | 0.8 | In-1 | 0.003 | S-1 | 7.7 |
| Example 69 | Ad-3 | 0.1 | Ad-5 | 1.6 | Su-3 | 0.8 | In-1 | 0.003 | S-1 | 7.7 |

[Table 11]

| | Dispersion liquid | | Resin (binder resin) | | Photopolymerization initiator | | Polymerizable monomer | |
|---|---|---|---|---|---|---|---|---|
| | Type | Parts by mass | Type | Parts by mass | Type | Parts by mass | Type | Parts by mass |
| Example 70 | DL-38 | 65.1 | C-421 | 16.6 | I-3 | 1.8 | M-2 | 6.3 |
| Example 71 | DL-39 | 65.1 | C-421 | 16.6 | I-3 | 1.8 | M-2 | 6.3 |
| Example 72 | DL-40 | 65.1 | C-421 | 16.6 | I-3 | 1.8 | M-2 | 6.3 |
| Example 73 | DL-41 | 65.1 | C-421 | 16.6 | I-3 | 1.8 | M-2 | 6.3 |
| Example 74 | DL-42 | 65.1 | C-421 | 16.6 | I-3 | 1.8 | M-2 | 6.3 |
| Example 75 | DL-43 | 65.1 | C-421 | 16.6 | I-3 | 1.8 | M-2 | 6.3 |
| Example 76 | DL-44 | 65.1 | C-421 | 16.6 | I-3 | 1.8 | M-2 | 6.3 |
| Example 77 | DL-45 | 65.1 | C-421 | 16.6 | I-3 | 1.8 | M-2 | 6.3 |
| Example 78 | DL-46 | 65.1 | C-421 | 16.6 | I-3 | 1.8 | M-2 | 6.3 |
| Example 79 | DL-47 | 65.1 | C-421 | 16.6 | I-3 | 1.8 | M-2 | 6.3 |
| Example 80 | DL-48 | 65.1 | C-421 | 16.6 | I-3 | 1.8 | M-2 | 6.3 |
| Example 81 | DL-49 | 65.1 | C-421 | 16.6 | I-3 | 1.8 | M-2 | 6.3 |
| Example 82 | DL-50 | 65.1 | C-421 | 16.6 | I-3 | 1.8 | M-2 | 6.3 |
| Example 83 | DL-51 | 65.1 | C-421 | 16.6 | I-3 | 1.8 | M-2 | 6.3 |
| Example 84 | DL-52 | 65.1 | C-421 | 16.6 | I-3 | 1.8 | M-2 | 6.3 |
| Example 85 | DL-36 | 65.1 | C-421 | 16.6 | I-1 | 1.8 | M-2 | 6.3 |

(continued)

| | Dispersion liquid | | Resin (binder resin) | | Photopolymerization initiator | | Polymerizable monomer | |
|---|---|---|---|---|---|---|---|---|
| | Type | Parts by mass | Type | Parts by mass | Type | Parts by mass | Type | Parts by mass |
| Example 86 | DL-36 | 65.1 | C-421 | 16.6 | I-2 | 1.8 | M-2 | 6.3 |
| Example 87 | DL-36 | 65.1 | C-421 | 16.6 | I-3/I-4 (mass ratio of 95/5) | 1.8 | M-2 | 6.3 |
| Example 88 | DL-36 | 65.1 | C-421 | 16.6 | I-5/I-6/I-7 (mass ratio of 1/1/1) | 1.8 | M-2 | 6.3 |
| Example 89 | DL-36 | 65.1 | C-421 | 15.0 | I-3 | 3.4 | M-2 | 6.3 |
| Example 90 | DL-36 | 65.1 | C-421 | 15.3 | I-3 | 3.1 | M-2 | 6.3 |
| Example 91 | DL-36 | 65.1 | C-421 | 17.2 | I-3 | 1.2 | M-2 | 6.3 |
| Example 92 | DL-36 | 65.1 | C-421 | 17.5 | I-3 | 0.9 | M-2 | 6.3 |

[Table 12]

| | Additive 1 | | Additive 2 | | Surfactant | | Polymerization inhibitor | | Solvent | |
|---|---|---|---|---|---|---|---|---|---|---|
| | Type | Parts by mass | Type | Parts by mass | Type | Parts by mass | Type | Parts by mass | Type | Parts by mass |
| Example 70 | Ad-3 | 0.1 | Ad-5 | 1.6 | Su-3 | 0.8 | In-1 | 0.003 | S-1 | 7.7 |
| Example 71 | Ad-3 | 0.1 | Ad-5 | 1.6 | Su-3 | 0.8 | In-1 | 0.003 | S-1 | 7.7 |
| Example 72 | Ad-3 | 0.1 | Ad-5 | 1.6 | Su-3 | 0.8 | In-1 | 0.003 | S-1 | 7.7 |
| Example 73 | Ad-3 | 0.1 | Ad-5 | 1.6 | Su-3 | 0.8 | In-1 | 0.003 | S-1 | 7.7 |
| Example 74 | Ad-3 | 0.1 | Ad-5 | 1.6 | Su-3 | 0.8 | In-1 | 0.003 | S-1 | 7.7 |
| Example 75 | Ad-3 | 0.1 | Ad-5 | 1.6 | Su-3 | 0.8 | In-1 | 0.003 | S-1 | 7.7 |
| Example 76 | Ad-3 | 0.1 | Ad-5 | 1.6 | Su-3 | 0.8 | In-1 | 0.003 | S-1 | 7.7 |
| Example 77 | Ad-3 | 0.1 | Ad-5 | 1.6 | Su-3 | 0.8 | In-1 | 0.003 | S-1 | 7.7 |
| Example 78 | Ad-3 | 0.1 | Ad-5 | 1.6 | Su-3 | 0.8 | In-1 | 0.003 | S-1 | 7.7 |
| Example 79 | Ad-3 | 0.1 | Ad-5 | 1.6 | Su-3 | 0.8 | In-1 | 0.003 | S-1 | 7.7 |
| Example 80 | Ad-3 | 0.1 | Ad-5 | 1.6 | Su-3 | 0.8 | In-1 | 0.003 | S-1 | 7.7 |
| Example 81 | Ad-3 | 0.1 | Ad-5 | 1.6 | Su-3 | 0.8 | In-1 | 0.003 | S-1 | 7.7 |
| Example 82 | Ad-3 | 0.1 | Ad-5 | 1.6 | Su-3 | 0.8 | In-1 | 0.003 | S-1 | 7.7 |
| Example 83 | Ad-3 | 0.1 | Ad-5 | 1.6 | Su-3 | 0.8 | In-1 | 0.003 | S-1 | 7.7 |
| Example 84 | Ad-3 | 0.1 | Ad-5 | 1.6 | Su-3 | 0.8 | In-1 | 0.003 | S-1 | 7.7 |
| Example 85 | Ad-3 | 0.1 | Ad-5 | 1.6 | Su-3 | 0.8 | In-1 | 0.003 | S-1 | 7.7 |
| Example 86 | Ad-3 | 0.1 | Ad-5 | 1.6 | Su-3 | 0.8 | In-1 | 0.003 | S-1 | 7.7 |
| Example 87 | Ad-3 | 0.1 | Ad-5 | 1.6 | Su-3 | 0.8 | In-1 | 0.003 | S-1 | 7.7 |
| Example 88 | Ad-3 | 0.1 | Ad-5 | 1.6 | Su-3 | 0.8 | In-1 | 0.003 | S-1 | 7.7 |

(continued)

| | Additive 1 | | Additive 2 | | Surfactant | | Polymerization inhibitor | | Solvent | |
|---|---|---|---|---|---|---|---|---|---|---|
| | Type | Parts by mass | Type | Parts by mass | Type | Parts by mass | Type | Parts by mass | Type | Parts by mass |
| Example 89 | Ad-3 | 0.1 | Ad-5 | 1.6 | Su-3 | 0.8 | In-1 | 0.003 | S-1 | 7.7 |
| Example 90 | Ad-3 | 0.1 | Ad-5 | 1.6 | Su-3 | 0.8 | In-1 | 0.003 | S-1 | 7.7 |
| Example 91 | Ad-3 | 0.1 | Ad-5 | 1.6 | Su-3 | 0.8 | In-1 | 0.003 | S-1 | 7.7 |
| Example 92 | Ad-3 | 0.1 | Ad-5 | 1.6 | Su-3 | 0.8 | In-1 | 0.003 | S-1 | 7.7 |

[Table 13]

| | Dispersion liquid | | Resin (binder resin) | | Photopolymerization initiator | | Polymerizable monomer | |
|---|---|---|---|---|---|---|---|---|
| | Type | Parts by mass | Type | Parts by mass | Type | Parts by mass | Type | Parts by mass |
| Example 93 | DL-36 | 65.1 | C-421 | 16.6 | I-1 | 1.8 | M-1 | 6.3 |
| Example 94 | DL-36 | 65.1 | C-421 | 16.6 | I-1 | 1.8 | M-3 | 6.3 |
| Example 95 | DL-36 | 65.1 | C-421 | 16.6 | I-1 | 1.8 | M-4 | 6.3 |
| Example 96 | DL-36 | 65.1 | C-421 | 16.6 | I-1 | 1.8 | M-1/M-2 (mass ratio of 25/75) | 6.3 |
| Example 97 | DL-36 | 65.1 | C-421 | 12.0 | I-3 | 1.8 | M-2 | 10.9 |
| Example 98 | DL-36 | 65.1 | C-421 | 13.5 | I-3 | 1.8 | M-2 | 9.4 |
| Example 99 | DL-36 | 65.1 | C-421 | 20.0 | I-3 | 1.8 | M-2 | 2.9 |
| Example 100 | DL-36 | 65.1 | C-421 | 21.5 | I-3 | 1.8 | M-2 | 1.4 |
| Example 101 | DL-36 | 65.1 | C-421 | 16.6 | I-1 | 1.8 | M-2 | 6.3 |
| Example 102 | DL-36 | 65.1 | C-421 | 16.6 | I-1 | 1.8 | M-2 | 6.3 |
| Example 103 | DL-36 | 65.1 | C-421 | 16.6 | I-1 | 1.8 | M-2 | 6.3 |
| Example 104 | DL-36 | 65.1 | C-421 | 16.6 | I-3 | 1.8 | M-2 | 6.3 |
| Example 105 | DL-36 | 65.1 | C-421 | 16.6 | I-1 | 1.8 | M-2 | 6.3 |
| Example 106 | DL-36 | 65.1 | C-421 | 16.6 | I-3 | 1.8 | M-2 | 6.3 |
| Example 107 | DL-36 | 65.1 | C-421 | 16.6 | I-3 | 1.8 | M-2 | 6.3 |

(continued)

| | Dispersion liquid | | Resin (binder resin) | | Photopolymerization initiator | | Polymerizable monomer | |
|---|---|---|---|---|---|---|---|---|
| | Type | Parts by mass | Type | Parts by mass | Type | Parts by mass | Type | Parts by mass |
| Example 108 | DL-36 | 65.1 | C-421 | 16.6 | I-3 | 1.8 | M-2 | 6.3 |
| Example 109 | DL-36 | 64.0 | C-421 | 18.0 | I-3 | 1.8 | M-2 | 8 |
| Example 110 | DL-36 | 62.0 | C-421 | 19.0 | I-3 | 1.8 | M-2 | 9 |
| Example 111 | DL-36 | 60.0 | C-421 | 20.0 | I-3 | 1.8 | M-2 | 10 |
| Example 112 | DL-36 | 65.1 | C-421/C-451 (mass ratio of 50/50) | 16.6 | I-3 | 1.8 | M-2 | 6.3 |

[Table 14]

| | Additive 1 | | Additive 2 | | Surfactant | | Polymerization inhibitor | | Solvent | |
|---|---|---|---|---|---|---|---|---|---|---|
| | Type | Parts by mass | Type | Parts by mass | Type | Parts by mass | Type | Parts by mass | Type | Parts by mass |
| Example 93 | Ad-3 | 0.1 | Ad-5 | 1.6 | Su-3 | 0.8 | In-1 | 0.003 | S-1 | 7.7 |
| Example 94 | Ad-3 | 0.1 | Ad-5 | 1.6 | Su-3 | 0.8 | In-1 | 0.003 | S-1 | 7.7 |
| Example 95 | Ad-3 | 0.1 | Ad-5 | 1.6 | Su-3 | 0.8 | In-1 | 0.003 | S-1 | 7.7 |
| Example 96 | Ad-3 | 0.1 | Ad-5 | 1.6 | Su-3 | 0.8 | In-1 | 0.003 | S-1 | 7.7 |
| Example 97 | Ad-3 | 0.1 | Ad-5 | 1.6 | Su-3 | 0.8 | In-1 | 0.003 | S-1 | 7.7 |
| Example 98 | Ad-3 | 0.1 | Ad-5 | 1.6 | Su-3 | 0.8 | In-1 | 0.003 | S-1 | 7.7 |
| Example 99 | Ad-3 | 0.1 | Ad-5 | 1.6 | Su-3 | 0.8 | In-1 | 0.003 | S-1 | 7.7 |
| Example 100 | Ad-3 | 0.1 | Ad-5 | 1.6 | Su-3 | 0.8 | In-1 | 0.003 | S-1 | 7.7 |
| Example 101 | Ad-4 | 0.1 | Ad-5 | 1.6 | Su-3 | 0.8 | In-1 | 0.003 | S-1 | 7.7 |
| Example 102 | Ad-4 | 0.1 | Ad-5 | 1.6 | Su-1 | 0.8 | In-1 | 0.003 | S-1 | 7.7 |
| Example 103 | Ad-4 | 0.1 | Ad-5 | 1.6 | Su-2 | 0.8 | In-1 | 0.003 | S-1 | 7.7 |
| Example 104 | Ad-3 | 0.1 | Ad-5 | 1.6 | Su-2/Su-3 (mass ratio of 50/50) | 0.8 | In-1 | 0.003 | S-1 | 7.7 |

(continued)

| | Additive 1 | | Additive 2 | | Surfactant | | Polymerization inhibitor | | Solvent | |
|---|---|---|---|---|---|---|---|---|---|---|
| | Type | Parts by mass | Type | Parts by mass | Type | Parts by mass | Type | Parts by mass | Type | Parts by mass |
| Example 105 | Ad-4 | 0.1 | Ad-5 | 1.6 | Su-2 | 0.8 | In-2 | 0.003 | S-1 | 7.7 |
| Example 106 | Ad-3 | 0.1 | Ad-5 | 1.6 | Su-3 | 0.8 | In-1/In-2 (mass ratio of 50/50) | 0.003 | S-1 | 7.7 |
| Example 107 | Ad-3 | 0.1 | Ad-5 | 1.6 | Su-3 | 0.8 | In-1 | 0.3 | S-1 | 7.7 |
| Example 108 | Ad-3 | 0.1 | Ad-5 | 1.6 | Su-3 | 0.8 | In-1 | 0.4 | S-1 | 7.7 |
| Example 109 | Ad-3 | 0.1 | Ad-5 | 1.6 | Su-3 | 0.8 | In-1 | 0.003 | S-1 | 7.7 |
| Example 110 | Ad-3 | 0.1 | Ad-5 | 1.6 | Su-3 | 0.8 | In-1 | 0.003 | S-1 | 7.7 |
| Example 111 | Ad-3 | 0.1 | Ad-5 | 1.6 | Su-3 | 0.8 | In-1 | 0.003 | S-1 | 7.7 |
| Example 112 | Ad-3 | 0.1 | Ad-5 | 1.6 | Su-3 | 0.8 | In-1 | 0.003 | S-1 | 7.7 |

[Table 15]

| | Dispersion liquid | | Resin (binder resin) | | Photopolymerization initiator | | Polymerizable monomer | |
|---|---|---|---|---|---|---|---|---|
| | Type | Parts by mass | Type | Parts by mass | Type | Parts by mass | Type | Parts by mass |
| Example 113 | DL-36 | 65.1 | C-421 | 16.6 | I-3 | 1.8 | M-2 | 6.3 |
| Example 114 | DL-36 | 65.1 | C-421 | 16.6 | I-3 | 1.8 | M-2 | 6.3 |
| Example 115 | DL-36 | 65.1 | C-421 | 16.6 | I-3 | 1.8 | M-2 | 6.3 |
| Example 116 | DL-36/DL-34 (mass ratio of 85/15) | 65.1 | C-421 | 16.6 | I-3 | 1.8 | M-2 | 6.3 |
| Comparative Example 1 | DL-S1 | 62.0 | CC-001 | 19.0 | I-1 | 1.8 | M-2 | 9 |

[Table 16]

| | Additive 1 | | Additive 2 | | Surfactant | | Polymerization inhibitor | | Solvent | |
|---|---|---|---|---|---|---|---|---|---|---|
| | Type | Parts by mass | Type | Parts by mass | Type | Parts by mass | Type | Parts by mass | Type | Parts by mass |
| Example 113 | Ad-3 | 0.1 | Ad-5 | 1.6 | Su-3 | 0.8 | In-1 | 0.003 | S-1/S-2 (mass ratio of 50/50) | 7.7 |
| Example 114 | Ad-3 | 0.1 | Ad-5 | 1.6 | Su-3 | 0.8 | In-1 | 0.003 | S-1 | 45 |
| Example 115 | Ad-3 | 0.1 | Ad-5 | 1.6 | Su-3 | 0.8 | In-1 | 0.003 | S-1 | 80 |
| Example 116 | Ad-3 | 0.1 | Ad-5 | 1.6 | Su-3 | 0.8 | In-1 | 0.003 | S-1 | 7.7 |
| Comparative Example 1 | Ad-4 | 0.1 | Ad-5 | 1.6 | Su-2 | 0.8 | In-2 | 0.003 | S-1 | 7.7 |

The raw materials shown above in the table are as follows.

(Dispersion liquid)

DL-1 to DL-52: dispersion liquids DL-1 to DL-52 described above

(Resin (binder resin))

C-421, C-451, CC-001: the above-described resins C-421, C-451, and CC-001

C-601: 35% by mass propylene glycol monomethyl ether acetate solution of a resin having the following structure (weight-average molecular weight: 11,000, acid value: 66 mgKOH/g)

C-602: 35% by mass propylene glycol monomethyl ether acetate solution of a resin having the following structure (weight-average molecular weight: 11,000, acid value: 65 mgKOH/g)

(C-601)

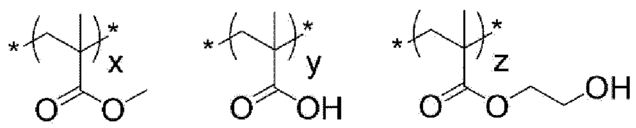

x/y/z=54/13/33 (mol%)

(C-602)

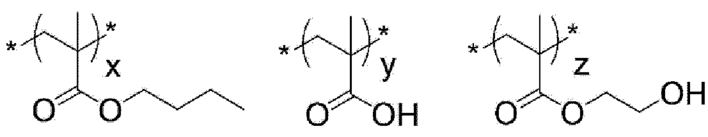

x/y/z=45/15/40 (mol%)

(Photopolymerization initiator)

I-1: Omnirad 369 (manufactured by IGM Resins B.V.)

I-2: Omnirad 819 (manufactured by IGM Resins B.V.)

I-3: Omnirad TPO H (manufactured by IGM Resins B.V.)

1-4: Irgacure OXE03 (manufactured by BASF)

I-5 to I-7: Compounds having the following structures

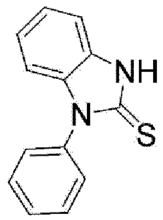

(I-5)

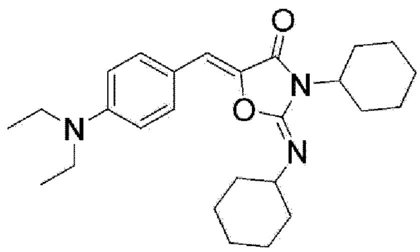

(I-6)

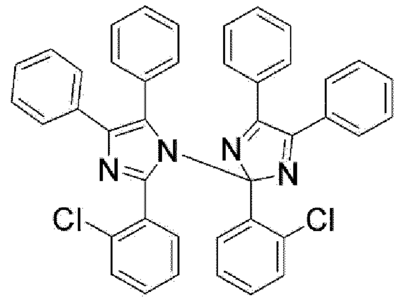

(I-7)

(Polymerizable monomer)

M-1: KAYARAD DPHA (manufactured by Nippon Kayaku Co., Ltd., dipentaerythritol hexa(meth)acrylate)
M-2: KAYARAD RP-1040 (manufactured by Nippon Kayaku Co., Ltd.)
M-3: NK ESTER A-TMMT (manufactured by Shin-Nakamura Chemical Co., Ltd.)
M-4: Light Acrylate DCP-A (manufactured by KYOEISHA CHEMICAL Co., Ltd., dimethylol-tricyclodecane diacrylate)

(Additive)

Ad-3: ADEKA STAB AO-80 (manufactured by ADEKA Corporation, anti-coloring agent)
Ad-4: Irganox 1010 (manufactured by BASF, anti-coloring agent)
Ad-5: compound having the following structure (silane coupling agent)

**(Ad-5)**

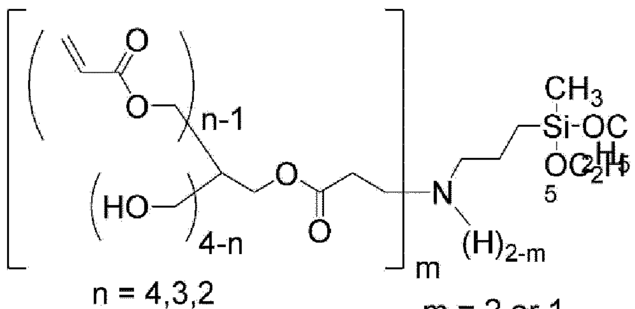

n = 4,3,2
(n=4 main reactant)

m = 2 or 1
(m=2 main product)

(Surfactant)

Su-1: 1% by mass propylene glycol monomethyl ether acetate solution of a compound having the following structure

**(Su-1)** 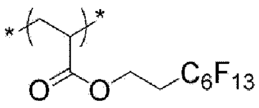 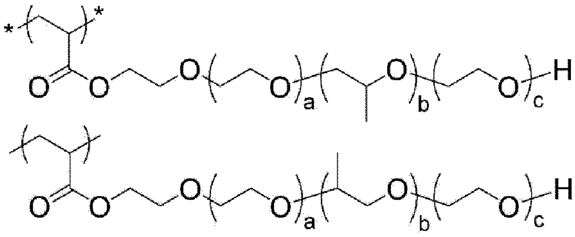

a+c =14 b=17

62% 38%

Su-2: a solution obtained by diluting KF-6001 (manufactured by Shin-Etsu Chemical Co., Ltd., a silicone-based surfactant) with propylene glycol monomethyl ether acetate so that the concentration of solid contents is adjusted to 1% by mass

Su-3: A solution obtained by diluting SH8400 (manufactured by Dow·Toray Industries, Inc., a silicone-based surfactant) with propylene glycol monomethyl ether acetate so that the concentration of solid contents is adjusted to 1% by mass

(Polymerization inhibitor)

In-1: p-methoxyphenol
In-2: 1,4-benzoquinone

(Solvent)

S-1: propylene glycol monomethyl ether acetate
S-2: propylene glycol monomethyl ether

<Evaluation of storage stability>

Each photosensitive composition was placed in a container having a liquid height of 20 cm and allowed to stand in a refrigerator (4 ± 1°C) for 6 months. After standing, a 1 cm solution from the top and a 1 cm solution from the bottom were sampled, and each sample was applied to an 8-inch (= 203.2 mm) glass wafer with an undercoat layer (manufactured by Fujifilm Electronic Materials Co., Ltd., CT-4000L, thickness: 0.1 μm) using a spin coater such that the thickness after post-baking was 4 μm. The coating film was heat-treated (pre-baked) using a hot plate at 100°C for 2 minutes. Next, using an i-ray stepper exposure device FPA-3000 i5+ (manufactured by Canon Corporation), the coating film was exposed to light having a wavelength of 365 nm at an exposure amount of 1000 mJ/cm$^2$ by being irradiated with the light. Thereafter, a heating treatment (post-baking) was performed for 5 minutes using a hot plate at 200°C to form a film. The transmittance of the obtained film in a wavelength range of 400 to 1000 nm was measured using a spectrophotometer (U-4100, manufactured by Hitachi High-Tech Corporation).

The maximum value (T1) of the transmittance of the film formed of the 1 cm solution from the top at a wavelength of 400 to 1000 nm, the maximum value (T2) of the transmittance of the film formed of the 1 cm solution from the bottom at a wavelength of 400 to 1000 nm, and ΔT which is the difference (T1 - T2) were determined, and storage stability was evaluated according to the evaluation standard. As ΔT is smaller, the storage stability is better.

-Evaluation standard-

5: ΔT was 3% or less.
4: ΔT was more than 3% and 5% or less.
3: ΔT was more than 5% and 10% or less.
2: ΔT was more than 10% and 15% or less.
1: ΔT was more than 15%.

<Evaluation of developability>

Each of the photosensitive compositions was applied to an 8-inch (= 203.2 mm) glass wafer with an undercoat layer (manufactured by Fujifilm Electronic Materials Co., Ltd., CT-4000L, thickness: 0.1 μm) such that the thickness after post-baking was 4 μm. Next, a heating treatment (pre-baking) was performed for 2 minutes using a hot plate at 100°C. Next, using an i-ray stepper exposure device FPA-3000 i5+ (manufactured by Canon Inc.), the photosensitive composition was exposed to light having a wavelength of 365 nm through a mask having a pattern at an exposure amount of 1,000 mJ/cm$^2$, by being irradiated with the light. As the mask, a mask having an island pattern of 100 μm × 100 μm was used.

Next, the glass wafer on which the irradiated coating film was formed was placed on a horizontal rotary table of a spin-shower developing machine (DW-30 Type, manufactured by Chemitronics Co., Ltd.), and subjected to a puddle development at room temperature for 60 seconds using an alkali developer (CD-2060, manufactured by Fujifilm Electronic Materials Co., Ltd.). Next, the glass wafer after the puddle development was fixed on the horizontal rotary table by a vacuum chuck method, a rinse treatment (23 seconds × 2 times) was performed by supplying pure water from above a rotation center in shower-like from an ejection nozzle while rotating the glass wafer at a rotation speed of 50 rpm by a rotating device, and then the glass wafer was spin-dried. Next, a heating treatment (post-baking) was performed for 5 minutes using a hot plate at 200°C to form a colored pattern (pixel).

The non-exposed portion of the obtained patterned cured film-attached glass wafer was observed with a scanning electron microscope (manufactured by Hitachi High-Technologies Corporation, trade name "SU8010"), the number of particle-like residues confirmed in the observation image was counted, and the developability was evaluated according to the following evaluation standard.

-Evaluation standard-

A: No development residue was observed in the non-exposed portion.
B: 1 to 3 particle-like development residues were observed in the non-exposed portion.
C: 4 to 50 particle-like development residues were observed in the non-exposed portion.
D: 51 to 100 particle-like development residues were observed in the non-exposed portion.
E: 101 or more particle-like development residues were observed in the non-exposed portion.

<Evaluation of light scattering properties>

Each of the photosensitive compositions was applied to an 8-inch (= 203.2 mm) glass wafer with an undercoat layer (manufactured by Fujifilm Electronic Materials Co., Ltd., CT-4000L, thickness: 0.1 μm) using a spin coater such that the thickness after post-baking was 4 μm. The coating film was heat-treated (pre-baked) using a hot plate at 100°C for 2 minutes. Next, using an i-ray stepper exposure device FPA-3000 i5+ (manufactured by Canon Corporation), the coating film was exposed to light having a wavelength of 365 nm at an exposure amount of 1000 mJ/cm$^2$ by being irradiated with the light. Thereafter, a heating treatment (post-baking) was performed for 5 minutes using a hot plate at 200°C to form a film.

A transmittance of the obtained film to light in a wavelength range of 400 to 1000 nm was measured using a spectrophotometer (U-4100, manufactured by Hitachi High-Tech Corporation), and the maximum value ($T_{max}$) of the transmittance in the range and an absolute value (transmittance difference ΔT) of a difference between a transmittance ($T_{940}$) to light having a wavelength of 940 nm and a transmittance ($T_{450}$) to light having a wavelength of 450 nm were calculated.

$$\text{Transmittance difference } \Delta T = |T_{940} - T_{450}|$$

-Evaluation standard for transmittance difference ΔT-

A: transmittance difference ΔT was less than 15%.
B: transmittance difference ΔT was 15% or more and less than 25%.
C: transmittance difference ΔT was 25% or more and less than 30%.
D: transmittance difference ΔT was 30% or more and less than 35%.
E: transmittance difference ΔT was 35% or more.

-Evaluation standard for maximum value $T_{max}$ of transmittance-

A: maximum value $T_{max}$ of the transmittance was 85% or less.
B: maximum value $T_{max}$ of the transmittance was more than 85% and 90% or less.
C: maximum value $T_{max}$ of the transmittance was more than 90%.

[Table 17]

| | Developability | Storage stability | Light scattering property | |
|---|---|---|---|---|
| | | | Transmittance difference ΔT | Maximum value $T_{max}$ of transmittance |
| Example 1 | A | A | A | A |
| Example 2 | A | A | A | A |
| Example 3 | A | A | A | A |
| Example 4 | A | A | A | A |
| Example 5 | A | A | A | A |
| Example 6 | A | B | A | A |
| Example 7 | A | A | B | B |
| Example 8 | A | A | A | A |
| Example 9 | A | A | A | A |
| Example 10 | A | A | A | A |
| Example 11 | A | A | A | A |
| Example 12 | A | A | A | A |
| Example 13 | C | A | B | A |
| Example 14 | C | A | B | A |
| Example 15 | A | A | A | A |
| Example 16 | A | A | A | A |
| Example 17 | A | A | A | A |
| Example 18 | A | A | A | A |
| Example 19 | A | A | A | A |
| Example 20 | A | A | A | A |
| Example 21 | A | A | A | A |
| Example 22 | A | A | A | A |
| Example 23 | A | A | A | A |
| Example 24 | A | A | A | A |
| Example 25 | A | A | A | A |
| Example 26 | A | A | A | A |
| Example 27 | A | A | A | A |
| Example 28 | A | A | A | A |
| Example 29 | A | A | A | A |
| Example 30 | A | A | A | A |
| Example 31 | A | A | A | A |
| Example 32 | A | A | B | B |

(continued)

| | Developability | Storage stability | Light scattering property | |
|---|---|---|---|---|
| | | | Transmittance difference ΔT | Maximum value $T_{max}$ of transmittance |
| Example 33 | A | A | A | A |
| Example 34 | A | A | A | A |
| Example 35 | A | A | B | B |
| Example 36 | A | A | A | A |
| Example 37 | A | A | A | A |
| Example 38 | A | A | A | A |
| Example 39 | A | A | A | A |
| Example 40 | A | A | A | A |

[Table 18]

| | Developability | Storage stability | Light scattering property | |
|---|---|---|---|---|
| | | | Transmittance difference ΔT | Maximum value $T_{max}$ of transmittance |
| Example 41 | A | A | A | A |
| Example 42 | A | A | A | A |
| Example 43 | A | A | A | A |
| Example 44 | A | A | A | A |
| Example 45 | A | A | A | A |
| Example 46 | A | A | B | B |
| Example 47 | A | A | A | A |
| Example 48 | A | A | A | A |
| Example 49 | A | A | A | A |
| Example 50 | A | A | B | B |
| Example 51 | A | A | A | A |
| Example 52 | A | C | B | B |
| Example 53 | A | C | B | B |
| Example 54 | A | C | B | B |
| Example 55 | A | C | B | B |
| Example 56 | A | C | B | B |
| Example 57 | A | C | B | B |
| Example 58 | A | C | B | B |
| Example 59 | A | C | B | B |
| Example 60 | A | A | A | A |
| Example 61 | A | A | A | A |
| Example 62 | A | A | A | A |
| Example 63 | A | A | A | A |
| Example 64 | A | A | A | A |
| Example 65 | A | A | A | A |
| Example 66 | A | A | A | A |

(continued)

| | Developability | Storage stability | Light scattering property | |
|---|---|---|---|---|
| | | | Transmittance difference $\Delta T$ | Maximum value $T_{max}$ of transmittance |
| Example 67 | A | A | A | A |
| Example 68 | A | A | A | A |
| Example 69 | A | A | A | A |
| Example 70 | A | A | A | A |
| Example 71 | A | A | A | A |
| Example 72 | A | B | A | A |
| Example 73 | A | A | B | B |
| Example 74 | A | C | B | B |
| Example 75 | A | B | A | A |
| Example 76 | A | B | A | A |
| Example 77 | A | C | B | B |
| Example 78 | A | B | A | A |
| Example 79 | A | A | A | A |
| Example 80 | A | A | A | A |

[Table 19]

| | Developability | Storage stability | Light scattering property | |
|---|---|---|---|---|
| | | | Transmittance difference $\Delta T$ | Maximum value $T_{max}$ of transmittance |
| Example 81 | A | A | A | A |
| Example 82 | A | A | A | A |
| Example 83 | A | A | A | A |
| Example 84 | A | A | A | A |
| Example 85 | A | A | A | A |
| Example 86 | A | A | A | A |
| Example 87 | A | A | A | A |
| Example 88 | A | A | A | A |
| Example 89 | A | A | A | A |
| Example 90 | A | A | A | A |
| Example 91 | A | A | A | A |
| Example 92 | A | A | A | A |
| Example 93 | A | A | A | A |
| Example 94 | A | A | A | A |
| Example 95 | A | A | A | A |
| Example 96 | A | A | A | A |
| Example 97 | A | A | B | B |
| Example 98 | A | A | A | A |
| Example 99 | A | A | A | A |
| Example 100 | A | A | B | B |

(continued)

| | Developability | Storage stability | Light scattering property | |
|---|---|---|---|---|
| | | | Transmittance difference $\Delta T$ | Maximum value $T_{max}$ of transmittance |
| Example 101 | A | A | A | A |
| Example 102 | A | A | A | A |
| Example 103 | A | A | A | A |
| Example 104 | A | A | A | A |
| Example 105 | A | A | A | A |
| Example 106 | A | A | A | A |
| Example 107 | A | A | A | A |
| Example 108 | A | A | A | A |
| Example 109 | A | A | A | A |
| Example 110 | A | A | A | A |
| Example 111 | A | A | B | B |
| Example 112 | A | A | A | A |
| Example 113 | A | A | A | A |
| Example 114 | A | A | A | A |
| Example 115 | A | A | B | B |
| Example 116 | A | A | A | A |
| Comparative Example 1 | D | E | C | C |

As shown in the above table, the photosensitive compositions of Examples had good storage stability and developability.

In a case where a film having a thickness of 4 μm was formed by heating the photosensitive compositions of Examples 1 to 116 and Comparative Example 1 at 200°C for 5 minutes, the transmittance of light having a wavelength of 365 nm of the obtained film was 35% or more for the photosensitive compositions of Examples 1 to 5, 7 to 22, 25 to 71, 73 to 87, and 90 to 116, which was more excellent in the transmittance of light having a wavelength of 365 nm than the film formed of the photosensitive compositions of Examples 6, 23, 24, 72, 88, 89, and Comparative Example 1.

In addition, the films obtained using the photosensitive compositions of Examples 6, 23, 24, 72, 88, and 89 were excellent in the transmittance of light having a wavelength of 365 nm as compared with the film obtained using the photosensitive composition of Comparative Example 1.

Each of the photosensitive compositions of Examples 1 to 116 was applied to an 8-inch (= 203.2 mm) glass wafer with an undercoat layer (manufactured by Fujifilm Electronic Materials Co., Ltd., CT-4000L, thickness: 0.1 μm) using a spin coater such that the thickness after post-baking was 4 μm. The coating film was heat-treated (pre-baked) using a hot plate at 120°C for 2 minutes. Next, using an i-ray stepper exposure device FPA-3000 i5+ (manufactured by Canon Corporation), the coating film was exposed to light having a wavelength of 365 nm at an exposure amount of 1000 $mJ/cm^2$. Thereafter, a heating treatment (post-baking) was performed for 5 minutes using a hot plate at 200°C to form a film having a thickness of 4 μm. Using a scanning electron microscope (SEM) (S-4800H, manufactured by Hitachi High-Tech Corporation), a cross section of the obtained film in a thickness direction was observed (magnification: 10000 times), and the uneven distribution state of the particles was confirmed to check whether a phase-separated state was formed.

In all of the obtained films, the phase-separated structure including the first phase containing particles and the second phase having a lower content of the particles than the first phase was formed in the film.

Even in a case where the following pigment dispersion liquid 1 was added to the photosensitive compositions of Examples 1 to 116 in an amount of 0.03 parts by mass, the same effects as those of each of Examples were obtained.

(Pigment dispersion liquid 1)

A mixed solution of 88.80 parts by mass of C.I.Pigment Blue 15:6, 23.20 parts by mass of C.I.Pigment Violet 23, 152.00 parts by mass of a 30% by mass PGMEA solution of a dispersant (Solsperse 36000, manufactured by Lubrizol

Corporation), and 536.00 parts by mass of PGMEA was subjected to a dispersion treatment under the above-described dispersion conditions using an Ultra Apex Mill manufactured by Kotobuki Kogyo Industries Co., Ltd. as a circulation type dispersion apparatus (bead mill), thereby producing a pigment dispersion liquid 1.

Explanation of References

1, 2: optical sensor
101: photoelectric conversion element
111 to 114: pixel
110: optical filter
121, 122: film
130: transparent support

## Claims

**1.** A photosensitive composition comprising:

particles A containing a rare earth element;
a photopolymerization initiator B; and
a resin C,
wherein the resin C includes a resin having at least one selected from an acid value or a base number.

**2.** The photosensitive composition according to claim 1,
wherein the particles A are particles of a rare earth phosphate.

**3.** The photosensitive composition according to claim 1 or 2,
wherein the particles A are particles containing a yttrium element.

**4.** The photosensitive composition according to claim 1 or 2,
wherein an average primary particle diameter of the particles A is 30 to 200 nm.

**5.** The photosensitive composition according to claim 1 or 2,
wherein the resin C includes a resin having an acid value and a base number.

**6.** The photosensitive composition according to claim 1 or 2,

wherein the resin C includes a resin having a repeating unit of a poly(meth)acrylic structure and a resin having a repeating unit of a polyester structure, and
at least one of the resin having a repeating unit of a poly(meth)acrylic structure or the resin having a repeating unit of a polyester structure has at least one selected from an acid value or a base number.

**7.** The photosensitive composition according to claim 1 or 2, further comprising:
polyalkyleneimine.

**8.** The photosensitive composition according to claim 1 or 2,

wherein the resin C includes a resin having an acid value, and
the photosensitive composition further contains polyalkyleneimine.

**9.** The photosensitive composition according to claim 1 or 2, further comprising:
a polymerizable monomer.

**10.** The photosensitive composition according to claim 1 or 2,
wherein a content of the particles A in a total solid content of the photosensitive composition is 35% by mass or more.

**11.** The photosensitive composition according to claim 1 or 2,
wherein, in a case where a film having a thickness of 4 μm is formed by heating the photosensitive composition at 200°C for 5 minutes, a phase-separated structure of a first phase containing the particles A and a second phase having a lower content of the particles A than a content of the particles A of the first phase is formed in the film.

**12.** The photosensitive composition according to claim 11,
wherein the phase-separated structure is a sea-island structure or a co-continuous phase structure.

**13.** A film formed of the photosensitive composition according to claim 1 or 2.

**14.** An optical sensor comprising:
the film according to claim 13.

FIG. 1

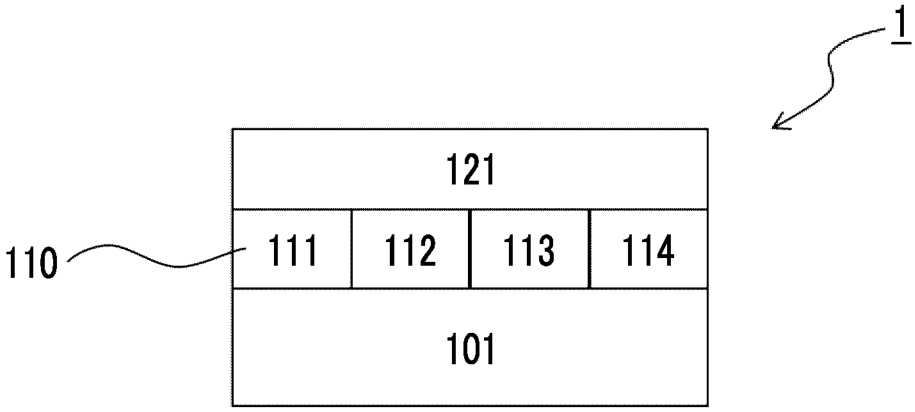


FIG. 2

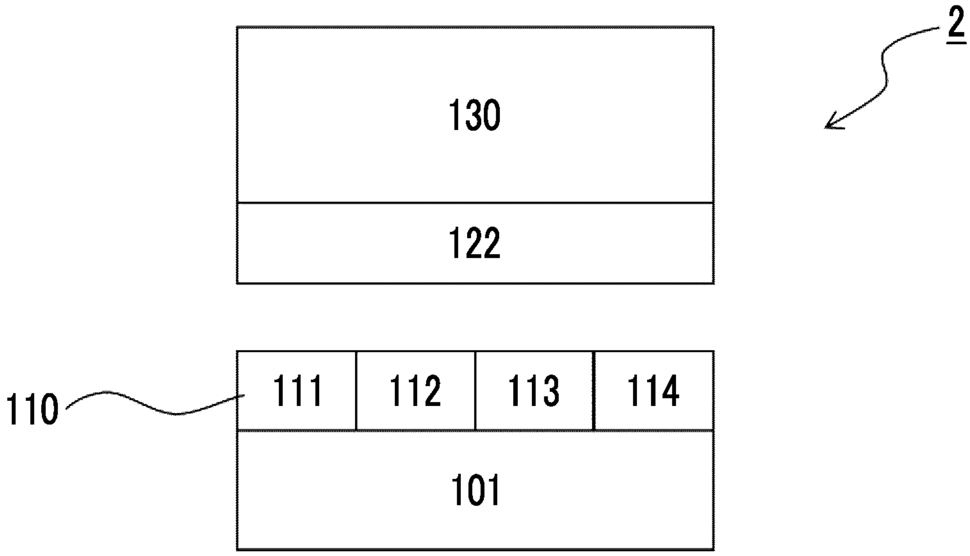

## INTERNATIONAL SEARCH REPORT

International application No.
**PCT/JP2023/029206**

**A. CLASSIFICATION OF SUBJECT MATTER**

***G03F 7/004***(2006.01)i; ***G01J 1/04***(2006.01)i; ***G02B 5/02***(2006.01)i; ***G03F 7/033***(2006.01)i
FI: G03F7/004 501; G03F7/004 504; G03F7/033; G02B5/02 B; G01J1/04 B

According to International Patent Classification (IPC) or to both national classification and IPC

**B. FIELDS SEARCHED**

Minimum documentation searched (classification system followed by classification symbols)

G03F7/004; G01J1/04; G02B5/02; G03F7/033

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | WO 2022/158313 A1 (FUJIFILM CORP.) 28 July 2022 (2022-07-28) paragraphs [0154], [0204]-[0206], [0287], example 53 | 1, 3-14<br>2 |
| X<br>A | WO 2020/204073 A1 (JSR CORP.) 08 October 2020 (2020-10-08) paragraph [0076], example 10 | 1, 4, 9-10, 13<br>2-3, 5-8, 11-12, 14 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **12 September 2023** | **26 September 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2023/029206**

| Patent document cited in search report | Publication date (day/month/year) | Patent family member(s) | Publication date (day/month/year) |
| --- | --- | --- | --- |
| WO 2022/158313 A1 | 28 July 2022 | TW 202237727 A | |
| WO 2020/204073 A1 | 08 October 2020 | TW 202104535 A | |

Form PCT/ISA/210 (patent family annex) (January 2015)

## REFERENCES CITED IN THE DESCRIPTION

*This list of references cited by the applicant is for the reader’s convenience only. It does not form part of the European patent document. Even though great care has been taken in compiling the references, errors or omissions cannot be excluded and the EPO disclaims all liability in this regard.*

### Patent documents cited in the description


- JP 2020076993 A
- JP 2014130173 A
- JP 6301489 B
- WO 2018221177 A
- WO 2018110179 A
- JP 2019043864 A
- JP 2019044030 A
- JP 2019167313 A
- JP 2020055992 A
- JP 2013190459 A
- JP 2020172619 A
- WO 2020152120 A
- JP 2021181406 A
- JP 2022013379 A
- JP 2022015747 A
- JP 2021507058 A
- WO 2022085485 A
- JP 5430746 B
- JP 5647738 B
- JP 2021173858 A
- JP 2021170089 A
- JP 2012014052 A
- JP 2010527339 A
- JP 2011524436 A
- WO 2015004565 A
- JP 2016532675 A
- WO 2017033680 A
- JP 2013522445 A
- WO 2016034963 A
- JP 2017523465 A
- JP 2017167399 A
- JP 2017151342 A
- JP 6469669 B
- JP 2012137564 A
- JP 2017194662 A
- JP 2010168539 A
- JP 2013029760 A
- JP 2014177613 A
- JP 2013043962 A
- WO 2018163668 A
- JP 2007269779 A
- WO 2015166779 A
- JP 2011252065 A
- WO 2017159910 A
- JP 2015034961 A
- JP 2009217221 A
- JP 2012208374 A
- JP 2013068814 A
- JP 2016162946 A
- WO 2021132247 A
- JP 6268967 B
- WO 2016181987 A
- WO 2020137819 A
- WO 2017159190 A
- JP 2010106268 A
- US 20110124824 A
- JP 2015157893 A
- JP 2015194521 A
- JP 2012046629 A
- JP 2019061199 A
- JP 2021032975 A
- JP 2019032434 A
- JP 2018018077 A
- JP 2016139112 A
- US 20210063745 A
- CN 112394509 B
- US 10921499 B
- KR 1020180061467 A
- JP 2018101034 A
- JP 2020101671 A
- TW 202028805 A
- JP 2009145395 A
- JP 2003262716 A
- JP 2003185831 A
- JP 2003261827 A
- JP 2012126830 A
- JP 2006169325 A
- KR 1020170122130 A


### Non-patent literature cited in the description


- *MATERIAL STAGE*, 2019, vol. 19 (3), 37-60
- The Chemical Daily. Toyo Gosei Co., 13 November 2015
- The Chemical Daily. Miyoshi Oil & Fat Co., 01 February 2016
- Dispersion Technology Comprehension. Johokiko Co., Ltd., 15 July 2005

- Actual comprehensive data collection on dispersion technology and industrial application centered on suspension (solid/liquid dispersion system). Publication Department, Management Development Center, 10 October 1978
- Extension of Use of Ink Jet - Infinite Possibilities in Patent. S.B.Research Co., Ltd., February 2005